# EUROPEAN PATENT APPLICATION

(11) **EP 4 716 442 A2**
(43) Date of publication of application: **25.03.2026**
(21) Application number: 25193434.5
(22) Date of filing: 01.08.2025
(51) Int. Cl.: H10P 72/00

(54) **SUBSTRATE PROCESSING APPARATUS**

(30) Priority: 19.09.2024 JP 2024162621
(71) Applicant: SCREEN Holdings Co., Ltd., Kyoto-shi, Kyoto 602-8585 (JP)
(72) Inventor: NISHIYAMA, Koji, Kyoto, 602-8585 (JP)
(74) Representative: Kilian Kilian & Partner mbB

(57) **Abstract**

A substrate processing apparatus includes a front block, a cabinet portion, and a rear block. The front block includes a chamber. The rear block includes a chamber. The cabinet portion includes a processing liquid container, a pipe, and a liquid feeder. The processing liquid container stores a processing liquid. The pipe connects the processing liquid container and the chamber of the front block. The liquid feeder is provided on the pipe. The front block, the cabinet portion, and the rear block are arranged in this order in a front-rear direction.

## Description

### BACKGROUND OF THE INVENTION

### 1. TECHNICAL FIELD

The present invention relates to a substrate processing apparatus for processing a substrate. The substrate is, for example, any of a semiconductor wafer, a substrate for a liquid crystal display, a substrate for organic electroluminescence (EL), a substrate for a flat panel display (FPD), a substrate for an optical display, a substrate for a magnetic disk, a substrate for an optical disk, a substrate for a magneto-optical disk, a substrate for a photomask, and a substrate for a solar cell.

### 2. DESCRIPTION OF THE RELATED ART

JP 2010-171258 A discloses a substrate processing apparatus. Hereinafter, reference numerals described in JP 2010-171258 A are written in parentheses. A substrate processing apparatus (100) includes an indexer block (10), a processing block (20), and a processing block (30). The indexer block (10), the processing block (20), and the processing block (30) are arranged in a first direction (X). The processing block (30) includes a coating processing unit (SC).

The substrate processing apparatus (100) includes a cabinet (60) and a processing liquid supply mechanism (90). The cabinet (60) is installed in the indexer block (10). The cabinet (60) includes a bottle (70). The bottle (70) stores a processing liquid. The processing liquid supply mechanism (90) supplies the processing liquid from the bottle (70) to the coating processing unit (SC). The processing liquid supply mechanism (90) extends from the indexer block (10) to the processing block (20), and further extends from the processing block (20) to the processing block (30).

### SUMMARY OF THE INVENTION

It is important to appropriately supply a processing liquid for quality of processing on a substrate.

The present invention has been made in view of such a circumstance, and an object of the present invention is to provide a substrate processing apparatus that appropriately supplies a processing liquid.

In order to achieve such an object, the present invention has the following configuration. That is, the present invention provides a substrate processing apparatus including: a first block; a cabinet portion; and a second block, in which the first block, the cabinet portion, and the second block are arranged in this order in a first direction, the first direction is horizontal, the first block includes a first chamber, the second block includes a second chamber, and the cabinet portion includes: a first processing liquid container configured to store a processing liquid; a first pipe connecting the first processing liquid container and the first chamber; and a first liquid feeder provided on the first pipe.

The substrate processing apparatus includes the first block, the cabinet portion, and the second block. The first block includes the first chamber. The second block includes the second chamber. The cabinet portion includes the first processing liquid container, the first pipe, and the first liquid feeder. The first processing liquid container stores a processing liquid. The first pipe connects the first processing liquid container and the first chamber. The first liquid feeder is provided on the first pipe.

Here, the first block, the cabinet portion, and the second block are arranged in this order in the first direction. The first direction is horizontal. Therefore, the cabinet portion is close to the first block. Thus, it is easy to shorten the first pipe. As a result, the first liquid feeder appropriately supplies the processing liquid to the first chamber.

In summary, according to the substrate processing apparatus, the processing liquid is appropriately supplied.

It is preferred in the substrate processing apparatus described above that the cabinet portion includes: a second pipe connecting the first processing liquid container and the second chamber; and a second liquid feeder provided on the second pipe. The cabinet portion includes the second pipe and the second liquid feeder. The second pipe connects the first processing liquid container and the second chamber. The second liquid feeder is provided on the second pipe. As described above, the first block, the cabinet portion, and the second block are arranged in this order in the first direction. Therefore, the cabinet portion is close to the second block. Thus, it is easy to shorten the second pipe. Therefore, the second liquid feeder appropriately supplies the processing liquid to the second chamber.

It is preferred in the substrate processing apparatus described above that the cabinet portion is adjacent to the first chamber, and the cabinet portion is adjacent to the second chamber. The cabinet portion is adjacent to the first chamber. Thus, it is easier to shorten the first pipe. As a result, the first liquid feeder more appropriately supplies the processing liquid to the first chamber.

The cabinet portion is adjacent to the second chamber. Thus, it is easier to shorten the second pipe. As a result, the second liquid feeder more appropriately supplies the processing liquid to the second chamber.

It is preferred in the substrate processing apparatus described above that the second pipe has a length equal to a length of the first pipe. Therefore, quality of processing on a substrate in the second chamber can be easily made equal to quality of processing on a substrate in the first chamber.

It is preferred in the substrate processing apparatus described above that the first pipe has a downstream portion from the first liquid feeder to the first chamber, the second pipe has a downstream portion from the second liquid feeder to the second chamber, and the downstream portion of the second pipe has a length equal to a length of the downstream portion of the first pipe. Therefore, quality of processing on a substrate in the second chamber can be easily made equal to quality of processing on a substrate in the first chamber.

It is preferred in the substrate processing apparatus described above that the second chamber is disposed at a height position same as a height position of the first chamber. Therefore, it is easy for the second pipe to have a length equal to a length of the first pipe.

It is preferred in the substrate processing apparatus described above that the second liquid feeder is disposed at a height position same as a height position of the first liquid feeder. Therefore, it is easy for the second pipe to have a length equal to a length of the first pipe.

It is preferred in the substrate processing apparatus described above that the first liquid feeder includes a first pump provided on the first pipe, the second liquid feeder includes a third pump provided on the second pipe, and the third pump is disposed at a height position same as a height position of the first pump. The first liquid feeder includes the first pump. The first pump is provided on the first pipe. Therefore, it is easy for the first liquid feeder to supply the processing liquid from the first processing liquid container to the first chamber.

The second liquid feeder includes the third pump. The third pump is provided on the second pipe. Therefore, it is easy for the second liquid feeder to supply the processing liquid from the first processing liquid container to the second chamber.

The third pump is disposed at a height position same as a height position of the first pump. Therefore, it is easy to dispose the second liquid feeder at a height position same as a height position of the first liquid feeder.

It is preferred in the substrate processing apparatus described above that the first liquid feeder includes a second pump provided on the first pipe, the second pump is disposed downstream of the first pump, the second liquid feeder includes a fourth pump provided on the second pipe, the fourth pump is disposed downstream of the third pump, and the fourth pump is disposed at a height position same as a height position of the second pump. The first liquid feeder includes the second pump. The second pump is provided on the first pipe. The second pump is disposed downstream of the first pump. Therefore, it is easy for the first liquid feeder to supply the processing liquid from the first processing liquid container to the first chamber.

The second liquid feeder includes the fourth pump. The fourth pump is provided on the second pipe. The fourth pump is disposed downstream of the third pump. Therefore, it is easy for the second liquid feeder to supply the processing liquid from the first processing liquid container to the second chamber.

The fourth pump is disposed at a height position same as a height position of the second pump. Therefore, it is easy to dispose the second liquid feeder at a height position same as a height position of the first liquid feeder.

It is preferred in the substrate processing apparatus described above that the second pump is closer to the first block than a center of the cabinet portion in the first direction, and the fourth pump is closer to the second block than a center of the cabinet portion in the first direction. The second pump is closer to the first block than a center of the cabinet portion in the first direction. Therefore, a distance between the second pump and the first chamber in the first direction is relatively short. Thus, it is easy to shorten a length of a portion of the first pipe between the second pump and the first chamber. As a result, the first liquid feeder appropriately supplies the processing liquid to the first chamber.

The fourth pump is closer to the second block than a center of the cabinet portion in the first direction. Therefore, a distance between the fourth pump and the second chamber in the first direction is relatively short. Thus, it is easy to shorten a length of a portion of the second pipe between the fourth pump and the second chamber. Therefore, the second liquid feeder appropriately supplies the processing liquid to the second chamber.

It is preferred in the substrate processing apparatus described above that the first pipe extends from the cabinet portion to the first block, the first pipe includes: a first inner portion disposed in the cabinet portion; a first outer portion disposed in the first block; and a first joint connecting the first inner portion and the first outer portion, the second pipe extends from the cabinet portion to the second block, and the second pipe includes: a second inner portion disposed in the cabinet portion; a second outer portion disposed in the second block; and a second joint connecting the second inner portion and the second outer portion. The first pipe extends from the cabinet portion to the first block. The first pipe includes the first inner portion, the first outer portion, and the first joint. The first inner portion is disposed in the cabinet portion. The first outer portion is disposed in the first block. The first joint connects the first inner portion and the first outer portion. Therefore, it is easy to separate the first pipe at a boundary between the cabinet portion and the first block.

The second pipe extends from the cabinet portion to the second block. The second pipe includes the second inner portion, the second outer portion, and the second joint. The second inner portion is disposed in the cabinet portion. The second outer portion is disposed in the second block. The second joint connects the second inner portion and the second outer portion. Therefore, it is easy to separate the second pipe at a boundary between the cabinet portion and the second block.

It is preferred in the substrate processing apparatus described above that the first pipe does not reach the second block, and the second pipe does not reach the first block. The first pipe does not reach the second block. Therefore, it is easy to shorten the first pipe. Furthermore, the number of the joints of the first pipe is small.

The second pipe does not reach the first block. Therefore, it is easy to shorten the second pipe. Furthermore, the number of the joints of the second pipe is small.

It is preferred in the substrate processing apparatus described above that the cabinet portion is adjacent to the first chamber. Thus, it is easier to shorten the first pipe. As a result, the first liquid feeder more appropriately supplies the processing liquid to the first chamber.

It is preferred in the substrate processing apparatus described above that the first liquid feeder includes a first pump provided on the first pipe. Therefore, it is easy for the first liquid feeder to supply the processing liquid from the first processing liquid container to the first chamber.

It is preferred in the substrate processing apparatus described above that the first pump is disposed at a position lower than the first processing liquid container. Therefore, gravity promotes a flow of the processing liquid from the first processing liquid container to the first pump. Thus, it is easy for the processing liquid to flow from the first processing liquid container to the first pump. For example, it is easy for the first pump to suction the processing liquid from the first processing liquid container.

It is preferred in the substrate processing apparatus described above that the first pump overlaps with the first processing liquid container in plan view. Therefore, it is easy to reduce a size of the cabinet portion in plan view. In other words, it is easy to reduce a footprint of the cabinet portion.

It is preferred in the substrate processing apparatus described above that the first liquid feeder includes a second pump provided on the first pipe, the second pump is disposed downstream of the first pump. Therefore, it is easy for the first liquid feeder to supply the processing liquid from the first processing liquid container to the first chamber.

It is preferred in the substrate processing apparatus described above that the second pump is closer to the first block than a center of the cabinet portion in the first direction. Therefore, a distance between the second pump and the first chamber in the first direction is relatively short. Thus, it is easy to shorten a length of a portion of the first pipe between the second pump and the first chamber. As a result, the first liquid feeder appropriately supplies the processing liquid to the first chamber.

It is preferred in the substrate processing apparatus described above that at least a part of the second pump is disposed at a height position same as a height position of at least a part of the first chamber. Therefore, a distance between the second pump and the first chamber in a vertical direction is relatively short. Thus, it is easier to shorten a length of a portion of the first pipe between the second pump and the first chamber. As a result, the first liquid feeder appropriately supplies the processing liquid to the first chamber.

It is preferred in the substrate processing apparatus described above that the first chamber includes a first processing unit, the first processing unit includes: a holding portion configured to hold a substrate; and a nozzle configured to dispense a processing liquid to a substrate held by the holding portion, and the first pipe connects the first processing liquid container and the nozzle. The first chamber includes the first processing unit. The first processing unit includes the holding portion and the nozzle. The holding portion holds the substrate. The nozzle dispenses the processing liquid to the substrate held by the holding portion. The first pipe connects the first processing liquid container and the nozzle. Therefore, it is easy for the first liquid feeder to supply the processing liquid from the first processing liquid container to the nozzle. Thus, it is easy for the first liquid feeder to supply the processing liquid from the first processing liquid container to the first chamber.

It is preferred in the substrate processing apparatus described above that at least a part of the second pump is disposed at a position lower than the nozzle. Therefore, the first liquid feeder appropriately supplies the processing liquid to the nozzle.

It is preferred in the substrate processing apparatus described above that the first chamber includes a second processing unit, and the second processing unit shares the nozzle of the first processing unit. The first chamber includes the second processing unit. Therefore, the first chamber efficiently processes the substrate.

The second processing unit shares the nozzle of the first processing unit. Therefore, quality of processing on a substrate in the second processing unit can be easily made equal to quality of processing on a substrate in the first processing unit.

It is preferred in the substrate processing apparatus described above that the first processing unit includes a cup disposed outward of the holding portion, the cup has an upper end, and at least a part of the second pump is disposed at a position lower than the upper end of the cup. The first processing unit includes the cup. The cup is disposed outward of the holding portion. The cup has the upper end. At least a part of the second pump is disposed at a position lower than the upper end of the cup. Therefore, the first liquid feeder appropriately supplies the processing liquid to the nozzle.

It is preferred in the substrate processing apparatus described above that the cabinet portion includes: a second processing liquid container configured to store a processing liquid; a third pipe connecting the second processing liquid container and the first chamber; and a third liquid feeder provided on the third pipe, the third liquid feeder includes: a fifth pump provided on the third pipe; and a sixth pump provided on the third pipe, the sixth pump is disposed downstream of the fifth pump, and the sixth pump is disposed at a height position same as a height position of the second pump. The cabinet portion includes the second processing liquid container, the third pipe, and the third liquid feeder. The second processing liquid container stores a processing liquid. The third pipe connects the second processing liquid container and the first chamber. The third liquid feeder is provided on the third pipe. The third liquid feeder includes the fifth pump and the sixth pump. The fifth pump is provided on the third pipe. The sixth pump is provided on the third pipe. The sixth pump is disposed downstream of the fifth pump. Therefore, it is easy for the third liquid feeder to supply the processing liquid from the second processing liquid container to the first chamber.

The second pump and the sixth pump are disposed at the same height position. Therefore, it is easy to improve quality of processing on a substrate in the first chamber. For example, quality of processing on a substrate using the processing liquid in the second processing liquid container in the first chamber can be easily made equal to quality of processing on a substrate using the processing liquid in the first processing liquid container in the first chamber.

It is preferred in the substrate processing apparatus described above that the second pump and the sixth pump are arranged in a second direction, and the second direction is horizontal and is orthogonal to the first direction. The second pump and the sixth pump are arranged in the second direction. The second direction is horizontal. Therefore, it is easy to dispose the sixth pump at a height position same as a height position of the second pump.

The second direction is orthogonal to the first direction. Therefore, the second pump and the sixth pump are not arranged in the first direction. Thus, it is easy to shorten a length of the cabinet portion in the first direction. Furthermore, it is easy for a portion of the third pipe between the sixth pump and the first chamber to have a length equal to a length of a portion of the first pipe between the second pump and the first chamber. Therefore, it is easy to improve quality of processing on a substrate in the first chamber. For example, quality of processing on a substrate using the processing liquid in the second processing liquid container in the first chamber can be easily made equal to quality of processing on a substrate using the processing liquid in the first processing liquid container in the first chamber.

It is preferred that the substrate processing apparatus described above includes an indexer portion, in which the indexer portion includes: a carrier stage; and a transport mechanism, the carrier stage and the transport mechanism are arranged in a second direction, and the second direction is horizontal and is orthogonal to the first direction. The substrate processing apparatus includes the indexer portion. The indexer portion includes the carrier stage and the transport mechanism. The carrier stage and the transport mechanism are arranged in the second direction. The second direction is horizontal. The second direction is orthogonal to the first direction. Therefore, it is easy to shorten a length of the indexer portion in the first direction. Thus, even when the substrate processing apparatus includes the cabinet portion, a length of the substrate processing apparatus in the first direction does not significantly increase.

It is preferred in the substrate processing apparatus described above that the indexer portion, the first block, the cabinet portion, and the second block are arranged in this order in the first direction. Even when the indexer portion, the first block, the cabinet portion, and the second block are arranged in this order in the first direction, the first liquid feeder appropriately supplies the processing liquid to the first chamber.

It is preferred in the substrate processing apparatus described above that the first block, the cabinet portion, the second block, and the indexer portion are arranged in this order in the first direction. Even when the first block, the cabinet portion, the second block, and the indexer portion are arranged in this order in the first direction, the first liquid feeder appropriately supplies the processing liquid to the first chamber.

It is preferred in the substrate processing apparatus described above that the first pipe does not reach the indexer portion. Therefore, it is easy to shorten the first pipe. Furthermore, the number of the joints of the first pipe is small.

It is preferred that the substrate processing apparatus described above includes a bridge portion, in which the bridge portion transports a substrate to the first block and the second block, the first block, the bridge portion, and the second block are arranged in this order in the first direction, and the cabinet portion and the bridge portion are arranged in the second direction. The substrate processing apparatus includes the bridge portion. The bridge portion transports a substrate to the first block and the second block. Therefore, it is easy for the first block to process the substrate. It is easy for the second block to process the substrate.

The first block, the bridge portion, and the second block are arranged in this order in the first direction. Therefore, it is easy for the bridge portion to transport a substrate to the first block and the second block.

The cabinet portion and the bridge portion are arranged in the second direction. Therefore, it is easy to arrange the first block, the bridge portion, and the second block in this order in the first direction.

It is preferred that the substrate processing apparatus described above includes a slider portion, in which the slider portion transports a substrate between the indexer portion and the bridge portion, the slider portion overlaps with one of the first block or the second block in plan view. The substrate processing apparatus includes the slider portion. The slider portion transports a substrate between the indexer portion and the bridge portion. Therefore, a substrate is efficiently transported between the indexer portion and the bridge portion.

The slider portion overlaps with either first block or the second block in plan view. Therefore, even when the substrate processing apparatus includes the slider portion, the substrate processing apparatus does not become significantly large in plan view. In other words, even when the substrate processing apparatus includes the slider portion, a footprint of the substrate processing apparatus does not become significantly large.

### BRIEF DESCRIPTION OF THE DRAWINGS

For the purpose of illustrating the invention, there are shown in the drawings several forms which are presently preferred, it being understood, however, that the invention is not limited to the precise arrangement and instrumentalities shown.
FIG. 1 is a schematic side view of a substrate processing apparatus according to an embodiment;
FIG. 2 is a control block diagram of the substrate processing apparatus;
FIG. 3 is a plan view of the substrate processing apparatus;
FIG. 4 is a plan view of the substrate processing apparatus;
FIG. 5 is a plan view of the substrate processing apparatus;
FIG. 6 is a first side view of the substrate processing apparatus;
FIG. 7 is a second side view of the substrate processing apparatus;
FIG. 8 is a front view of an indexer portion;
FIG. 9 is a front view of a front block;
FIG. 10 is a front view of a bridge portion;
FIG. 11 is a front view of a rear block;
FIG. 12 is a detailed front view of the indexer portion;
FIG. 13 is a detailed plan view of a slider portion;
FIG. 14 is a piping diagram between a cabinet portion and a chamber;
FIG. 15 is a detailed piping diagram between the cabinet portion and the chamber;
FIG. 16 is a detailed plan view of a part of the bridge portion;
FIG. 17 is a detailed plan view of the cabinet portion;
FIG. 18 is a detailed side view of the cabinet portion;
FIG. 19 is a side view of the substrate processing apparatus schematically illustrating an operation of the substrate processing apparatus;
FIG. 20 is a diagram schematically illustrating a transport path of a substrate;
FIG. 21 is a side view schematically illustrating an operation example of the substrate processing apparatus;
FIG. 22 is a schematic side view of a substrate processing apparatus according to a modified embodiment; and
FIG. 23 is a schematic side view of a substrate processing apparatus according to a modified embodiment.

### DETAILED DESCRIPTION

Hereinafter, a substrate processing apparatus of the present invention will be described with reference to the drawings.

### <1. Outline of substrate processing apparatus>

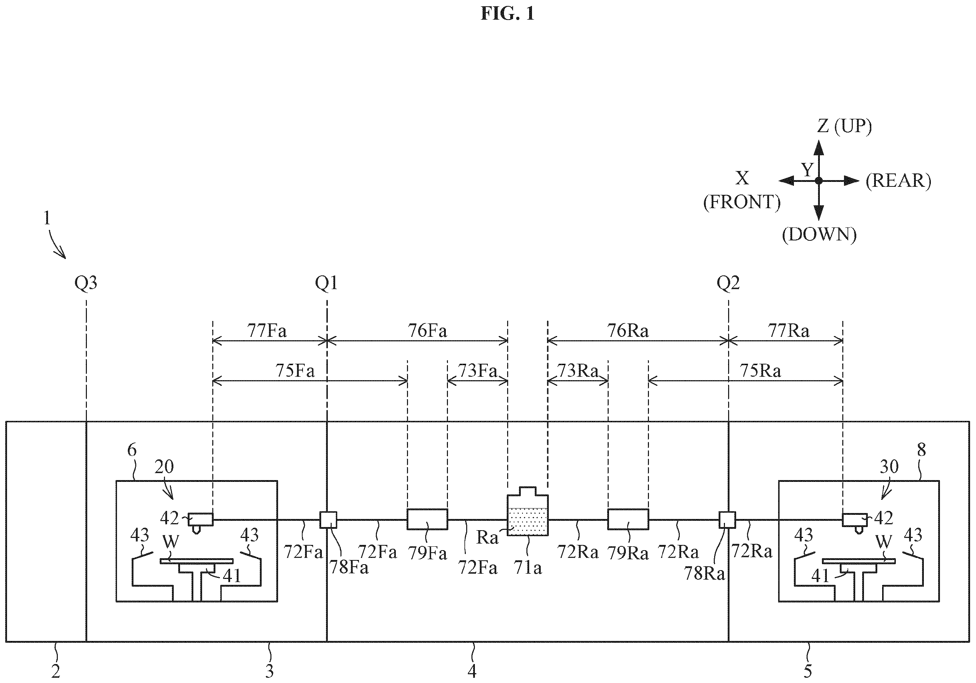

FIG. 1 is a schematic side view of a substrate processing apparatus 1 according to an embodiment. The substrate processing apparatus 1 processes a substrate W.

The substrate W is, for example, a semiconductor wafer, a substrate for a liquid crystal display, a substrate for organic electroluminescence (EL), a substrate for a flat panel display (FPD), a substrate for an optical display, a substrate for a magnetic disk, a substrate for a magneto-optical disk, a substrate for a photomask, or a substrate for a solar cell. The substrate W has a thin flat plate shape. The substrate W has a substantially circular shape in plan view.

The substrate processing apparatus 1 includes an indexer portion 2, a front block 3, a cabinet portion 4, and a rear block 5. The indexer portion 2, the front block 3, the cabinet portion 4, and the rear block 5 are arranged in this order in a front-rear direction X.

The front-rear direction X is horizontal. In the present specification, a direction from the cabinet portion 4 toward the front block 3 in the front-rear direction X is referred to as "frontward". A direction opposite to the frontward is referred to as "rearward". A width direction Y is horizontal. The width direction Y is orthogonal to the front-rear direction X. One direction in the width direction Y is referred to as a "first side". A direction opposite to the first side is referred to as a "second side". A vertical direction Z is orthogonal to the front-rear direction X. The vertical direction Z is orthogonal to the width direction Y. The vertical direction Z includes "upward" and "downward". In each figure, the frontward is indicated by "FRONT" for reference. The rearward is indicated by "REAR". The first side is indicated by "FIRST SIDE" or "1ST". The second side is indicated by "SECOND SIDE" or "2ND". The upward is indicated by "UP". The downward is indicated by "DOWN".

The front-rear direction X is an example of a first direction of the present invention. The width direction Y is an example of a second direction of the present invention.

The cabinet portion 4 is disposed rearward of the front block 3. The cabinet portion 4 is disposed frontward of the rear block 5. The cabinet portion 4 is disposed between the front block 3 and the rear block 5.

The cabinet portion 4 is connected to the front block 3. The cabinet portion 4 is in contact with the front block 3. The cabinet portion 4 is separable from the front block 3.

The cabinet portion 4 is connected to the rear block 5. The cabinet portion 4 is in contact with the rear block 5. The cabinet portion 4 is separable from the rear block 5.

The front block 3 includes a chamber 6. The rear block 5 includes a chamber 8. The chamber 8 is disposed at a height position same as a height position of the chamber 6.

The chamber 6, the cabinet portion 4, and the chamber 8 are arranged in the front-rear direction X. The cabinet portion 4 is adjacent to the chamber 6. The cabinet portion 4 is adjacent to the chamber 8.

Each of the chambers 6 and 8 processes the substrate W. For example, the chamber 6 performs liquid processing on the substrate W. For example, the chamber 8 performs liquid processing on the substrate W.

The "liquid processing" is processing performed on the substrate W by supplying a processing liquid to the substrate W. The "liquid processing" includes, for example, at least one of coating processing, development processing, etching processing, or cleaning processing. The "processing liquid" includes, for example, at least one of a coating film material, a developer, an etching solution, or a cleaning liquid.

In the "coating processing", a coating film is formed on the substrate W. The "coating film" is formed by applying a coating film material to the substrate W. The "coating film" is, for example, at least one of a lower layer film, an intermediate layer film, or an upper layer film. The "coating film" is, for example, at least one of a resist film, an antireflection film, a spin on glass (SOG) film, or a protective film.

Processing performed on the substrate W by the chamber 8 is identical to processing performed on the substrate W by the chamber 6. For example, each of the chambers 6 and 8 supplies a resist liquid to the substrate W to form a resist film on the substrate W.

The chamber 6 includes a processing unit 20. The processing unit 20 processes one substrate W at a time.

The processing unit 20 includes a holding portion 41, a nozzle 42, and a cup 43. The holding portion 41 holds the substrate W. The holding portion 41 suctions, for example, a back surface of the substrate W. The holding portion 41 holds only a center of the back surface of the substrate W with a vacuum suction force. The holding portion 41 is, for example, a vacuum chuck. The substrate W held by the holding portion 41 takes a horizontal posture. The holding portion 41 is configured to be able to rotate the substrate W. The nozzle 42 dispenses the processing liquid to the substrate W held by the holding portion 41. The cup 43 is disposed outward of the holding portion 41. The cup 43 surrounds the holding portion 41. The cup 43 has a tubular shape. The cup 43 receives liquid scattered from the substrate W.

The chamber 8 includes a processing unit 30. The processing unit 30 has the same structure as the processing unit 20. In the present specification, in a case where different elements have a common structure, the structure is denoted by a common reference sign, and a detailed description thereof is omitted. For example, the processing unit 30 includes a holding portion 41, a nozzle 42, and a cup 43.

The cabinet portion 4 includes a processing liquid container 71a. The processing liquid container 71a stores a processing liquid Ra. The processing liquid container 71a is, for example, at least one of a gallon bottle, a tank, or a bottle. After the processing liquid container 71a becomes empty, the processing liquid container 71a is not refilled with the processing liquid Ra. After the processing liquid container 71a becomes empty, the processing liquid container 71a is removed from the cabinet portion 4. The empty processing liquid container 71a is replaced with another processing liquid container 71a that stores the processing liquid Ra.

The cabinet portion 4 includes a pipe 72Fa. The pipe 72Fa connects the processing liquid container 71a and the chamber 6. The pipe 72Fa extends from the processing liquid container 71a to the chamber 6. The pipe 72Fa connects the processing liquid container 71a and the nozzle 42 of the chamber 6. The pipe 72Fa extends from the processing liquid container 71a to the nozzle 42 of the chamber 6.

The cabinet portion 4 includes a liquid feeder 79Fa. The liquid feeder 79Fa is provided on the pipe 72Fa. The liquid feeder 79Fa feeds the processing liquid Ra from the processing liquid container 71a to the chamber 6. The liquid feeder 79Fa feeds the processing liquid Ra from the processing liquid container 71a to the nozzle 42 of the chamber 6.

The cabinet portion 4 includes a pipe 72Ra. The pipe 72Ra connects the processing liquid container 71a and the chamber 8. The pipe 72Ra extends from the processing liquid container 71a to the chamber 8. The pipe 72Ra connects the processing liquid container 71a and the nozzle 42 of the chamber 8. The pipe 72Ra extends from the processing liquid container 71a to the nozzle 42 of the chamber 8.

The cabinet portion 4 includes a liquid feeder 79Ra. The liquid feeder 79Ra is provided on the pipe 72Ra. The liquid feeder 79Ra feeds the processing liquid Ra from the processing liquid container 71a to the chamber 8. The liquid feeder 79Ra feeds the processing liquid Ra from the processing liquid container 71a to the nozzle 42 of the chamber 8.

The pipe 72Ra has a length equal to a length of the pipe 72Fa.

The pipe 72Fa has an upstream portion 73Fa. The upstream portion 73Fa connects the processing liquid container 71a and the liquid feeder 79Fa. The upstream portion 73Fa extends from the processing liquid container 71a to the liquid feeder 79Fa.

The pipe 72Ra has an upstream portion 73Ra. The upstream portion 73Ra connects the processing liquid container 71a and the liquid feeder 79Ra. The upstream portion 73Ra extends from the processing liquid container 71a to the liquid feeder 79Ra.

The upstream portion 73Ra has a length equal to a length of the upstream portion 73Fa.

The pipe 72Fa has a downstream portion 75Fa. The downstream portion 75Fa connects the liquid feeder 79Fa and the chamber 6. The downstream portion 75Fa extends from the liquid feeder 79Fa to the chamber 6. For example, the downstream portion 75Fa connects the liquid feeder 79Fa and the nozzle 42 of the chamber 6. The downstream portion 75Fa extends from the liquid feeder 79Fa to the nozzle 42 of the chamber 6.

The pipe 72Ra has a downstream portion 75Ra. The downstream portion 75Ra connects the liquid feeder 79Ra and the chamber 8. The downstream portion 75Ra extends from the liquid feeder 79Ra to the chamber 8. For example, the downstream portion 75Ra connects the liquid feeder 79Ra and the nozzle 42 of the chamber 8. The downstream portion 75Ra extends from the liquid feeder 79Ra to the nozzle 42 of the chamber 8.

The downstream portion 75Ra has a length equal to a length of the downstream portion 75Fa.

The pipe 72Fa reaches the front block 3. The pipe 72Fa extends from the cabinet portion 4 to the front block 3.

The pipe 72Fa crosses a boundary Q1. The boundary Q1 is a boundary between the cabinet portion 4 and the front block 3.

The pipe 72Fa has an inner portion 76Fa and an outer portion 77Fa. The inner portion 76Fa is disposed in the cabinet portion 4. The outer portion 77Fa is disposed in the front block 3.

The pipe 72Fa includes one joint 78Fa. The joint 78Fa is disposed on the boundary Q1. The joint 78Fa connects the inner portion 76Fa and the outer portion 77Fa. The joint 78Fa attaches and detaches the inner portion 76Fa and the outer portion 77Fa. The liquid feeder 79Fa is provided on the inner portion 76Fa. The joint 78Fa is disposed downstream of the liquid feeder 79Fa.

"Downstream" means downstream in a flow direction of the processing liquid Ra. The flow direction of the processing liquid Ra is, for example, a direction from the processing liquid container 71a toward the chamber 6. The flow direction of the processing liquid Ra is, for example, a direction from the processing liquid container 71a toward the chamber 8. Similarly, "upstream" means upstream in the flow direction of the processing liquid Ra. "Upstream" is the direction opposite to "downstream".

The pipe 72Fa does not reach the rear block 5. The pipe 72Fa does not extend from the cabinet portion 4 to the rear block 5.

The pipe 72Fa does not cross a boundary Q2. The boundary Q2 is a boundary between the cabinet portion 4 and the rear block 5.

The pipe 72Fa does not reach the indexer portion 2. The pipe 72Fa does not extend from the cabinet portion 4 to the indexer portion 2.

The pipe 72Fa does not cross a boundary Q3. The boundary Q3 is a boundary between the indexer portion 2 and the front block 3.

The number of the joints 78Fa included in the pipe 72Fa is one.

The pipe 72Ra reaches the rear block 5. The pipe 72Ra extends from the cabinet portion 4 to the rear block 5.

The pipe 72Ra crosses the boundary Q2.

The pipe 72Ra has an inner portion 76Ra and an outer portion 77Ra. The inner portion 76Ra is disposed in the cabinet portion 4. The outer portion 77Ra is disposed in the rear block 5.

The pipe 72Ra includes one joint 78Ra. The joint 78Ra is disposed on the boundary Q2. The joint 78Ra connects the inner portion 76Ra and the outer portion 77Ra. The joint 78Ra attaches and detaches the inner portion 76Ra and the outer portion 77Ra. The liquid feeder 79Ra is provided on the inner portion 76Ra. The joint 78Ra is disposed downstream of the liquid feeder 79Ra.

The pipe 72Ra does not reach the front block 3. The pipe 72Ra does not extend from the cabinet portion 4 to the front block 3.

The pipe 72Ra does not cross the boundary Q1.

The pipe 72Ra does not reach the indexer portion 2. The pipe 72Ra does not extend from the cabinet portion 4 to the indexer portion 2.

The pipe 72Ra does not cross the boundary Q3.

The number of the joints 78Ra included in the pipe 72Ra is one.

The liquid feeder 79Ra is disposed at a height position same as a height position of the liquid feeder 79Fa.

The entire liquid feeder 79Fa is disposed in the cabinet portion 4. The liquid feeder 79Fa does not reach the front block 3. The liquid feeder 79Fa does not reach the rear block 5. The liquid feeder 79Fa does not reach the indexer portion 2.

The entire liquid feeder 79Ra is disposed in the cabinet portion 4. The liquid feeder 79Ra does not reach the front block 3. The liquid feeder 79Ra does not reach the rear block 5. The liquid feeder 79Ra does not reach the indexer portion 2.

The front block 3 is an example of a first block of the present invention. The chamber 6 is an example of a first chamber of the present invention. The processing unit 20 is an example of a first processing unit of the present invention.

The processing liquid container 71a is an example of a first processing liquid container of the present invention.

The rear block 5 is an example of a second block of the present invention. The chamber 8 is an example of a second chamber of the present invention.

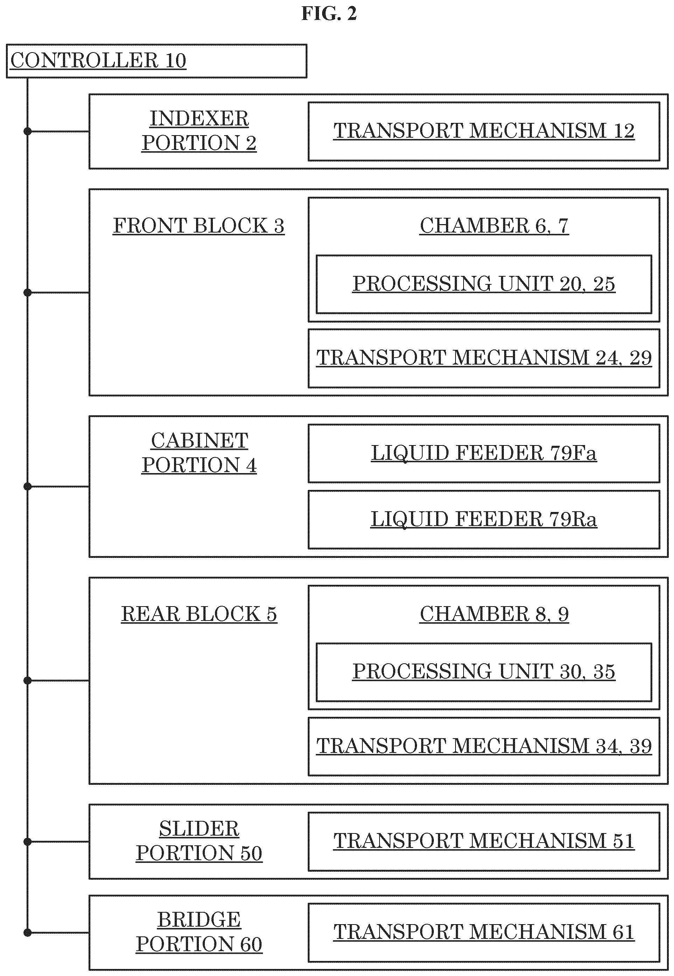

FIG. 2 is a control block diagram of the substrate processing apparatus 1. The substrate processing apparatus 1 includes a controller 10. The controller 10 controls the indexer portion 2, the front block 3, the cabinet portion 4, and the rear block 5. Specifically, the controller 10 controls the chamber 6. The controller 10 controls the processing unit 20. The controller 10 controls the liquid feeders 79Fa and 79Ra. The controller 10 controls the chamber 8. The controller 10 controls the processing unit 30.

The controller 10 is implemented by, for example, a central processing unit (CPU), a random access memory (RAM), and a storage medium. The central processing unit executes arithmetic processing. The random access memory functions as a work area for arithmetic processing. The storage medium is, for example, a fixed disk. The controller 10 has various types of information stored in advance in the storage medium. The information included in the controller 10 includes, for example, transport information and processing information. The transport information defines a procedure of transporting the substrate W. The processing information defines a procedure of processing the substrate W. The processing information is also referred to as a processing recipe.

### <2. Indexer portion 2>

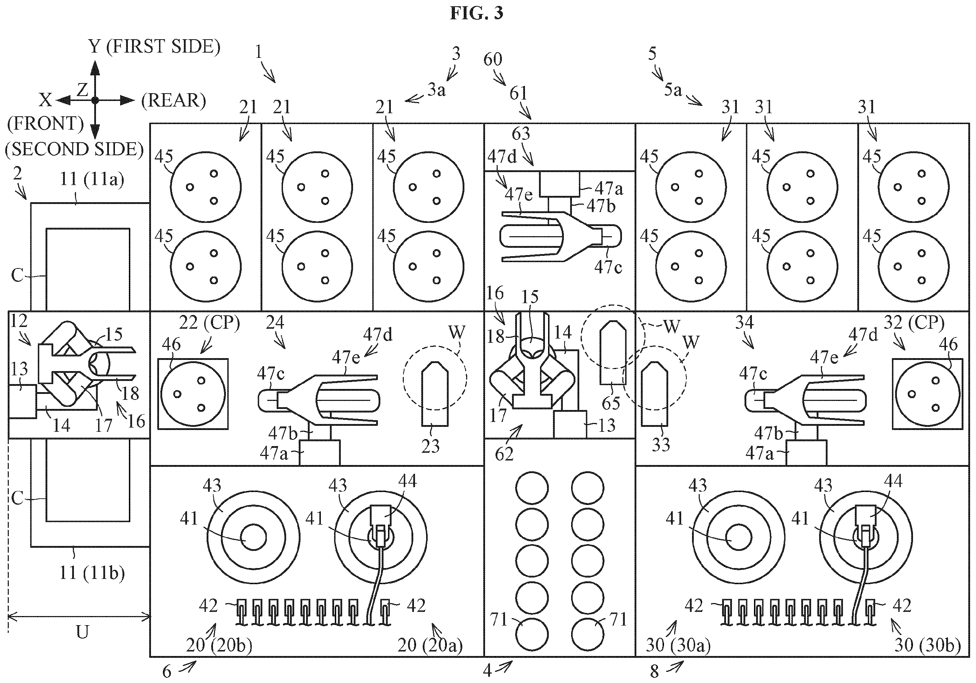

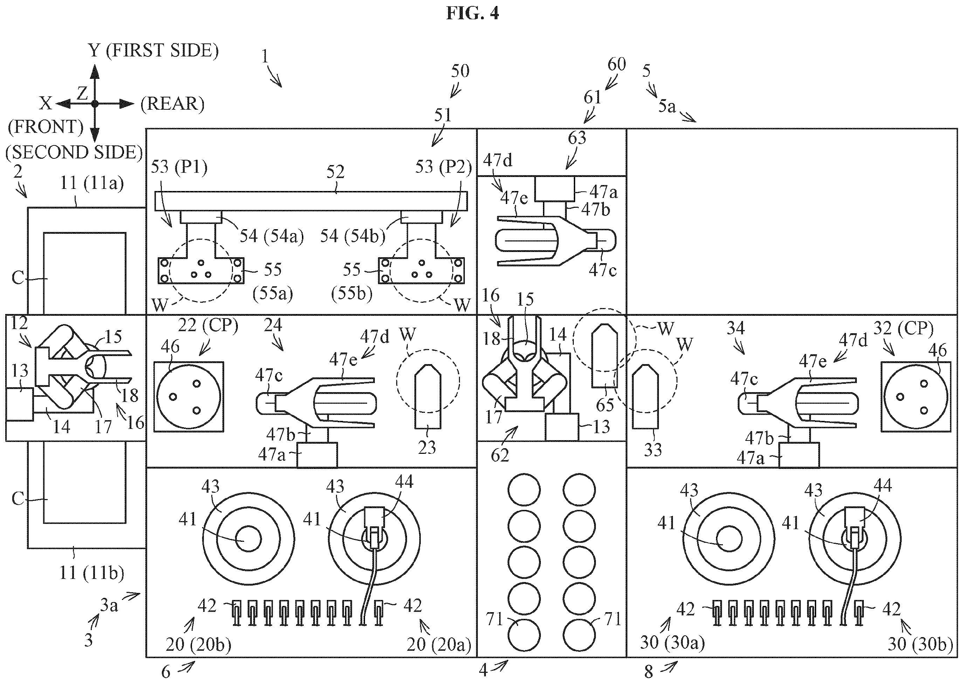

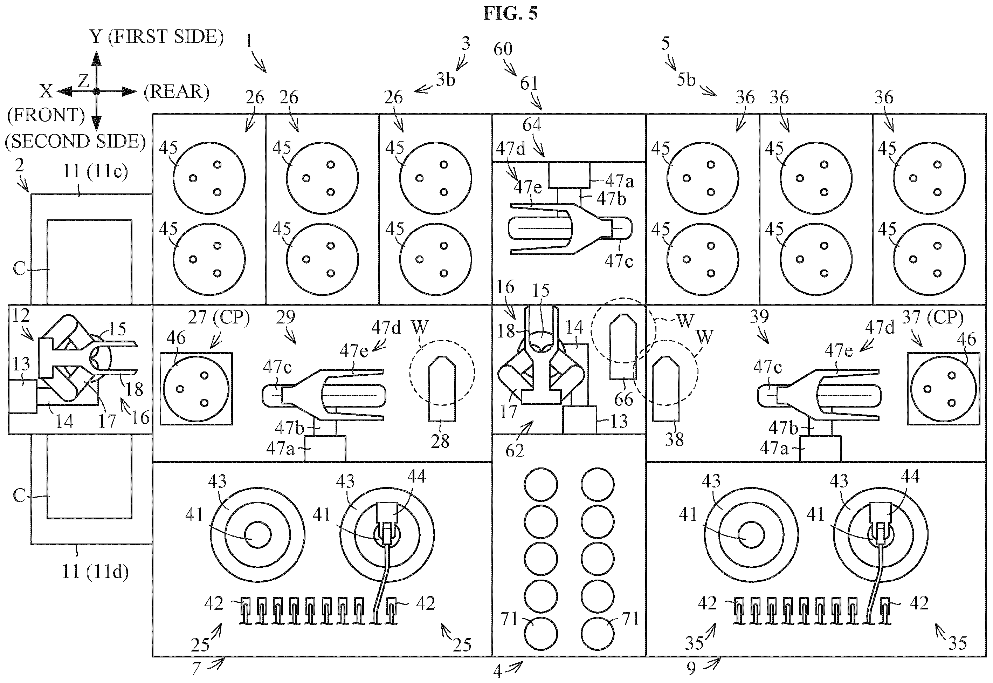

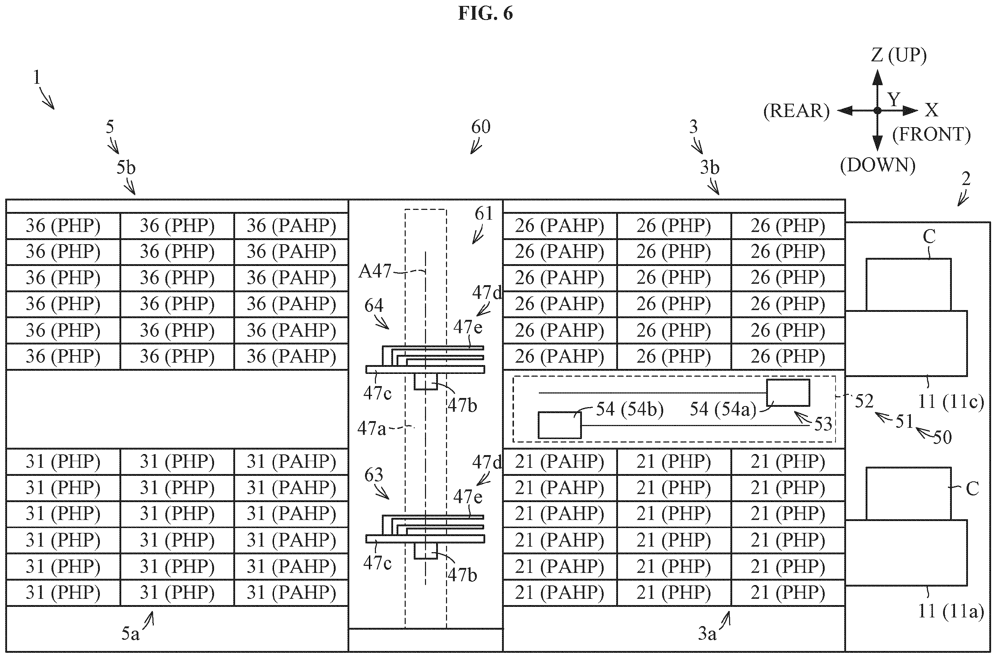

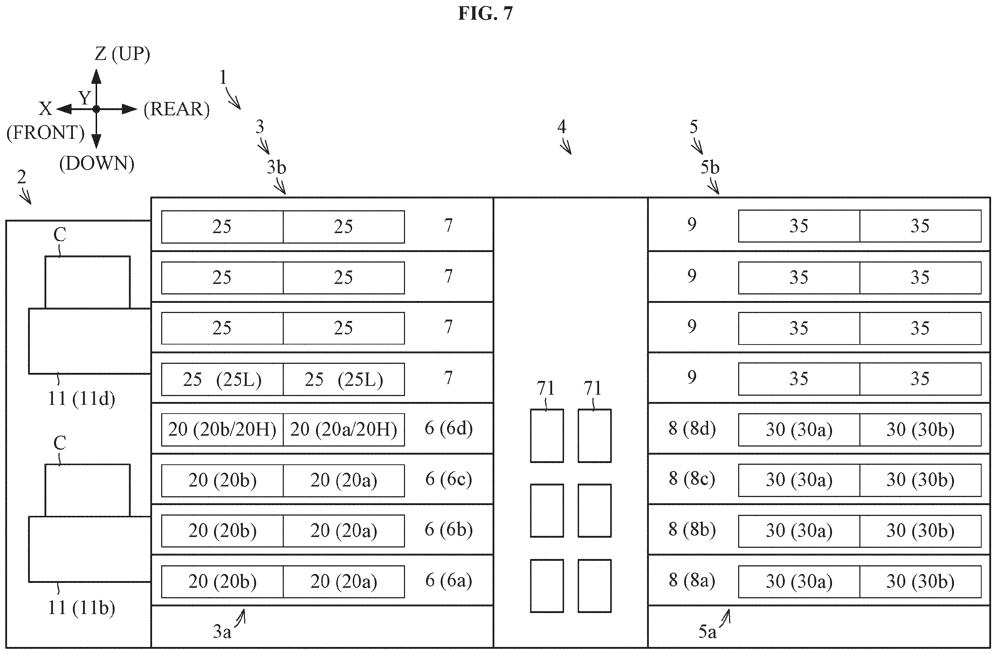

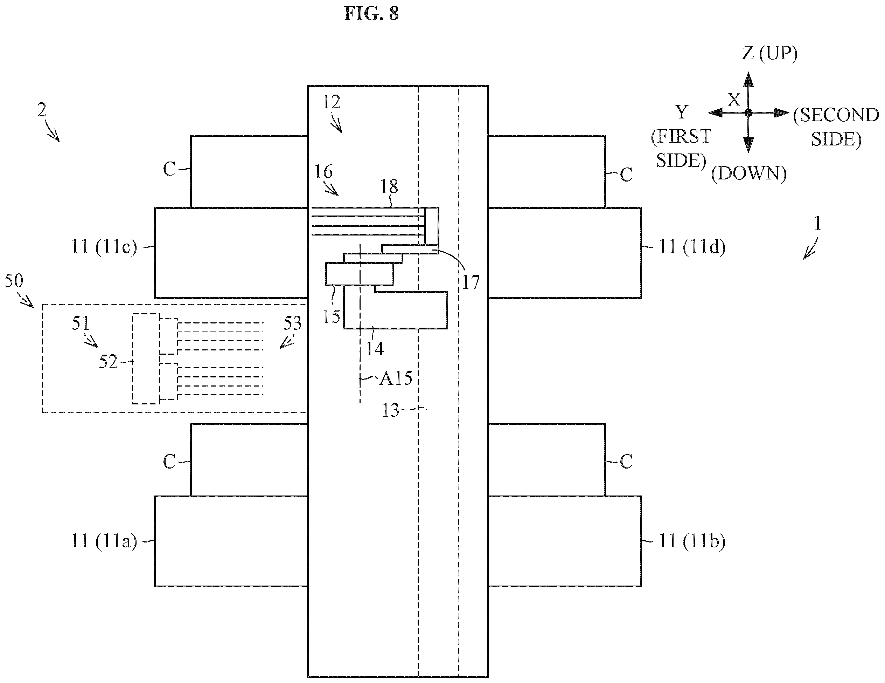

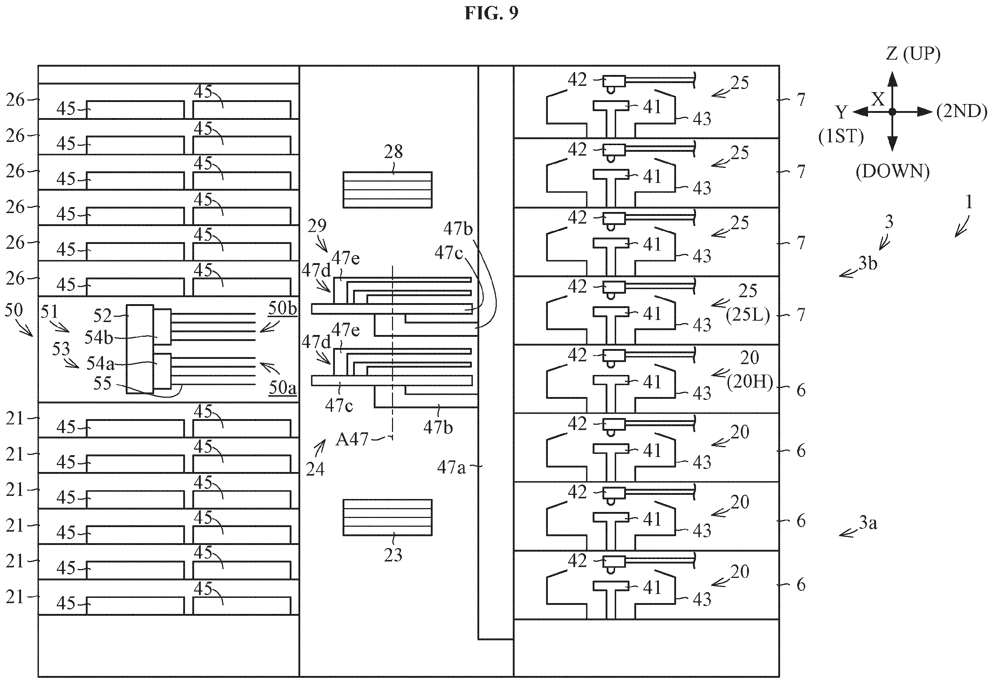

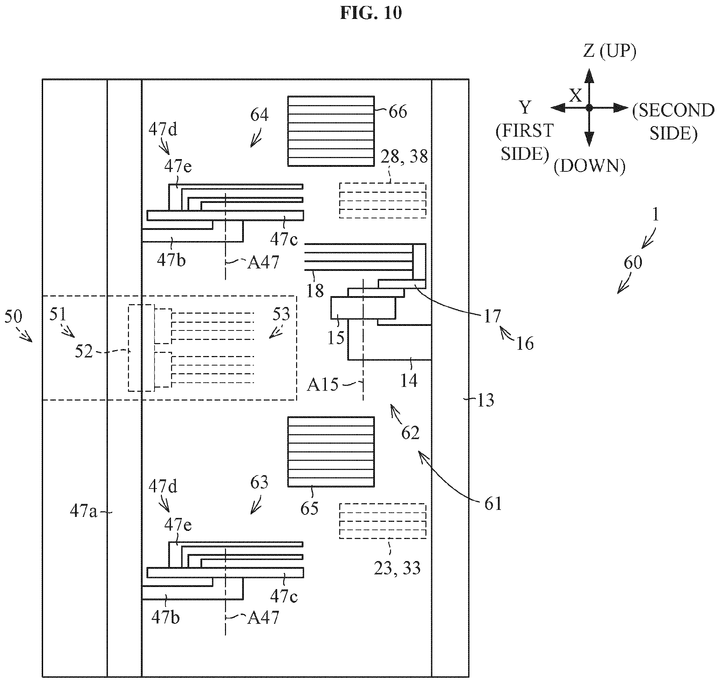

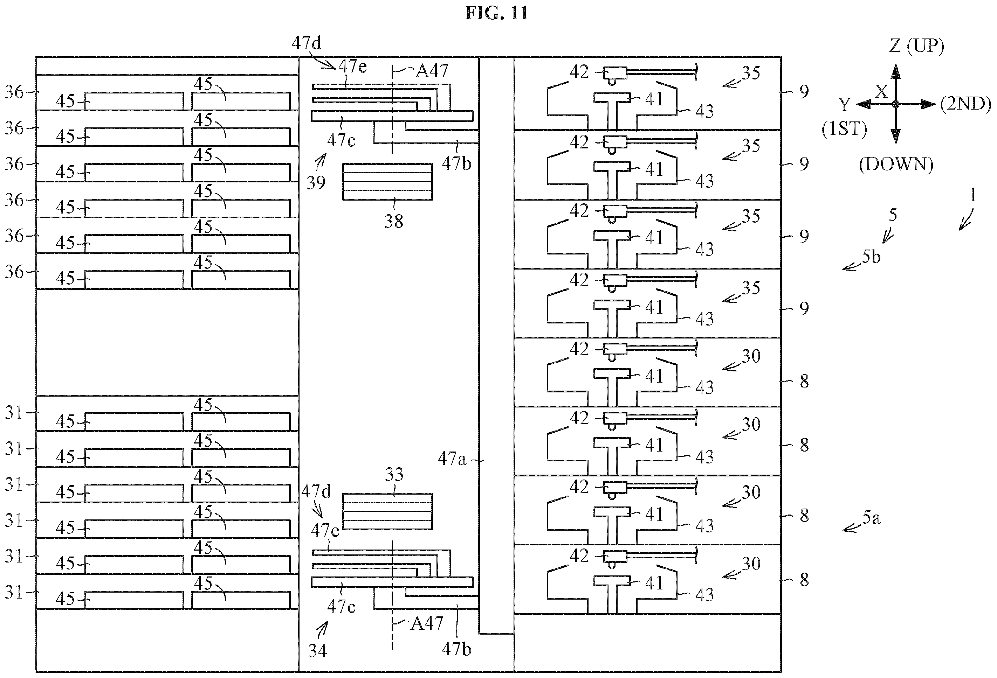

FIGS. 3, 4, and 5 each are plan views of the substrate processing apparatus 1. FIG. 3 illustrates a lower portion of the substrate processing apparatus 1 in the vertical direction Z. FIG. 4 illustrates a middle portion of the substrate processing apparatus 1 in the vertical direction Z. FIG. 5 illustrates an upper portion of the substrate processing apparatus 1 in the vertical direction Z. FIG. 6 is a first side view of the substrate processing apparatus 1. FIG. 7 is a second side view of the substrate processing apparatus 1. FIG. 8 is a front view of the indexer portion 2. FIG. 9 is a front view of the front block 3. FIG. 10 is a front view of a bridge portion 60. FIG. 11 is a front view of the rear block 5.

The indexer portion 2 includes a plurality of (for example, four) carrier stages 11. One carrier C is placed on each carrier stage 11.

The carrier C accommodates a plurality of substrates W. The carrier C is, for example, a front opening unified pod (FOUP), a standard mechanical interface (SMIF), or an open cassette (OC). The carrier C is transported to the substrate processing apparatus 1 by a carrier transport mechanism (not illustrated).

The indexer portion 2 includes the transport mechanism 12. The transport mechanism 12 transports the substrate W to the carrier C.

The transport mechanism 12 is, for example, a transport robot.

The transport mechanism 12 includes a support column 13, a lift portion 14, a rotation portion 15, and a support portion 16. In FIG. 8, the support column 13 is indicated by a broken line for convenience. The support column 13 is fixedly installed. The support column 13 extends in the vertical direction Z. The lift portion 14 is supported by the support column 13. The lift portion 14 moves in the vertical direction Z with respect to the support column 13. The rotation portion 15 is supported by the lift portion 14. The rotation portion 15 rotates about a rotation axis A15 with respect to the lift portion 14. The rotation axis A15 is illustrated in FIG. 8. The rotation axis A15 extends in the vertical direction Z. The rotation axis A15 passes through the rotation portion 15, for example. The support portion 16 is supported by the rotation portion 15. The support portion 16 moves forward and backward with respect to the rotation portion 15. More specifically, the support portion 16 reciprocates in one direction determined by an orientation of the rotation portion 15. "One direction determined by an orientation of the rotation portion 15" is a radial direction of the rotation axis A15. The radial direction of the rotation axis A15 is horizontal. The support portion 16 supports the substrate W.

The support portion 16 supports a plurality of substrates W at a time. The transport mechanism 12 transports a plurality of substrates W at a time.

The support portion 16 includes an articulated arm 17 and a plurality of hands 18. The articulated arm 17 is directly supported by the rotation portion 15. The hand 18 is directly supported by the articulated arm 17. The articulated arm 17 bends and extends. As a result, the hand 18 moves forward and backward with respect to the rotation portion 15. Each of the hands 18 supports one substrate W.

Each of the hands 18 supports the substrate W in a horizontal posture. Each of the hands 18 is in contact with a back surface of the substrate W. Each of the hands 18 is in contact with a peripheral portion of the back surface of the substrate W. Each of the hands 18 has a Y-shape in plan view.

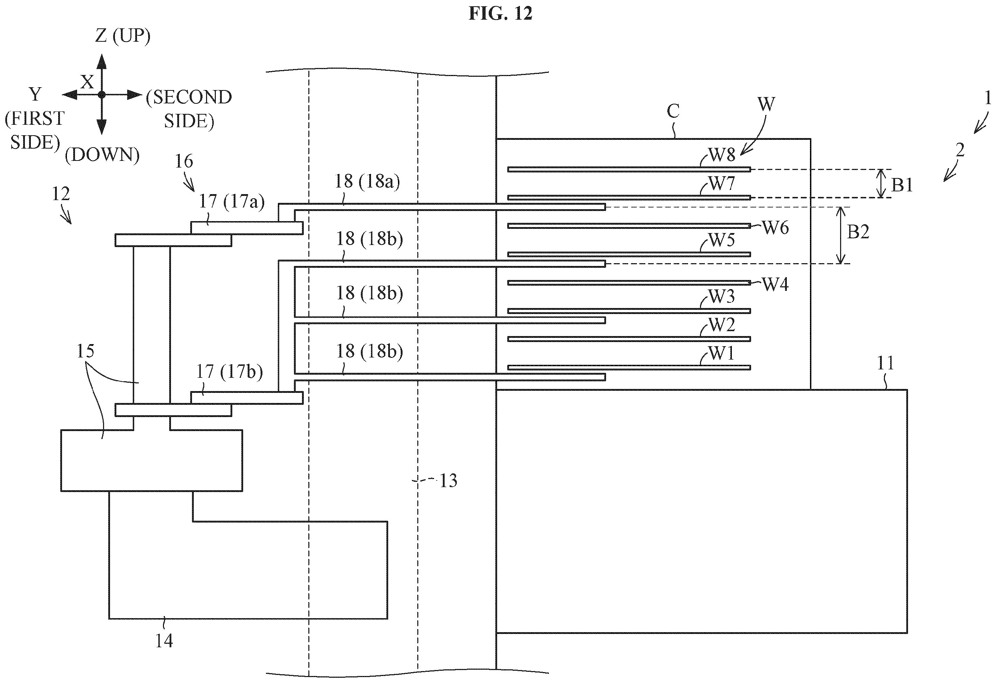

FIG. 12 is a detailed front view of the indexer portion 2. The carrier C supports the substrate W in a horizontal posture. In the carrier C, a plurality of substrates W are arranged in the vertical direction Z. A distance between two substrates W adjacent to each other in the vertical direction Z in the carrier C is referred to as a pitch B1. The pitch B1 is, for example, 10 mm.

The plurality of hands 18 are arranged in the vertical direction Z. A distance between two hands 18 adjacent to each other in the vertical direction Z is referred to as a pitch B2. The pitch B2 is twice the pitch B1. The pitch B2 is, for example, 20mm.

The substrates W in the carrier C are referred to as substrates W1, W2, W3, W4, W5, W6, W7, and W8. The substrates W1, W2, W3, W4, W5, W6, W7, and W8 are arranged in this order in the vertical direction Z. The transport mechanism 12 takes the substrates W1, W3, W5, and W7 in the carrier C on the carrier stage 11 at a time. The transport mechanism 12 places the substrates W1, W3, W5, and W7 into the carrier C on the carrier stage 11 at a time. Similarly, the transport mechanism 12 transports the substrates W2, W4, W6, and W8 to the carrier C on the carrier stage 11 at a time.

At least one of the hands 18 may move relative to the rotation portion 15 independently of other hands 18. In this case, it is also easy for the transport mechanism 12 to transport one substrate W at a time.

For example, the articulated arm 17 includes articulated arms 17a and 17b. The articulated arm 17b operates independently of the articulated arm 17a. Each of the articulated arms 17a and 17b is directly supported by the rotation portion 15. The articulated arm 17a supports one hand 18. The articulated arm 17b supports other three hands 18.

For convenience, one hand 18 supported by the articulated arm 17a is referred to as a "hand 18a". The hands 18 supported by the articulated arm 17b are referred to as a "hands 18b". The articulated arm 17a moves the hand 18a forward and backward with respect to the rotation portion 15. The articulated arm 17b moves the hand 18b forward and backward with respect to the rotation portion 15. The hand 18b moves independently of the hand 18a.

For example, when the transport mechanism 12 transports one substrate W, the articulated arm 17a alone moves the hand 18a, and the articulated arm 17b does not move the hands 18b. When the transport mechanism 12 transports one substrate W, the hand 18a alone supports the substrate W, and the hands 18b do not support the substrate W.

For example, when the transport mechanism 12 transports a plurality of substrates W, the articulated arms 17a and 17b may move the hands 18a and 18b in synchronization. When the transport mechanism 12 transports a plurality of substrates W, the hands 18a and 18b each may simultaneously support the substrates W.

### <3. Front block 3 and rear block 5>

Reference is made to FIGS. 3 to 11. The front block 3 includes a first front portion 3a. The first front portion 3a is one layer of the front block 3. The first front portion 3a includes a plurality of chambers 6. Each chamber 6 includes a plurality of processing units 20. Furthermore, the first front portion 3a includes a plurality of processing units 21 and a plurality of processing units 22. The first front portion 3a includes a placing portion 23. The first front portion 3a includes a transport mechanism 24. The transport mechanism 24 transports the substrate W to the chamber 6, the processing units 21 and 22, and the placing portion 23.

The front block 3 includes a second front portion 3b. The second front portion 3b is another layer of the front block 3. The second front portion 3b includes a plurality of chambers 7. Each chamber 7 includes a plurality of processing units 25. Furthermore, the second front portion 3b includes a plurality of processing units 26 and a plurality of processing units 27. The second front portion 3b includes a placing portion 28. The second front portion 3b includes a transport mechanism 29. The transport mechanism 29 transports the substrate W to the chamber 7, the processing units 26 and 27, and the placing portion 28.

The rear block 5 includes a first rear portion 5a. The first rear portion 5a is one layer of the rear block 5. The first rear portion 5a includes a plurality of chambers 8. Each chamber 8 includes a plurality of processing units 30. Furthermore, the first rear portion 5a includes a plurality of processing units 31 and a plurality of processing units 32. The first rear portion 5a includes a placing portion 33. The first rear portion 5a includes a transport mechanism 34. The transport mechanism 34 transports the substrate W to the chamber 8, the processing units 31 and 32, and the placing portion 33.

The rear block 5 includes a second rear portion 5b. The second rear portion 5b is another layer of the rear block 5. The second rear portion 5b includes a plurality of chambers 9. Each chamber 9 includes a plurality of processing units 35. Further, the second rear portion 5b includes a plurality of processing units 36 and a plurality of processing units 37. The second rear portion 5b includes a placing portion 38. The second rear portion 5b includes a transport mechanism 39. The transport mechanism 39 transports the substrate W to the chamber 9, the processing units 36 and 37, and the placing portion 38.

The chamber 6 and the processing unit 20 will be described. Each chamber 6 includes the processing unit 20 as described above. The processing unit 20 includes a plurality of nozzles 42. Each nozzle 42 dispenses a processing liquid. A composition of the processing liquid dispensed from one nozzle 42 may be different from a composition of the processing liquid dispensed from another nozzle 42. The composition of the processing liquid dispensed from one nozzle 42 may be identical to the composition of the processing liquid dispensed from another nozzle 42.

The processing unit 20 further includes a nozzle transport mechanism 44. The nozzle transport mechanism 44 holds one nozzle 42 and moves the nozzle 42 between a standby position and a processing position. The standby position is a position outward of the cup 43. The processing position is a position upward of the substrate W held by the holding portion 41. When the nozzle 42 is located at the processing position, the nozzle 42 dispenses the processing liquid onto the substrate W held by the holding portion 41.

For example, the nozzle 42 is shared by a plurality of processing units 20 belonging to one chamber 6.

The plurality of processing units 20 belonging to one chamber 6 are referred to as processing units 20a and 20b for convenience, in order to distinguish from one another. One chamber 6 includes the processing units 20a and 20b. The processing unit 20a includes a nozzle 42. The processing unit 20b shares the nozzle 42 of the processing unit 20a.

For example, the nozzle 42 dispenses the processing liquid onto the substrate W held by the holding portion 41 of the processing unit 20a, and dispenses the processing liquid onto the substrate W held by the holding portion 41 of the processing unit 20b. The nozzle 42 is configured to move to a position upward of the substrate W held by the holding portion 41 of the processing unit 20a, and is configured to move to a position upward of the substrate W held by the holding portion 41 of the processing unit 20b.

The processing unit 20a is an example of a first processing unit of the present invention. The processing unit 20b is an example of a second processing unit of the present invention.

The chamber 7 has the same structure as the chamber 6. Similarly, the chamber 8 has the same structure as the chamber 6. The chamber 9 has the same structure as the chamber 6.

The processing unit 25 has the same structure as the processing unit 20. Similarly, the processing unit 30 has the same structure as the processing unit 20. The processing unit 35 has the same structure as the processing unit 20.

The processing units 21 and 22 will be described. Each of the processing units 21 and 22 processes the substrate W. Each of the processing units 21 and 22 processes one substrate W at a time.

Each of the processing units 21 and 22 performs non-liquid processing on the substrate W.

The "non-liquid processing" is processing or inspection performed on the substrate W without supplying the processing liquid to the substrate W. The "non-liquid processing" includes, for example, at least one of heat processing or inspection.

Reference is made to FIG. 6. For example, some processing units 21 are classified as adhesion reinforcing processing units PAHP. The adhesion reinforcing processing unit PAHP performs adhesion reinforcing processing. The adhesion reinforcing processing is for improving adhesion between the substrate W and a coating film. For example, the adhesion reinforcing processing unit PAHP supplies hexamethyldisilazane (HMDS) to the substrate W and adjusts a temperature of the substrate W to a predetermined temperature. Other processing units 21 are classified as heating and cooling units PHP. The heating and cooling unit PHP heats the substrate W and then cools the substrate W.

Reference is made to FIG. 3. Each of the processing units 21 includes one or two support members 45. The support member 45 supports the substrate W in a horizontal posture. The support member 45 includes, for example, at least one of a horizontal plate or a vertical pin. Each of the processing units 21 may include a heater (not illustrated). The heater heats the substrate W on the support member 45. Each of the processing units 21 may include a cooler (not illustrated). The cooler cools the substrate W on the support member 45. When the processing unit 21 includes two support members 45, the processing unit 21 may further include a local transport mechanism (not illustrated). The local transport mechanism transports the substrate W between the two support members 45.

The processing unit 26 has the same structure as the processing unit 21. Similarly, each of the processing units 31 and 36 has the same structure as the processing unit 21.

For example, the processing unit 22 is classified as a cooling unit CP. The cooling unit CP cools the substrate W.

Each of the processing units 22 includes one support member 46. The support member 46 supports the substrate W in a horizontal posture. The support member 46 includes, for example, at least one of a horizontal plate or a vertical pin. Each of the processing units 22 includes a cooler (not illustrated). The cooler cools the substrate W on the support member 46.

The processing unit 27 has the same structure as the processing unit 22. Similarly, each of the processing units 32 and 37 has the same structure as the processing unit 22.

The placing portion 23 will be described. A plurality of (for example, four) substrates W are placed on the placing portion 23 at a time. The placing portion 23 supports the substrate W in a horizontal posture. The plurality of substrates W on the placing portion 23 are arranged in the vertical direction Z. Although not illustrated, the placing portion 23 includes, for example, at least one of a horizontal plate, a support pin, or a shelf.

The placing portion 28 has the same structure as the placing portion 23. Similarly, each of the placing portions 33 and 38 has the same structure as the placing portion 23.

The transport mechanism 24 is, for example, a transport robot. The transport mechanism 29 is, for example, a transport robot. The transport mechanism 34 is, for example, a transport robot. The transport mechanism 39 is, for example, a transport robot.

A structure of the transport mechanism 24 will be described. The transport mechanism 24 includes a support column 47a, a lift portion 47b, a rotation portion 47c, and a support portion 47d. The support column 47a is fixedly installed. The support column 47a extends in the vertical direction Z. The lift portion 47b is supported by the support column 47a. The lift portion 47b moves in the vertical direction Z with respect to the support column 47a. The rotation portion 47c is supported by the lift portion 47b. The rotation portion 47c rotates about a rotation axis A47 with respect to the lift portion 47b. The rotation axis A47 is illustrated in FIG. 9. The rotation axis A47 extends in the vertical direction Z. The rotation axis A47 passes through, for example, the rotation portion 47c. The support portion 47d is supported by the rotation portion 47c. The support portion 47d moves forward and backward with respect to the rotation portion 47c. More specifically, the support portion 47d reciprocates in one direction determined by an orientation of the rotation portion 47c. "One direction determined by an orientation of the rotation portion 47c" is a radial direction of the rotation axis A47. The radial direction of the rotation axis A47 is horizontal. The support portion 47d supports the substrate W.

The support portion 47d supports a plurality of substrates W at a time. The transport mechanism 24 transports a plurality of substrates W at a time.

The support portion 47d includes a plurality of (for example, two) hands 47e. Each hand 47e is directly supported by the rotation portion 47c. Each hand 47e slides with respect to the rotation portion 47c. Each of the hands 47e supports one substrate W.

Each of the hands 47e supports the substrate W in a horizontal posture. Each of the hands 47e is in contact with a back surface of the substrate W. Each of the hands 47e is in contact with a peripheral portion of the back surface of the substrate W. Each of the hands 47e has a Y-shape in plan view.

The plurality of hands 47e are arranged in the vertical direction Z.

The plurality of hands 47e may move with respect to the rotation portion 47c independently of one another.

The transport mechanism 29 has the same structure as the transport mechanism 24. Similarly, each of the transport mechanisms 34 and 39 has the same structure as the transport mechanism 24.

### <4. Slider portion and bridge portion>

Reference is made to FIGS. 4, 6, and 9. The substrate processing apparatus 1 further includes a slider portion 50 and the bridge portion 60. The slider portion 50 is connected to the indexer portion 2. The slider portion 50 is connected to the bridge portion 60. The slider portion 50 transports the substrate W between the indexer portion 2 and the bridge portion 60.

The indexer portion 2 transports the substrate W to the slider portion 50. The indexer portion 2 transports the substrate W between the carrier C and the slider portion 50. For example, the transport mechanism 12 transports the substrate W between the carrier C and the slider portion 50.

The bridge portion 60 transports the substrate W to the slider portion 50.

The slider portion 50 will be described. The slider portion 50 includes a transport mechanism 51. The transport mechanism 51 transports the substrate W.

The transport mechanism 51 is, for example, a transport robot.

The transport mechanism 51 includes a guide 52 and a support portion 53. The guide 52 is fixedly installed. The guide 52 extends linearly. The guide 52 extends in the front-rear direction X. The support portion 53 is attached to the guide 52. The support portion 53 is guided by the guide 52. The support portion 53 slides with respect to the guide 52. The support portion 53 moves parallel to the guide 52. The support portion 53 linearly moves along the guide 52. The support portion 53 moves in the front-rear direction X along the guide 52. The support portion 53 reciprocates along the guide 52. The support portion 53 supports the substrate W.

The transport mechanism 51 does not reach the indexer portion 2. The guide 52 does not reach the indexer portion 2. The transport mechanism 51 does not enter the indexer portion 2. The support portion 53 does not enter the indexer portion 2.

The transport mechanism 51 does not reach the bridge portion 60. The guide 52 does not reach the bridge portion 60. The transport mechanism 51 does not enter the bridge portion 60. The support portion 53 does not enter the bridge portion 60.

The support portion 53 does not move in the width direction Y with respect to the guide 52. For example, the support portion 53 does not extend or contract with respect to the guide 52.

The support portion 53 supports a plurality of substrates W at a time. The transport mechanism 51 transports a plurality of substrates W at a time.

The support portion 53 includes a movable element 54 and a plurality of (for example, eight) hands 55. The movable element 54 is directly supported by the guide 52. The hands 55 are directly supported by the movable element 54. The movable element 54 slides with respect to the guide 52. As a result, the hands 55 move with respect to the guide 52. Each of the hands 55 supports one substrate W.

Each of the hands 55 supports the substrate W in a horizontal posture. Each of the hands 55 is in contact with a back surface of the substrate W. Each of the hands 55 is in contact with a central portion of the back surface of the substrate W. Each of the hands 55 has a T-shape in plan view.

The plurality of hands 55 are arranged in the vertical direction Z.

Some of the hands 55 may move relative to the guide 52 independently of other hands 55. **In** this case, it is easy for the transport mechanism 51 to efficiently transport a large number of substrates W.

For example, the movable element 54 includes movable elements 54a and 54b. The movable element 54b operates independently of the movable element 54a. Each of the movable elements 54a and 54b is directly supported by the guide 52. Each of the movable elements 54a and 54b supports a plurality of (four) hands 55.

For convenience, the hands 55 supported by the movable element 54a are referred to as a "hands 55a". The hands 55 supported by the movable element 54b are referred to as a "hands 55b". The movable element 54a moves the hands 55a with respect to the guide 52. The movable element 54b moves the hands 55b with respect to the guide 52. The hands 55b move independently of the hands 55a.

For example, each of the hands 55a and 55b may transport the substrate W in one direction alone. The hand 55a transports the substrate W from the indexer portion 2 to the bridge portion 60, and does not transport the substrate W from the bridge portion 60 to the indexer portion 2. The hand 55b transports the substrate W from the bridge portion 60 to the indexer portion 2, and does not transport the substrate W from the indexer portion 2 to the bridge portion 60.

Alternatively, each of the hands 55a and 55b may transport the substrate W in both directions. The hand 55a transports the substrate W from the indexer portion 2 to the bridge portion 60, and transports the substrate W from the bridge portion 60 to the indexer portion 2. The hand 55b transports the substrate W from the indexer portion 2 to the bridge portion 60, and transports the substrate W from the bridge portion 60 to the indexer portion 2.

A structure of the transport mechanism 51 will be described. Although not illustrated, the transport mechanism 51 includes a drive mechanism. The drive mechanism moves the support portion 53 with respect to the guide 52.

The drive mechanism is provided to the guide 52, for example. The drive mechanism includes, for example, a driving pulley, a driven pulley, a belt, and a motor. The belt is wrapped around the driving pulley and the driven pulley. The belt extends along the guide 52. The support portion 53 is attached to the belt. For example, the movable element 54 is attached to the belt. The motor is connected to the driving pulley. The motor rotates the driving pulley in a forward direction and a reverse direction. When the driving pulley rotates, the belt rotates between the driving pulley and the driven pulley, and the support portion 53 reciprocates between the driving pulley and the driven pulley.

Alternatively, the drive mechanism may be provided to the support portion 53. The drive mechanism may include a ball screw mechanism. The drive mechanism may include an air cylinder.

The bridge portion 60 will be described.

Reference is made to FIGS. 3 to 6 and 10. As described above, the bridge portion 60 transports the substrate W to the slider portion 50.

The bridge portion 60 is connected to the front block 3 and the rear block 5. The bridge portion 60 transports the substrate W to the front block 3 and the rear block 5. For example, the bridge portion 60 transports the substrate W between the slider portion 50, the front block 3, and the rear block 5.

For example, the bridge portion 60 is connected to the first front portion 3a, the second front portion 3b, the first rear portion 5a, and the second rear portion 5b. The bridge portion 60 transports the substrate W to the first front portion 3a, the second front portion 3b, the first rear portion 5a, and the second rear portion 5b. The bridge portion 60 transports the substrate W between the slider portion 50, the first front portion 3a, the second front portion 3b, the first rear portion 5a, and the second rear portion 5b.

The bridge portion 60 performs "take-in", "distribution", "collection", and "discharge".

"Take-in" means taking the substrate W in the slider portion 50 and transporting the substrate W from the slider portion 50 to the bridge portion 60.

"Distribution" means transporting the substrate W from the bridge portion 60 to the front block 3 and the rear block 5, and placing the substrate W in the front block 3 and the rear block 5. For example, "distribution" means transporting the substrate W from the bridge portion 60 to the first front portion 3a, the second front portion 3b, the first rear portion 5a, and the second rear portion 5b, and placing the substrate W in the first front portion 3a, the second front portion 3b, the first rear portion 5a, and the second rear portion 5b.

"Collection" means taking the substrate W in the front block 3 and the rear block 5, and transporting the substrate W from the front block 3 and the rear block 5 to the bridge portion 60. For example, "collection" means taking the substrate W in the first front portion 3a, the second front portion 3b, the first rear portion 5a, and the second rear portion 5b, and transporting the substrate W from the first front portion 3a, the second front portion 3b, the first rear portion 5a, and the second rear portion 5b to the bridge portion 60.

"Discharge" means transporting the substrate W from the bridge portion 60 to the slider portion 50 and placing the substrate W in the slider portion 50.

The bridge portion 60 includes a transport mechanism 61. The transport mechanism 61 performs the above-described "take-in", "distribution", "collection", and "discharge".

The transport mechanism 61 is, for example, a transport robot.

For example, the transport mechanism 61 includes a plurality of transport mechanisms. The transport mechanism 61 includes transport mechanisms 62, 63, and 64. The transport mechanism 62 performs "take-in", "collection", and "discharge". Each of the transport mechanisms 63 and 64 performs a part of "distribution". The transport mechanism 63 performs distribution related to the first front portion 3a and the first rear portion 5a. The transport mechanism 64 performs distribution related to the second front portion 3b and the second rear portion 5b.

The transport mechanism 62 is, for example, a transport robot. The transport mechanism 63 is, for example, a transport robot. The transport mechanism 64 is, for example, a transport robot.

The bridge portion 60 includes a placing portion 65. A plurality of (for example, eight) substrates W are placed on the placing portion 65 at a time. The placing portion 65 supports the substrate W in a horizontal posture. The plurality of substrates W on the placing portion 65 are arranged in the vertical direction Z. Although not illustrated, the placing portion 65 includes, for example, at least one of a horizontal plate, a support pin, or a shelf.

The bridge portion 60 includes a placing portion 66. The placing portion 66 has the same structure as the placing portion 65.

The transport mechanism 62 and the transport mechanism 63 deliver the substrate W to each other via the placing portion 65. The transport mechanism 62 and the transport mechanism 64 deliver the substrate W to each other via the placing portion 66. For example, the transport mechanism 62 distributes the substrate W to the placing portions 65 and 66. The transport mechanism 62 distributes the substrate W to the transport mechanisms 63 and 64 via the placing portions 65 and 66.

A structure of the transport mechanism 62 will be described. The transport mechanism 62 has the same structure as the transport mechanism 12 of the indexer portion 2. For example, the transport mechanism 62 includes a support column 13, a lift portion 14, a rotation portion 15, and a support portion 16. The support portion 16 includes an articulated arm 17 and a plurality of hands 18.

Structures of the transport mechanisms 63 and 64 will be described. For example, each of the transport mechanisms 63 and 64 has the same structure as the transport mechanism 24 of the front block 3. For example, each of the transport mechanisms 63 and 64 includes a support column 47a, a lift portion 47b, a rotation portion 47c, and a support portion 47d. The support portion 47d includes a plurality of (for example, two) hands 47e.

The support portion 16 of the transport mechanism 62, the support portion 47d of the transport mechanism 63, and the support portion 47d of the transport mechanism 64 are referred to as "support portions of the transport mechanism 61" when not distinguished from one another. The hand 18 of the transport mechanism 62, the hand 47e of the transport mechanism 63, and the hand 47e of the transport mechanism 64 are referred to as "hands of the support portion of the transport mechanism 61" or "hands of the transport mechanism 61" when not distinguished from one another.

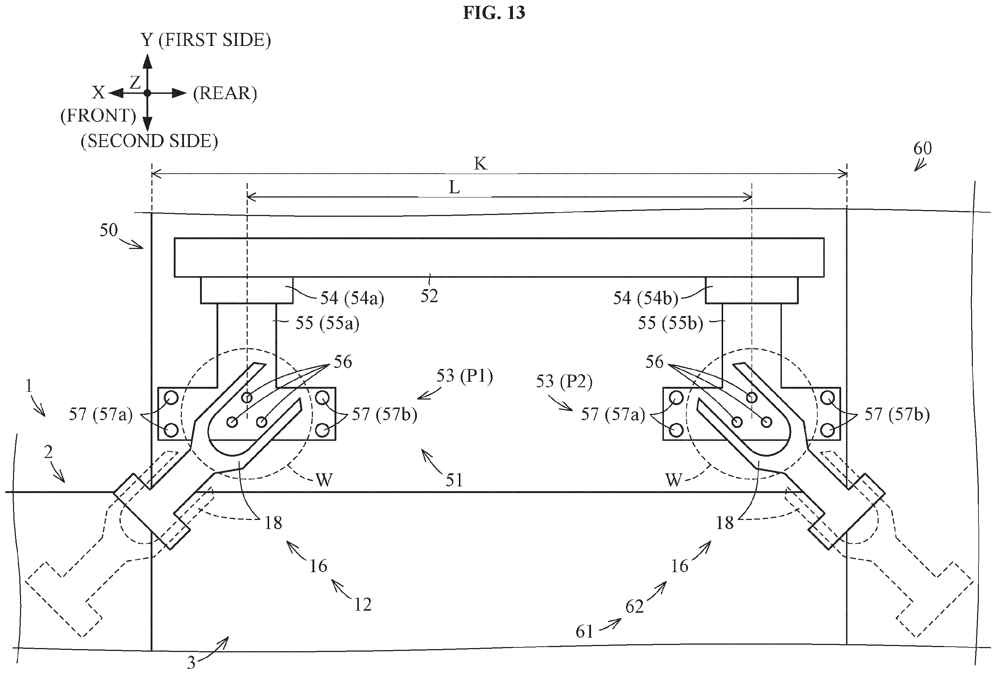

FIG. 13 is a detailed plan view of the slider portion 50. The hand 55 includes one or more (for example, three) contact portions 56. The contact portion 56 is in contact with a back surface of the substrate W. The contact portion 56 is in contact with a central portion of the back surface of the substrate W. The contact portion 56 has, for example, a pin shape or a pad shape.

The contact portion 56 may suction the back surface of the substrate W.

The hand 55 includes one or more (for example, four) guards 57. The guard 57 is disposed slightly outward of the substrate W. The guard 57 can come into contact with a peripheral edge of the substrate W. For example, when the substrate W is significantly shifted relative to the hand 55, the guard 57 comes into contact with the peripheral edge of the substrate W. The guard 57 inhibits falling of the substrate W from the hand 55.

The guard 57 is disposed outward of the contact portion 56.

The guard 57 includes a guard 57a and a guard 57b. The guard 57a, the contact portion 56, and the guard 57b are arranged in this order in the front-rear direction X. The guard 57a is disposed frontward of the contact portion 56. The guard 57b is disposed rearward of the contact portion 56. The contact portion 56 is disposed between the guard 57a and the guard 57b.

The transport mechanism 12 and the transport mechanism 51 deliver the substrate W to each other. The transport mechanism 12 and the transport mechanism 51 may deliver a plurality of substrates W to each other at a time.

When the transport mechanism 12 and the transport mechanism 51 deliver the substrate W to each other, a part of the transport mechanism 12 enters the slider portion 50. When the transport mechanism 12 and the transport mechanism 51 deliver the substrate W to each other, the support portion 16 of the transport mechanism 12 enters the slider portion 50.

When the transport mechanism 12 and the transport mechanism 51 deliver the substrate W to each other, the support portion 53 is located at a first position P1. The first position P1 is located in the slider portion 50.

When the transport mechanism 12 and the transport mechanism 51 deliver the substrate W to each other, the support portion 53 stands still. When the transport mechanism 12 and the transport mechanism 51 deliver the substrate W to each other, the transport mechanism 12 moves. The transport mechanism 12 places the substrate W on the transport mechanism 51. The transport mechanism 12 takes the substrate W on the transport mechanism 51.

When the transport mechanism 12 and the transport mechanism 51 deliver the substrate W to each other, the contact portion 56 does not interfere with the transport mechanism 12. When the transport mechanism 12 and the transport mechanism 51 deliver the substrate W to each other, the contact portion 56 does not overlap with the hand 18 of the transport mechanism 12 in plan view. When the transport mechanism 12 and the transport mechanism 51 deliver the substrate W to each other, the hand 18 of the transport mechanism 12 is located outward of the contact portion 56 in plan view.

When the transport mechanism 12 and the transport mechanism 51 deliver the substrate W to each other, the guard 57 does not interfere with the transport mechanism 12. When the transport mechanism 12 and the transport mechanism 51 deliver the substrate W to each other, the guard 57 does not overlap with the hand 18 of the transport mechanism 12 in plan view. When the transport mechanism 12 and the transport mechanism 51 deliver the substrate W to each other, the hand 18 of the transport mechanism 12 is located inward of the guard 57 in plan view. When the transport mechanism 12 and the transport mechanism 51 deliver the substrate W to each other, the hand 18 of the transport mechanism 12 is located between the guard 57a and the contact portion 56 and between the guard 57b and the contact portion 56 in plan view.

The transport mechanism 61 and the transport mechanism 51 deliver the substrate W to each other. The transport mechanism 61 and the transport mechanism 51 may deliver a plurality of substrates W to each other at a time.

For example, the transport mechanism 62 and the transport mechanism 51 deliver the substrate W to each other. The transport mechanism 62 and the transport mechanism 51 may deliver a plurality of substrates W to each other at a time.

When the transport mechanism 61 and the transport mechanism 51 deliver the substrate W to each other, a part of the transport mechanism 61 enters the slider portion 50. When the transport mechanism 61 and the transport mechanism 51 deliver the substrate W to each other, the support portion of the transport mechanism 61 enters the slider portion 50.

For example, when the transport mechanism 62 and the transport mechanism 51 deliver the substrate W to each other, a part of the transport mechanism 62 enters the slider portion 50. When the transport mechanism 62 and the transport mechanism 51 deliver the substrate W to each other, the support portion 16 of the transport mechanism 62 enters the slider portion 50.

When the transport mechanism 61 and the transport mechanism 51 deliver the substrate W to each other, the support portion 53 is located at a second position P2. The second position P2 is located in the slider portion 50.

For example, when the transport mechanism 62 and the transport mechanism 51 deliver the substrate W to each other, the support portion 53 is located at the second position P2. The second position P2 is located in the slider portion 50.

When the transport mechanism 61 and the transport mechanism 51 deliver the substrate W to each other, the support portion 53 stands still. When the transport mechanism 61 and the transport mechanism 51 deliver the substrate W to each other, the transport mechanism 61 moves. The substrate W is placed on the transport mechanism 61. The transport mechanism 61 takes a substrate W on the transport mechanism 51.

For example, when the transport mechanism 62 and the transport mechanism 51 deliver the substrate W to each other, the support portion 53 stands still. When the transport mechanism 62 and the transport mechanism 51 deliver the substrate W to each other, the transport mechanism 62 moves. The transport mechanism 62 places the substrate W on the transport mechanism 51. The transport mechanism 62 takes the substrate W on the transport mechanism 51.

When the transport mechanism 61 and the transport mechanism 51 deliver the substrate W to each other, the contact portion 56 does not interfere with the transport mechanism 61. When the transport mechanism 61 and the transport mechanism 51 deliver the substrate W to each other, the contact portion 56 does not overlap with the hand of the transport mechanism 61 in plan view. When the transport mechanism 61 and the transport mechanism 51 deliver the substrate W to each other, the hand of the transport mechanism 61 is located outward of the contact portion 56.

For example, when the transport mechanism 62 and the transport mechanism 51 deliver the substrate W to each other, the contact portion 56 does not interfere with the transport mechanism 62. When the transport mechanism 62 and the transport mechanism 51 deliver the substrate W to each other, the contact portion 56 does not overlap with the hand 18 of the transport mechanism 62 in plan view. When the transport mechanism 62 and the transport mechanism 51 deliver the substrate W to each other, the hand 18 of the transport mechanism 62 is located outward of the contact portion 56.

When the transport mechanism 61 and the transport mechanism 51 deliver the substrate W to each other, the guard 57 does not interfere with the transport mechanism 61. When the transport mechanism 61 and the transport mechanism 51 deliver the substrate W to each other, the guard 57 does not overlap with the hand of the transport mechanism 61 in plan view. When the transport mechanism 61 and the transport mechanism 51 deliver the substrate W to each other, the hand of the transport mechanism 61 is located inward of the guard 57. When the transport mechanism 61 and the transport mechanism 51 deliver the substrate W to each other, the hand of the transport mechanism 61 is located between the guard 57a and the contact portion 56 and between the guard 57b and the contact portion 56 in plan view.

For example, when the transport mechanism 62 and the transport mechanism 51 deliver the substrate W to each other, the guard 57 does not interfere with the transport mechanism 62. When the transport mechanism 62 and the transport mechanism 51 deliver the substrate W to each other, the guard 57 does not overlap with the hand 18 of the transport mechanism 62 in plan view. When the transport mechanism 62 and the transport mechanism 51 deliver the substrate W to each other, the hand 18 of the transport mechanism 62 is located inward of the guard 57. When the transport mechanism 62 and the transport mechanism 51 deliver the substrate W to each other, the hand 18 of the transport mechanism 62 is located between the guard 57a and the contact portion 56 and between the guard 57b and the contact portion 56 in plan view.

### <5. Cabinet portion 4>

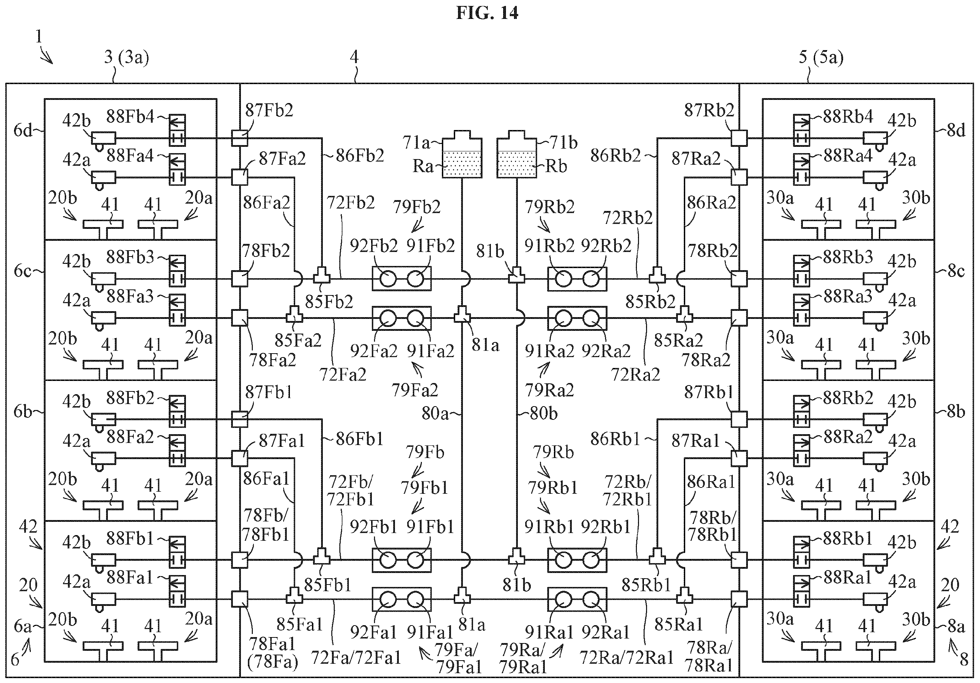

FIG. 14 is a piping diagram between the cabinet portion 4 and the chambers 6 and 8. FIG. 14 illustrates a configuration of the cabinet portion 4 and the chambers 6 and 8 simply. The cabinet portion 4 supplies the processing liquid Ra to the plurality of chambers 6. The cabinet portion 4 supplies the processing liquid Ra to the plurality of chambers 8.

The cabinet portion 4 includes a plurality of pipes 72Fa. The cabinet portion 4 includes a plurality of pipes 72Ra. The cabinet portion 4 includes a plurality of liquid feeders 79Fa. The cabinet portion 4 includes a plurality of liquid feeders 79Ra.

The cabinet portion 4 includes a processing liquid container 71b in addition to the processing liquid container 71a. The processing liquid container 71b stores a processing liquid Rb. For example, the processing liquid Ra has a composition different from that of the processing liquid Rb. The cabinet portion 4 supplies the processing liquid Rb to the plurality of chambers 6. The cabinet portion 4 supplies the processing liquid Rb to the plurality of chambers 8.

The cabinet portion 4 includes a plurality of pipes 72Fb. The cabinet portion 4 includes a plurality of pipes 72Rb. The cabinet portion 4 includes a plurality of joints 78Fb. The cabinet portion 4 includes a plurality of joints 78Rb. The cabinet portion 4 includes a plurality of liquid feeders 79Fb. The cabinet portion 4 includes a plurality of liquid feeders 79Rb.

Although not illustrated, the cabinet portion 4 may further supply the processing liquids Ra and Rb to the chamber 7. The cabinet portion 4 may supply the processing liquids Ra and Rb to the chamber 9.

The plurality of chambers 6 are referred to as chambers 6a, 6b, 6c, and 6d for convenience, in order to distinguish from one another. The plurality of chambers 8 are referred to as chambers 8a, 8b, 8c, and 8d for convenience, in order to distinguish from one another. The plurality of processing units 20 are referred to as processing units 20a and 20b for convenience, in order to distinguish from one another. The plurality of processing units 30 are referred to as processing units 30a and 30b for convenience, in order to distinguish from one another. The plurality of nozzles 42 are referred to as nozzles 42a and 42b for convenience, in order to distinguish from one another.

The plurality of pipes 72Fa are referred to as pipes 72Fa1 and 72Fa2, in order to distinguish from one another. The plurality of joints 78Fa are referred to as joints 78Fa1 and 78Fa2, in order to distinguish from one another. The plurality of liquid feeders 79Fa are referred to as liquid feeders 79Fa1 and 79Fa2, in order to distinguish from one another.

The plurality of pipes 72Ra are referred to as pipes 72Ra1 and 72Ra2, in order to distinguish from one another. The plurality of joints 78Ra are referred to as joints 78Ra1 and 78Ra2, in order to distinguish from one another. The plurality of liquid feeders 79Ra are referred to as liquid feeders 79Ra1 and 79Ra2, in order to distinguish from one another.

The plurality of pipes 72Fb are referred to as pipes 72Fb1 and 72Fb2, in order to distinguish from one another. The plurality of joints 78Fb are referred to as joints 78Fb1 and 78Fb2, in order to distinguish from one another. The plurality of liquid feeders 79Fb are referred to as liquid feeders 79Fb1 and 79Fb2, in order to distinguish from one another.

The plurality of pipes 72Rb are referred to as pipes 72Rb1 and 72Rb2, in order to distinguish from one another. The plurality of joints 78Rb are referred to as joints 78Rb1 and 78Rb2, in order to distinguish from one another. The plurality of liquid feeders 79Rb are referred to as liquid feeders 79Rb1 and 79Rb2, in order to distinguish from one another.

The liquid feeder 79Fa1 feeds the processing liquid Ra from the processing liquid container 71a to the nozzles 42a of the chambers 6a and 6b. The liquid feeder 79Fa2 feeds the processing liquid Ra from the processing liquid container 71a to the nozzles 42a of the chambers 6c and 6d. The liquid feeder 79Ra1 feeds the processing liquid Ra from the processing liquid container 71a to the nozzles 42a of the chambers 8a and 8b. The liquid feeder 79Ra2 feeds the processing liquid Ra from the processing liquid container 71a to the nozzles 42a of the chambers 8c and 8d. The nozzles 42a of the chambers 6 and 8 dispense the processing liquid Ra.

The liquid feeder 79Fb1 feeds the processing liquid Rb from the processing liquid container 71b to the nozzles 42b of the chambers 6a and 6b. The liquid feeder 79Fb2 feeds the processing liquid Rb from the processing liquid container 71b to the nozzles 42b of the chambers 6c and 6d. The liquid feeder 79Rb1 feeds the processing liquid Rb from the processing liquid container 71b to the nozzles 42b of the chambers 8a and 8b. The liquid feeder 79Rb2 feeds the processing liquid Rb from the processing liquid container 71b to the nozzles 42b of the chambers 8c and 8d. The nozzles 42b of the chambers 6 and 8 dispense the processing liquid Rb.

The processing liquid container 71a is an example of a first processing liquid container in the present invention. The processing liquid container 71b is an example of a second processing liquid container in the present invention. The liquid feeder 79Fa1 is an example of a first liquid feeder in the present invention. The liquid feeder 79Ra1 is an example of a second liquid feeder in the present invention. The liquid feeder 79Fa2 is an example of a third liquid feeder in the present invention. The chamber 6a is an example of a first chamber in the present invention. The chamber 8a is an example of a second chamber in the present invention. The chamber 6b is an example of a third chamber in the present invention.

The cabinet portion 4 will be described in more detail. The processing liquid container 71a is connected to the pipes 72Fa1, 72Fa2, 72Ra1, and 72Ra2. For example, the cabinet portion 4 includes a pipe 80a and a branch portion 81a. The pipe 80a is connected to the processing liquid container 71a. The branch portion 81a is provided on the pipe 80a. The branch portion 81a is connected to the pipes 72Fa1, 72Fa2, 72Ra1, and 72Ra2.

The processing liquid container 71b is connected to the pipes 72Fb1, 72Fb2, 72Rb1, and 72Rb2. For example, the cabinet portion 4 includes a pipe 80b and a branch portion 81b. The pipe 80b is connected to the processing liquid container 71b. The branch portion 81b is provided on the pipe 80b. The branch portion 81b is connected to the pipes 72Fb1, 72Fb2, 72Rb1, and 72Rb2.

A configuration between the processing liquid container 71a and the chambers 6a and 6b will be described. The pipe 72Fa1 is connected to the nozzle 42a of the chamber 6a. The liquid feeder 79Fa1 is provided on the pipe 72Fa1.

The liquid feeder 79Fa1 includes a pump 91Fa1. The pump 91Fa1 is provided on the pipe 72Fa1.

The liquid feeder 79Fa1 includes a pump 92Fa1. The pump 92Fa1 is provided on the pipe 72Fa1. The pump 92Fa1 is disposed downstream of the pump 91Fa1. The pipe 72Fa1 connects the pump 91Fa1 and the pump 92Fa1 in series.

The joint 78Fa1 is provided on the pipe 72Fa1. The joint 78Fa1 is disposed downstream of the liquid feeder 79Fa1.

The cabinet portion 4 includes a branch portion 85Fa1, a branch pipe 86Fa1, and a joint 87Fa1. The branch portion 85Fa1 is provided on the pipe 72Fa1. The branch portion 85Fa1 is disposed downstream of the liquid feeder 79Fa1 and upstream of the joint 78Fa1. The branch pipe 86Fa1 connects the branch portion 85Fa1 and the nozzle 42a of the chamber 6b. The joint 87Fa1 is provided on the branch pipe 86Fa1.

The chamber 6a includes a valve 88Fa1. The valve 88Fa1 is provided on the pipe 72Fa1. The valve 88Fa1 is disposed downstream of the joint 78Fa1.

The chamber 6b includes a valve 88Fa2. The valve 88Fa2 is provided on the branch pipe 86Fa1. The valve 88Fa2 is disposed downstream of the joint 87Fa1.

The pipe 72Fa1 is an example of a first pipe in the present invention. The pump 91Fa1 is an example of a first pump in the present invention. The pump 92Fa1 is an example of a second pump in the present invention.

A configuration between the processing liquid container 71a and the chambers 6c and 6d is identical to the configuration between the processing liquid container 71a and the chambers 6a and 6b. For example, the chamber 6c corresponds to the chamber 6a. The chamber 6d corresponds to the chamber 6b. The pipe 72Fa2 corresponds to the pipe 72Fa1. The joint 78Fa2 corresponds to the joint 78Fa1. The liquid feeder 79Fa2 corresponds to the liquid feeder 79Fa1. A branch portion 85Fa2 corresponds to the branch portion 85Fa1. A branch pipe 86Fa2 corresponds to the branch pipe 86Fa1. A joint 87Fa2 corresponds to the joint 87Fa1. A valve 88Fa3 corresponds to the valve 88Fa1. A valve 88Fa4 corresponds to the valve 88Fa2.

A configuration between the processing liquid container 71a and the chambers 8a and 8b will be described. The pipe 72Ra1 is connected to the nozzle 42a of the chamber 8a. The liquid feeder 79Ra1 is provided on the pipe 72Ra1.

The liquid feeder 79Ra1 includes a pump 91Ra1. The pump 91Ra1 is provided on the pipe 72Ra1.

The liquid feeder 79Ra1 includes a pump 92Ra1. The pump 92Ra1 is provided on the pipe 72Ra1. The pump 92Ra1 is disposed downstream of the pump 91Ra1. The pipe 72Ra1 connects the pump 91Ra1 and the pump 92Ra1 in series.

The joint 78Ra1 is provided on the pipe 72Ra1. The joint 78Ra1 is disposed downstream of the liquid feeder 79Ra1.

The cabinet portion 4 includes a branch portion 85Ra1, a branch pipe 86Ra1, and a joint 87Ra1. The branch portion 85Ra1 is provided on the pipe 72Ra1. The branch portion 85Ra1 is disposed downstream of the liquid feeder 79Ra1 and upstream of the joint 78Ra1. The branch pipe 86Ra1 connects the branch portion 85Ra1 and the nozzle 42a of the chamber 8b. The joint 87Ra1 is provided on the branch pipe 86Ra1.

The chamber 8a includes a valve 88Ra1. The valve 88Ra1 is provided on the pipe 72Ra1. The valve 88Ra1 is disposed downstream of the joint 78Ra1.

The chamber 8b includes a valve 88Ra2. The valve 88Ra2 is provided on the branch pipe 86Ra1. The valve 88Ra2 is disposed downstream of the joint 87Ra1.

The pipe 72Ra1 is an example of a second pipe in the present invention. The pump 91Ra1 is an example of a third pump in the present invention. The pump 92Ra1 is an example of a fourth pump in the present invention.

A configuration between the processing liquid container 71a and the chambers 8c and 8d is identical to a configuration between the processing liquid container 71a and the chambers 8a and 8b. For example, the pipe 72Ra2 corresponds to the pipe 72Ra1. The joint 78Ra2 corresponds to the joint 78Ra1. The liquid feeder 79Ra2 corresponds to the liquid feeder 79Ra1. A branch portion 85Ra2 corresponds to the branch portion 85Ra1. A branch pipe 86Ra2 corresponds to the branch pipe 86Ra1. A joint 87Ra2 corresponds to the joint 87Ra1. A valve 88Ra3 corresponds to the valve 88Ra1. A valve 88Ra4 corresponds to the valve 88Ra2.

A configuration between the processing liquid container 71b and the chambers 6a and 6b will be described. The pipe 72Fb1 is connected to the nozzle 42b of the chamber 6a. The liquid feeder 79Fb1 is provided on the pipe 72Fb1.

The liquid feeder 79Fb1 includes a pump 91Fb1. The pump 91Fb1 is provided on the pipe 72Fb1.

The liquid feeder 79Fb1 includes a pump 92Fb1. The pump 92Fb1 is provided on the pipe 72Fb1. The pump 92Fb1 is disposed downstream of the pump 91Fb1. The pipe 72Fb1 connects the pump 91Fb1 and the pump 92Fb1 in series.

The joint 78Fb1 is provided on the pipe 72Fb1. The joint 78Fb1 is disposed downstream of the liquid feeder 79Fb1.

The cabinet portion 4 includes a branch portion 85Fb1, a branch pipe 86Fb1, and a joint 87Fb1. The branch portion 85Fb1 is provided on the pipe 72Fb1. The branch portion 85Fb1 is disposed downstream of the liquid feeder 79Fb1 and upstream of the joint 78Fb 1. The branch pipe 86Fb1 connects the branch portion 85Fb1 and the nozzle 42b of the chamber 6b. The joint 87Fb1 is provided on the branch pipe 86Fb1.

The chamber 6a includes a valve 88Fb1. The valve 88Fb1 is provided on the pipe 72Fb1. The valve 88Fb1 is disposed downstream of the joint 78Fb1.

The chamber 6b includes a valve 88Fb2. The valve 88Fb2 is provided on the branch pipe 86Fb1. The valve 88Fb2 is disposed downstream of the joint 87Fb1.

The pipe 72Fb1 is an example of a third pipe in the present invention. The pump 91Fb1 is an example of a fifth pump in the present invention. The pump 92Fb1 is an example of a sixth pump in the present invention.

A configuration between the processing liquid container 71b and the chambers 6c and 6d is identical to the configuration between the processing liquid container 71b and the chambers 6a and 6b. For example, the pipe 72Fb2 corresponds to the pipe 72Fb1. The joint 78Fb2 corresponds to the joint 78Fb1. The liquid feeder 79Fb2 corresponds to the liquid feeder 79Fb1. A branch portion 85Fb2 corresponds to the branch portion 85Fb1. A branch pipe 86Fb2 corresponds to the branch pipe 86Fb1. A joint 87Fb2 corresponds to a joint 87Fb1. A valve 88Fb3 corresponds to the valve 88Fb1. A valve 88Fb4 corresponds to the valve 88Fb2.

A configuration between the processing liquid container 71b and the chambers 8a and 8b will be described. The pipe 72Rb1 is connected to the nozzle 42b of the chamber 8a. The liquid feeder 79Rb1 is provided on the pipe 72Rb1.

The liquid feeder 79Rb1 includes a pump 91Rb1. The pump 91Rb1 is provided on the pipe 72Rb1.

The liquid feeder 79Rb1 includes a pump 92Rb1. The pump 92Rb1 is provided on the pipe 72Rb1. The pump 92Rb1 is disposed downstream of the pump 91Rb1. The pipe 72Rb1 connects the pump 91Rb1 and the pump 92Rb1 in series.

The joint 78Rb1 is provided on the pipe 72Rb1. The joint 78Rb1 is disposed downstream of the liquid feeder 79Rb1.

The cabinet portion 4 includes a branch portion 85Rb1, a branch pipe 86Rb1, and a joint 87Rb1. The branch portion 85Rb1 is provided on the pipe 72Rb1. The branch portion 85Rb1 is disposed downstream of the liquid feeder 79Rb1 and upstream of the joint 78Rb 1. The branch pipe 86Rb1 connects the branch portion 85Rb1 and the nozzle 42b of the chamber 8b. The joint 87Rb1 is provided on the branch pipe 86Rb1.

The chamber 8a includes a valve 88Rb1. The valve 88Rb1 is provided on the pipe 72Rb1. The valve 88Rb1 is disposed downstream of the joint 78Rb1.

The chamber 8b includes a valve 88Rb2. The valve 88Rb2 is provided on the branch pipe 86Rb1. The valve 88Rb2 is disposed downstream of the joint 87Rb1.

A configuration between the processing liquid container 71b and the chambers 8c and 8d is identical to the configuration between the processing liquid container 71b and the chambers 8a and 8b. For example, the pipe 72Rb2 corresponds to the pipe 72Rb1. The joint 78Rb2 corresponds to the joint 78Rb1. The liquid feeder 79Rb2 corresponds to the liquid feeder 79Rb1. A branch portion 85Rb2 corresponds to the branch portion 85Rb1. A branch pipe 86Rb2 corresponds to the branch pipe 86Rb1. Aj oint 87Rb2 corresponds to the joint 87Rb1. A valve 88Rb3 corresponds to the valve 88Rb1. A valve 88Rb4 corresponds to the valve 88Rb2.

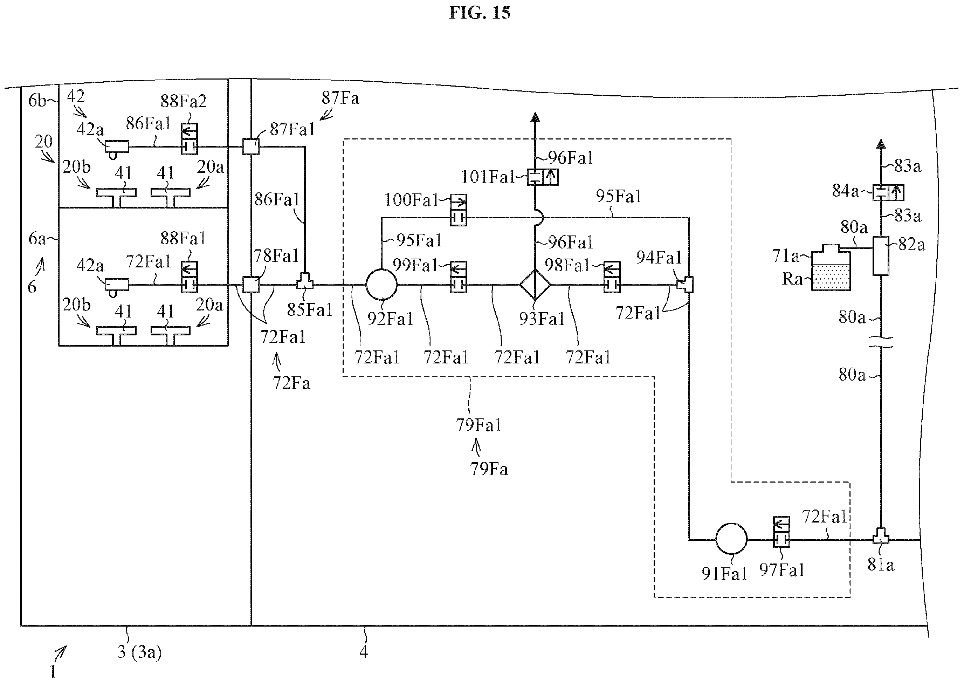

FIG. 15 is a detailed piping diagram between the cabinet portion 4 and the chamber 6. The cabinet portion 4 may include a trap tank 82a. The trap tank 82a temporarily stores the processing liquid Ra. The trap tank 82a collects bubbles in the processing liquid Ra. The trap tank 82a is configured to degas the processing liquid Ra.

Specifically, the trap tank 82a is provided on the pipe 80a. The processing liquid container 71a is connected to the pipe 72Fa1 via the trap tank 82a. Although not illustrated, the processing liquid container 71a is connected to the pipes 72Fa2, 72Ra1, and 72Ra2 via the trap tank 82a.

The cabinet portion 4 includes a discharge pipe 83a and a valve 84a. The discharge pipe 83a is connected to the trap tank 82a. The discharge pipe 83a communicates with a drainage facility (not illustrated). The valve 84a is provided on the discharge pipe 83a. When the valve 84a is opened, the discharge pipe 83a discharges gas and the processing liquid Ra from the trap tank 82a to the drainage facility.

Although not illustrated, the cabinet portion 4 may include a trap tank provided on the pipe 80b.

The liquid feeder 79Fa1 will be described. As described above, the liquid feeder 79Fa1 includes the pumps 91Fa1 and 92Fa1. Each of the pumps 91Fa1 and 92Fa1 is provided on the pipe 72Fa1. The pump 92Fa1 is disposed downstream of the pump 91Fa1.

The liquid feeder 79Fa1 includes a filter 93Fa1. The filter 93Fa1 is provided on the pipe 72Fa1. The filter 93Fa1 is disposed downstream of the pump 91Fa1 and upstream of the pump 92Fa1.

The liquid feeder 79Fa1 includes a branch portion 94Fa1 and a return pipe 95Fa1. The branch portion 94Fa1 is provided on the pipe 72Fa1. The branch portion 94Fa1 is disposed downstream of the pump 91Fa1 and upstream of the filter 93Fa1. The return pipe 95Fa1 connects the pump 92Fa1 and the branch portion 94Fa1. The return pipe 95Fa1 is different from the pipe 72Fa1.

The liquid feeder 79Fa1 includes a discharge pipe 96Fa1. The discharge pipe 96Fa1 is connected to the filter 93Fa1. The discharge pipe 96Fa1 communicates with a drainage facility (not illustrated).

The liquid feeder 79Fa1 includes valves 97Fa1, 98Fa1, and 99Fa1. Each of the valves 97Fa1, 98Fa1, and 99Fa1 is provided on the pipe 72Fa1. The valve 97Fa1 is disposed upstream of the pump 91Fa1. The valve 98Fa1 is disposed downstream of the branch portion 94Fa1 and upstream of the filter 93Fa1. The valve 99Fa1 is disposed downstream of the filter 93Fa1 and upstream of the pump 92Fa1.

The liquid feeder 79Fa1 includes a valve 100Fa1. The valve 100Fa1 is provided on the return pipe 95Fa1.

The liquid feeder 79Fa1 includes a valve 101Fa1. The valve 101Fa1 is provided on the discharge pipe 96Fa1.

Each of the pumps 91Fa1 and 92Fa1 is classified as, for example, a reciprocating pump. Each of the pumps 91Fa1 and 92Fa1 temporally performs suction and discharge alternately. Each of the pumps 91Fa1 and 92Fa1 is, for example, any of a diaphragm pump, a plunger pump, and a piston pump.

For example, the pump 91Fa1 has a pump chamber (not illustrated). The pump chamber of the pump 91Fa1 is connected to the pipe 72Fa1. The pump chamber of the pump 91Fa1 is filled with the processing liquid Ra. The pump 91Fa1 is configured to change a volume of the pumping chamber. When the pump 91Fa1 increases the volume of the pump chamber, the pump 91Fa1 suctions the processing liquid Ra. When the pump 91Fa1 suctions the processing liquid Ra, the processing liquid Ra enters the pump chamber of the pump 91Fa1 from the pipe 72Fa1. When the pump 91Fa1 reduces the volume of the pump chamber, the pump 91Fa1 discharges the processing liquid Ra. When the pump 91Fa1 discharges the processing liquid Ra, the processing liquid Ra exits from the pump chamber of the pump 91Fa1 to the pipe 72Fa1.

The pump 92Fa1 has, for example, the same structure as the pump 91Fa1.

An operation example of the liquid feeder 79Fa1 will be described.

The liquid feeder 79Fa1 executes a first step, a second step, and a third step.

In the first step, the pump 91Fa1 suctions the processing liquid Ra. Specifically, the valve 84a is closed. The valve 97Fa1 is opened. The valves 98Fa1 and 100Fa1 are closed. The pump 91Fa1 suctions the processing liquid Ra. The processing liquid Ra enters the pump 91Fa1 from the processing liquid container 71a through the pipe 72Fa1.

In the second step, the pump 92Fa1 suctions the processing liquid Ra. Specifically, the valve 97Fa1 is closed. The valves 98Fa1 and 99Fa1 are opened. The valves 100Fa1 and 101Fa1 are closed. The valves 88Fa1 and 88Fa2 are closed. The pump 91Fa1 discharges the processing liquid Ra. The pump 92Fa1 suctions the processing liquid Ra. The processing liquid Ra enters the pump 92Fa1 from the pump 91Fa1 through the pipe 72Fa1 and the filter 93Fa1. The filter 93Fa1 filters the processing liquid Ra. The filter 93Fa1 removes at least one of foreign matter or air bubbles from the processing liquid Ra.

In the third step, the pump 92Fa1 sends the processing liquid Ra to the nozzle 42a. Specifically, the valves 99Fa1 and 100Fa1 are closed. Either the valve 88Fa1 or the valve 88Fa2 is opened. The pump 92Fa1 discharges the processing liquid Ra. When the valve 88Fa1 is opened, the processing liquid Ra flows from the pump 92Fa1 to the nozzle 42a of the chamber 6a through the pipe 72Fa1. The nozzle 42a of the chamber 6a dispenses the processing liquid Ra. When the valve 88Fa2 is opened, the processing liquid Ra enters the nozzle 42a of the chamber 6b from the pump 92Fa1 through the branch pipe 86Fa1. The nozzle 42a of the chamber 6b dispenses the processing liquid Ra.

In the operation example described above, a period during which the third step is executed may overlap with a period during which the first step is executed. Alternatively, the period during which the third step is executed may not overlap with the period during which the first step is executed.

The liquid feeder 79Fa1 may further execute a fourth step. In the fourth step, the pump 92Fa1 returns the processing liquid Ra. Specifically, the valve 99Fa1 is closed. The valve 100Fa1 is opened. The valves 88Fa1 and 88Fa2 are closed. The pump 92Fa1 discharges the processing liquid Ra. The processing liquid Ra flows from the pump 92Fa1 to the return pipe 95Fa1. For example, in the fourth step, it is easy to adjust an amount of the processing liquid Ra in the pump 92Fa1. For example, in the fourth step, it is easy to adjust a pressure of the processing liquid Ra in the pump 92Fa1.

For example, the fourth step is performed after the second step and before the third step. Alternatively, the fourth step is performed after the third step and before the second step.

Although not illustrated, the liquid feeder 79Fa2 has the same structure as the liquid feeder 79Fa1. Each of the liquid feeders 79Ra1 and 79Ra2 has the same structure as the liquid feeder 79Fa1. Each of the liquid feeders 79Fb1, 79Fb2, 79Rb1, and 79Rb2 has the same structure as the liquid feeder 79Fa1.

Reference is made to FIG. 2. The controller 10 further controls the transport mechanism 12 of the indexer portion 2. The controller 10 controls the chamber 7 of the front block 3. The controller 10 controls the processing unit 25. The controller 10 controls the transport mechanisms 24 and 29. The controller 10 controls the chamber 9 of the rear block 5. The controller 10 controls the processing unit 35. The controller 10 controls the transport mechanisms 34 and 39. The controller 10 controls the slider portion 50. The controller 10 controls the transport mechanism 51. The controller 10 controls the bridge portion 60. The controller 10 controls the transport mechanism 61.

### <6. Disposition>

Reference is made to FIG. 8. For convenience, the plurality of carrier stages 11 are referred to as carrier stages 11a, 11b, 11c, and 11d in order to distinguish from one another. The carrier stage 11a is disposed on the first side of the transport mechanism 12 in the width direction Y. The carrier stage 11b is disposed on the second side of the transport mechanism 12 in the width direction Y. The carrier stage 11c is disposed on the first side of the transport mechanism 12 in the width direction Y. The carrier stage 11c is disposed upward of the carrier stage 11a in the vertical direction Z. The carrier stage 11d is disposed on the second side of the transport mechanism 12 in the width direction Y. The carrier stage 11d is disposed upward of the carrier stage 11b in the vertical direction Z.

Reference is made to FIG. 3. The carrier stage 11 and the transport mechanism 12 are arranged in the width direction Y. The carrier stage 11a, the transport mechanism 12, and the carrier stage 11b are arranged in this order in the width direction Y. The carrier stage 11a and the carrier stage 11b face each other.

The carrier stage 11 and the transport mechanism 12 are not arranged in the front-rear direction X. The carrier stage 11 is not disposed frontward of the transport mechanism 12 in the front-rear direction X.

Therefore, a length of the indexer portion 2 in the front-rear direction X is short.

FIG. 3 illustrates a length U. The length U is a length of the indexer portion 2 in the front-rear direction X. The length U is short.

The processing unit 21, the transport mechanism 24, and the chamber 6 are arranged in this order in the width direction Y. The processing unit 21, the transport mechanism 24, and the processing unit 20 are arranged in this order in the width direction Y. The processing unit 21 is disposed on the first side of the transport mechanism 24. The chamber 6 is disposed on the second side of the transport mechanism 24. The processing unit 20 is disposed on the second side of the transport mechanism 24.

The processing unit 22, the transport mechanism 24, and the placing portion 23 are arranged in this order in the front-rear direction X. The processing unit 22 is disposed frontward of the transport mechanism 24. The placing portion 23 is disposed rearward of the transport mechanism 24.

The cabinet portion 4 and the bridge portion 60 are arranged in the width direction Y. The bridge portion 60 is disposed on the first side of the cabinet portion 4.

The transport mechanism 62, the transport mechanism 63, and the placing portion 65 are arranged in a triangular shape in plan view. The transport mechanism 62, the transport mechanism 63, and the placing portion 65 are individually located at apexes of a virtual triangle (specifically, an acute-angle triangle) in plan view.

The transport mechanism 62 and the transport mechanism 63 are arranged in the width direction Y. The transport mechanism 63 is disposed on the first side of the transport mechanism 62.

The transport mechanism 62 and the placing portion 65 are arranged in the front-rear direction X. The placing portion 65 is disposed rearward of the transport mechanism 62.

The transport mechanism 63 and the placing portion 65 are arranged in the width direction Y. The placing portion 65 is disposed on the second side of the transport mechanism 63.

The processing unit 31, the transport mechanism 34, and the chamber 8 are arranged in this order in the width direction Y. The processing unit 31, the transport mechanism 34, and the processing unit 30 are arranged in this order in the width direction Y. The processing unit 31 is disposed on the first side of the transport mechanism 34. The chamber 8 is disposed on the second side of the transport mechanism 34. The processing unit 30 is disposed on the second side of the transport mechanism 34.

The placing portion 33, the transport mechanism 34, and the processing unit 32 are arranged in this order in the front-rear direction X. The placing portion 33 is disposed frontward of the transport mechanism 34. The processing unit 32 is disposed rearward of the transport mechanism 34.

The indexer portion 2, the front block 3, the cabinet portion 4, and the rear block 5 are arranged in this order in a front-rear direction X. The indexer portion 2, the front block 3, the cabinet portion 4, and the rear block 5 are arranged in a line.

The indexer portion 2, the first front portion 3a, the cabinet portion 4, and the first rear portion 5a are arranged in this order in the front-rear direction X. The indexer portion 2, the first front portion 3a, the cabinet portion 4, and the first rear portion 5a are arranged in a line.

The indexer portion 2, the front block 3, the bridge portion 60, and the rear block 5 are arranged in this order in the front-rear direction X. The indexer portion 2, the front block 3, the bridge portion 60, and the rear block 5 are arranged in a line.

The indexer portion 2, the first front portion 3a, the bridge portion 60, and the first rear portion 5a are arranged in this order in the front-rear direction X. The indexer portion 2, the first front portion 3a, the bridge portion 60, and the first rear portion 5a are arranged in a line.

The transport mechanism 12, the processing unit 22, the transport mechanism 24, the placing portion 23, the transport mechanism 62, the placing portion 65, the placing portion 33, the transport mechanism 34, and the processing unit 32 are arranged in this order in the front-rear direction X.

The carrier stage 11a, the processing unit 21, the transport mechanism 63, and the processing unit 31 are arranged in this order in the front-rear direction X.

The carrier stage 11b, the chamber 6, the cabinet portion 4, and the chamber 8 are arranged in this order in the front-rear direction X. The carrier stage 11b, the processing unit 20, the cabinet portion 4, and the processing unit 30 are arranged in this order in the front-rear direction X.

A length of the bridge portion 60 in the width direction Y is shorter than a length of the front block 3 in the width direction Y.

The length of the bridge portion 60 in the width direction Y is shorter than a length of the first front portion 3a in the width direction Y.

The length of the bridge portion 60 in the width direction Y is shorter than a length of the rear block 5 in the width direction Y.

The length of the bridge portion 60 in the width direction Y is shorter than a length of the first rear portion 5a in the width direction Y.

A total length of the bridge portion 60 and the cabinet portion 4 in the width direction Y is equal to the length of the front block 3 in the width direction Y.

The total length of the bridge portion 60 and the cabinet portion 4 in the width direction Y is equal to the length of the first front portion 3a in the width direction Y.

The total length of the bridge portion 60 and the cabinet portion 4 in the width direction Y is equal to the length of the rear block 5 in the width direction Y.

The total length of the bridge portion 60 and the cabinet portion 4 in the width direction Y is equal to the length of the first rear portion 5a in the width direction Y.

The length of the bridge portion 60 in the width direction Y is longer than a length of the cabinet portion 4 in the width direction Y.

The length of the bridge portion 60 in the front-rear direction X is equal to a length of the cabinet portion 4 in the front-rear direction X.

Reference is made to FIG. 4. The slider portion 50, the transport mechanism 24, and the chamber 6 are arranged in this order in the width direction Y. The slider portion 50, the transport mechanism 24, and the processing unit 20 are arranged in this order in the width direction Y. The slider portion 50 is disposed on the first side of the transport mechanism 24.

The indexer portion 2, the slider portion 50, the bridge portion 60, and the rear block 5 are arranged in this order in the front-rear direction X. The indexer portion 2, the slider portion 50, the bridge portion 60, and the rear block 5 are arranged in a line.

The indexer portion 2, the slider portion 50, the bridge portion 60, and the first rear portion 5a are arranged in this order in the front-rear direction X. The indexer portion 2, the slider portion 50, the bridge portion 60, and the first rear portion 5a are arranged in a line.

The carrier stage 11a, the slider portion 50, and the transport mechanism 63 are arranged in this order in the front-rear direction X.

The slider portion 50 is disposed rearward of the transport mechanism 12 and on the first side of the transport mechanism 12.

The slider portion 50 is disposed frontward of the transport mechanism 62 and on the first side of the transport mechanism 62.

The slider portion 50 is disposed frontward of the transport mechanism 63.

A length of the slider portion 50 in the width direction Y is shorter than the length of the bridge portion 60 in the width direction Y. Therefore, the length of the slider portion 50 in the width direction Y is shorter than the length of the front block 3 in the width direction Y. The length of the slider portion 50 in the width direction Y is shorter than the length of the rear block 5 in the width direction Y.

A length of the slider portion 50 in the width direction Y is shorter than the length of the bridge portion 60 in the width direction Y. Therefore, the length of the slider portion 50 in the width direction Y is shorter than the length of the first front portion 3a in the width direction Y. The length of the slider portion 50 in the width direction Y is shorter than the length of the first rear portion 5a in the width direction Y.

Reference is made to FIG. 5. The carrier stage 11c, the transport mechanism 12, and the carrier stage 11d are arranged in this order in the width direction Y. The carrier stage 11c and the carrier stage 11d face each other.

The processing unit 26, the transport mechanism 29, and the chamber 7 are arranged in this order in the width direction Y. The processing unit 26, the transport mechanism 29, and the processing unit 25 are arranged in this order in the width direction Y. The processing unit 26 is disposed on the first side of the transport mechanism 29 in the width direction Y. The chamber 7 is disposed on the second side of the transport mechanism 29 in the width direction Y. The processing unit 25 is disposed on the second side of the transport mechanism 29 in the width direction Y.

The processing unit 27, the transport mechanism 29, and the placing portion 28 are arranged in this order in the front-rear direction X. The processing unit 27 is disposed frontward of the transport mechanism 29. The placing portion 28 is disposed rearward of the transport mechanism 29.

The transport mechanism 62, the transport mechanism 64, and the placing portion 66 are arranged in a triangular shape in plan view. The transport mechanism 62, the transport mechanism 64, and the placing portion 66 are individually located at apexes of a virtual triangle (specifically, an acute-angle triangle) in plan view.

The transport mechanism 62 and the transport mechanism 64 are arranged in the width direction Y. The transport mechanism 64 is disposed on the first side of the transport mechanism 62.

The transport mechanism 62 and the placing portion 66 are arranged in the front-rear direction X. The placing portion 66 is disposed rearward of the transport mechanism 62.

The transport mechanism 64 and the placing portion 66 are arranged in the width direction Y. The placing portion 66 is disposed on the second side of the transport mechanism 64.

The processing unit 36, the transport mechanism 39, and the chamber 9 are arranged in this order in the width direction Y. The processing unit 36, the transport mechanism 39, and the processing unit 35 are arranged in this order in the width direction Y. The processing unit 36 is disposed on the first side of the transport mechanism 39. The chamber 9 is disposed on the second side of the transport mechanism 39. The processing unit 35 is disposed on the second side of the transport mechanism 39.

The placing portion 38, the transport mechanism 39, and the processing unit 37 are arranged in this order in the front-rear direction X. The placing portion 38 is disposed frontward of the transport mechanism 39. The processing unit 37 is disposed rearward of the transport mechanism 39.

The indexer portion 2, the second front portion 3b, the cabinet portion 4, and the second rear portion 5b are arranged in this order in the front-rear direction X. The indexer portion 2, the second front portion 3b, the cabinet portion 4, and the second rear portion 5b are arranged in a line.

The indexer portion 2, the second front portion 3b, the bridge portion 60, and the second rear portion 5b are arranged in this order in the front-rear direction X. The indexer portion 2, the second front portion 3b, the bridge portion 60, and the second rear portion 5b are arranged in a line.

The transport mechanism 12, the processing unit 27, the transport mechanism 29, the placing portion 28, the transport mechanism 62, the placing portion 66, the placing portion 38, the transport mechanism 39, and the processing unit 37 are arranged in this order in the front-rear direction X.

The carrier stage 11c, the processing unit 26, the transport mechanism 64, and the processing unit 36 are arranged in this order in the front-rear direction X.

The carrier stage 11d, the chamber 7, the cabinet portion 4, and the chamber 9 are arranged in this order in the front-rear direction X. The carrier stage 11d, the processing unit 25, the cabinet portion 4, and the processing unit 35 are arranged in this order in the front-rear direction X.

The length of the bridge portion 60 in the width direction Y is shorter than a length of the second front portion 3b in the width direction Y. The length of the bridge portion 60 in the width direction Y is shorter than a length of the second rear portion 5b in the width direction Y.

As described above, the length of the slider portion 50 in the width direction Y is shorter than the length of the bridge portion 60 in the width direction Y. Therefore, the length of the slider portion 50 in the width direction Y is shorter than the length of the second front portion 3b in the width direction Y. The length of the slider portion 50 in the width direction Y is shorter than the length of the second rear portion 5b in the width direction Y.

The total length of the bridge portion 60 and the cabinet portion 4 in the width direction Y is equal to the length of the second front portion 3b in the width direction Y. The total length of the bridge portion 60 and the cabinet portion 4 in the width direction Y is equal to the length of the second rear portion 5b in the width direction Y.

Reference is made to FIGS. 3 to 5. The carrier stage 11a and the carrier stage 11c overlap with each other in plan view. The carrier stage 11b and the carrier stage 11d overlap with each other in plan view.

The first front portion 3a and the second front portion 3b overlap with each other in plan view. Specifically, the chamber 6 and the chamber 7 overlap with each other in plan view. The processing unit 20 and the processing unit 25 overlap with each other in plan view. The processing unit 21 and the processing unit 26 overlap with each other in plan view. The processing unit 22 and the processing unit 27 overlap with each other in plan view. The placing portion 23 and the placing portion 28 overlap with each other in plan view. The transport mechanism 24 and the transport mechanism 29 overlap with each other in plan view.

Similarly, the first rear portion 5a and the second rear portion 5b overlap with each other in plan view.

The placing portion 65 and the placing portion 66 overlap with each other in plan view. The transport mechanism 63 and the transport mechanism 64 overlap with each other in plan view.

The slider portion 50 overlaps with the front block 3 in plan view.

The slider portion 50 overlaps with the first front portion 3a in plan view.

The slider portion 50 overlaps with the processing unit 21 in plan view. The entire slider portion 50 overlaps with the processing unit 21 in plan view.

The slider portion 50 does not overlap with the chamber 6 in plan view. The slider portion 50 does not overlap with the processing unit 20 in plan view. The slider portion 50 does not overlap with the processing unit 22 in plan view. The slider portion 50 does not overlap with the placing portion 23 in plan view. The slider portion 50 does not overlap with the transport mechanism 24 in plan view.

The slider portion 50 overlaps with the second front portion 3b in plan view.

The slider portion 50 overlaps with the processing unit 26 in plan view. The entire slider portion 50 overlaps with the processing unit 26 in plan view.

The slider portion 50 does not overlap with the chamber 7 in plan view. The slider portion 50 does not overlap with the processing unit 25 in plan view. The slider portion 50 does not overlap with the processing unit 27 in plan view. The slider portion 50 does not overlap with the placing portion 28 in plan view. The slider portion 50 does not overlap with the transport mechanism 29 in plan view.

The slider portion 50 does not overlap with the indexer portion 2 in plan view.

The slider portion 50 does not overlap with the bridge portion 60 in plan view.

The slider portion 50 does not overlap with the rear block 5 in plan view.

The slider portion 50 does not overlap with the first rear portion 5a in plan view. The slider portion 50 does not overlap with the chamber 8 in plan view. The slider portion 50 does not overlap with the processing unit 30 in plan view. The slider portion 50 does not overlap with the processing unit 31 in plan view. The slider portion 50 does not overlap with the processing unit 32 in plan view. The slider portion 50 does not overlap with the placing portion 33 in plan view. The slider portion 50 does not overlap with the transport mechanism 34 in plan view.

The slider portion 50 does not overlap with the second rear portion 5b in plan view. The slider portion 50 does not overlap with the chamber 9 in plan view. The slider portion 50 does not overlap with the processing unit 35 in plan view. The slider portion 50 does not overlap with the processing unit 36 in plan view. The slider portion 50 does not overlap with the processing unit 37 in plan view. The slider portion 50 does not overlap with the placing portion 38 in plan view. The slider portion 50 does not overlap with the transport mechanism 39 in plan view.

The indexer portion 2 does not overlap with the front block 3 in plan view. The indexer portion 2 does not overlap with the first front portion 3a in plan view. The indexer portion 2 does not overlap with the second front portion 3b in plan view. The indexer portion 2 does not overlap with the rear block 5 in plan view. The indexer portion 2 does not overlap with the first rear portion 5a in plan view. The indexer portion 2 does not overlap with the second rear portion 5b in plan view.

The indexer portion 2 does not overlap with the bridge portion 60 in plan view.

The bridge portion 60 does not overlap with the front block 3 in plan view. The bridge portion 60 does not overlap with the first front portion 3a in plan view. The bridge portion 60 does not overlap with the second front portion 3b in plan view. The bridge portion 60 does not overlap with the rear block 5 in plan view. The bridge portion 60 does not overlap with the first rear portion 5a in plan view. The bridge portion 60 does not overlap with the second rear portion 5b in plan view.

Reference is made to FIG. 13. When the transport mechanism 12 and the transport mechanism 51 deliver the substrate W to each other, the support portion 53 overlaps with the processing unit 21 in plan view.

When the support portion 53 is located at the first position P1, the support portion 53 overlaps with the processing unit 21 in plan view.

When the transport mechanism 62 and the transport mechanism 51 deliver the substrate W to each other, the support portion 53 overlaps with the processing unit 21 in plan view.

When the support portion 53 is located at the second position P2, the support portion 53 overlaps with the processing unit 21 in plan view.

The first position P1 and the second position P2 are arranged in the front-rear direction X. The second position P2 is disposed rearward of the first position P1.

The support portion 53 reciprocates between the first position P1 and the second position P2.

FIG. 13 illustrates a transport distance L. The transport distance L is a transport distance of the substrate W in the slider portion 50. The transport distance L is, for example, a distance between the first position P1 and the second position P2 in the front-rear direction X.

The transport distance L is relatively short.

FIG. 13 illustrates a distance K. The distance K is a distance between the indexer portion 2 and the bridge portion 60 in the front-rear direction X. The distance K corresponds to a distance of the front block 3 in the front-rear direction X. The distance K corresponds to a distance of the first front portion 3a in the front-rear direction X. The distance K corresponds to a distance of the second front portion 3b in the front-rear direction X. The transport distance L is shorter than the distance K.

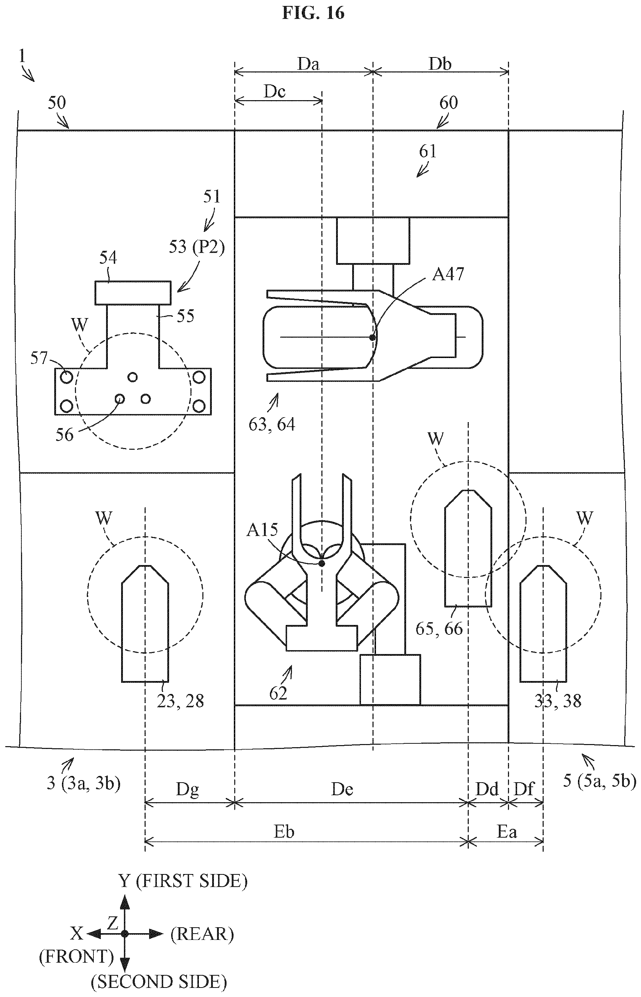

FIG. 16 is a detailed plan view of the bridge portion 60. The transport mechanism 63 is disposed at a center of the bridge portion 60 in the front-rear direction X. For example, the rotation axis A47 of the transport mechanism 63 is disposed at the center of the bridge portion 60 in the front-rear direction X.

FIG. 16 illustrates distances Da and Db. The distance Da is a distance between the transport mechanism 63 and the front block 3 in the front-rear direction X. The distance Db is a distance between the transport mechanism 63 and the rear block 5 in the front-rear direction X. The distance Da is equal to the distance Db.

The transport mechanism 62 is disposed frontward of the transport mechanism 63. For example, the rotation axis A15 of the transport mechanism 62 is disposed frontward of the rotation axis A47 of the transport mechanism 63.

The transport mechanism 62 is closer to the slider portion 50 than the center of the bridge portion 60 in the front-rear direction X. The transport mechanism 62 is closer to the slider portion 50 than the transport mechanism 63 in the front-rear direction X.

FIG. 16 illustrates a distance Dc. The distance Dc is a distance between the transport mechanism 62 and the slider portion 50 in the front-rear direction X. The distance Da corresponds to a distance between the center of the bridge portion 60 and the slider portion 50 in the front-rear direction X. The distance Da corresponds to a distance between the transport mechanism 63 and the slider portion 50 in the front-rear direction X. The distance Dc is shorter than the distance Da.

The placing portion 65 is disposed rearward of the transport mechanism 63. For example, the placing portion 65 is disposed rearward of the rotation axis A47 of the transport mechanism 63. The placing portion 65 is closer to the rear block 5 than the center of the bridge portion 60 in the front-rear direction X.

FIG. 16 illustrates a distance Dd. The distance Dd is a distance between the placing portion 65 and the rear block 5 in the front-rear direction X. The distance Db corresponds to a distance between the center of the bridge portion 60 and the rear block 5 in the front-rear direction X. The distance Dd is shorter than the distance Db.

The placing portion 65 is close to the rear block 5. The substrate W placed on the placing portion 65 overlaps with the rear block 5 in plan view. A part of the substrate W placed on the placing portion 65 overlaps with the rear block 5 in plan view. The placing portion 65 does not overlap with the rear block 5 in plan view.

The distance Dd is shorter than a radius of the substrate W.

The placing portion 65 is closer to the rear block 5 than the front block 3 in the front-rear direction X.

FIG. 16 illustrates a distance De. The distance De is a distance between the placing portion 65 and the front block 3 in the front-rear direction X. The distance Dd is shorter than the distance De.

The placing portion 33 is close to the bridge portion 60. The substrate W placed on the placing portion 33 overlaps with the bridge portion 60 in plan view. A part of the substrate W placed on the placing portion 33 overlaps with the bridge portion 60 in plan view. The placing portion 33 does not overlap with the bridge portion 60 in plan view.

FIG. 16 illustrates a distance Df. The distance Df is a distance between the placing portion 33 and the bridge portion 60 in the front-rear direction X. The distance Df is shorter than the radius of the substrate W.

The placing portion 33 is closer to the bridge portion 60 than the placing portion 23.

FIG. 16 illustrates a distance Dg. The distance Dg is a distance between the placing portion 23 and the bridge portion 60 in the front-rear direction X. The distance Df is shorter than the distance Dg.

The substrate W placed on the placing portion 23 does not overlap with the bridge portion 60 in plan view. The placing portion 23 does not overlap with the bridge portion 60 in plan view. The distance Dg is longer than the radius of the substrate W.

The placing portion 65 is close to the placing portion 33. The substrate W placed on the placing portion 65 overlaps with the substrate W placed on the placing portion 33 in plan view. A part of the substrate W placed on the placing portion 65 overlaps with a part of the substrate W placed on the placing portion 33 in plan view.

FIG. 16 illustrates a distance Ea. The distance Ea is a distance between the placing portion 65 and the placing portion 33 in the front-rear direction X. The distance Ea is shorter than a diameter of the substrate W.

The placing portion 65 is closer to the placing portion 33 than the placing portion 23. The substrate W placed on the placing portion 65 does not overlap with the substrate W placed on the placing portion 23 in plan view.

FIG. 16 illustrates a distance Eb. The distance Eb is a distance between the placing portion 65 and the placing portion 23 in the front-rear direction X. The distance Ea is shorter than the distance Eb. The distance Eb is longer than a diameter of the substrate W.

The substrate W placed on the placing portion 23 does not overlap with the substrate W placed on the placing portion 33 in plan view.

The transport mechanism 64 is disposed at the same position as the transport mechanism 63 in plan view. The placing portion 66 is disposed at the same position as the placing portion 65 in plan view. The placing portion 28 is disposed at the same position as the placing portion 23 in plan view. The placing portion 38 is disposed at the same position as the placing portion 33 in plan view.

Reference is made to FIG. 6. The first front portion 3a and the second front portion 3b are arranged in the vertical direction Z. The second front portion 3b is disposed upward of the first front portion 3a.

The processing units 21 and 26 are arranged in the vertical direction Z. The processing unit 26 is disposed upward of the processing unit 21.

The plurality of processing units 21 are arranged in the front-rear direction X and the vertical direction Z. The plurality of processing units 26 are arranged in the front-rear direction X and the vertical direction Z.

The slider portion 50 is provided so as to penetrate the front block 3.

The first front portion 3a, the slider portion 50, and the second front portion 3b are arranged in this order in the vertical direction Z. The slider portion 50 is disposed upward of the first front portion 3a. The slider portion 50 is disposed downward of the second front portion 3b. The slider portion 50 is disposed between the first front portion 3a and the second front portion 3b.

The processing unit 21, the slider portion 50, and the processing unit 26 are arranged in this order in the vertical direction Z. The processing unit 21 is disposed downward of the slider portion 50. The processing unit 26 is disposed upward of the slider portion 50. The slider portion 50 is disposed between the processing unit 21 and the processing unit 26.

The transport mechanisms 63 and 64 are arranged in the vertical direction Z. The transport mechanism 64 is disposed upward of the transport mechanism 63.

The transport mechanism 63 is disposed at a height position same as a height position of the first front portion 3a. The transport mechanism 63 is disposed at a height position same as a height position of the first rear portion 5a.

The transport mechanism 64 is disposed at a height position same as a height position of the second front portion 3b. The transport mechanism 64 is disposed at a height position same as a height position of the second rear portion 5b.

The first rear portion 5a and the second rear portion 5b are arranged in the vertical direction Z. The second rear portion 5b is disposed upward of the first rear portion 5a.

The processing units 31 and 36 are arranged in the vertical direction Z. The processing unit 36 is disposed upward of the processing unit 31.

The plurality of processing units 31 are arranged in the front-rear direction X and the vertical direction Z. The plurality of processing units 36 are arranged in the front-rear direction X and the vertical direction Z.

At least one processing unit 21 is in contact with the bridge portion 60. For example, the adhesion reinforcing processing unit PAHP in the processing units 21 is in contact with the bridge portion 60.

At least one processing unit 21 is adjacent to the transport mechanism 63. For example, the adhesion reinforcing processing unit PAHP in the processing units 21 is adjacent to the transport mechanism 63.

At least one processing unit 31 is in contact with the bridge portion 60. For example, the adhesion reinforcing processing unit PAHP in the processing units 31 is in contact with the bridge portion 60.

At least one processing unit 31 is adjacent to the transport mechanism 63. For example, the adhesion reinforcing processing unit PAHP in the processing units 31 is adjacent to the transport mechanism 63.

At least one processing unit 26 is in contact with the bridge portion 60. For example, the adhesion reinforcing processing unit PAHP in the processing units 26 is in contact with the bridge portion 60.

At least one processing unit 26 is adjacent to the transport mechanism 64. For example, the adhesion reinforcing processing unit PAHP in the processing units 26 is adjacent to the transport mechanism 64.

At least one processing unit 36 is in contact with the bridge portion 60. For example, the adhesion reinforcing processing unit PAHP in the processing units 36 is in contact with the bridge portion 60.

At least one processing unit 36 is adjacent to the transport mechanism 64. For example, the adhesion reinforcing processing unit PAHP in the processing units 36 is adjacent to the transport mechanism 64.

Reference is made to FIG. 7. The chambers 6 and 7 are arranged in the vertical direction Z. The chamber 7 is disposed upward of the chamber 6.

The plurality of chambers 6 are arranged in the vertical direction Z. For example, the chamber 6b is disposed upward of the chamber 6a. The chamber 6c is disposed upward of the chamber 6b. The chamber 6d is disposed upward of the chamber 6c. Similarly, the plurality of chambers 7 are arranged in the vertical direction Z.

The processing units 20 and 25 are arranged in the vertical direction Z. The processing unit 25 is disposed upward of the processing unit 20.

The plurality of processing units 20 are arranged in the front-rear direction X and the vertical direction Z. The plurality of processing units 25 are arranged in the front-rear direction X and the vertical direction Z.

The chambers 8 and 9 are arranged in the vertical direction Z. The chamber 9 is disposed upward of the chamber 8.

The plurality of chambers 8 are arranged in the vertical direction Z. For example, the chamber 8b is disposed upward of the chamber 8a. The chamber 8c is disposed upward of the chamber 8b. The chamber 8d is disposed upward of the chamber 8c. Similarly, the plurality of chambers 9 are arranged in the vertical direction Z.

The processing units 30 and 35 are arranged in the vertical direction Z. The processing unit 35 is disposed upward of the processing unit 30.

The plurality of processing units 30 are arranged in the front-rear direction X and the vertical direction Z. The plurality of processing units 35 are arranged in the front-rear direction X and the vertical direction Z.

The chamber 8 is disposed at a height position same as a height position of the chamber 6. For example, the chamber 8a is disposed at a height position same as a height position of the chamber 6a. The chamber 8b is disposed at a height position same as a height position of the chamber 6b.

The processing unit 30 is disposed at a height position same as a height position of the processing unit 20.

The chamber 9 is disposed at a height position same as a height position of the chamber 7.

The processing unit 35 is disposed at a height position same as a height position of the processing unit 25.

The chamber 6 is adjacent to the cabinet portion 4.

The chamber 7 is adjacent to the cabinet portion 4.

The chamber 8 is adjacent to the cabinet portion 4.

The chamber 9 is adjacent to the cabinet portion 4.

At least one processing unit 20 is adjacent to the cabinet portion 4.

At least one processing unit 25 is adjacent to the cabinet portion 4.

At least one processing unit 30 is adjacent to the cabinet portion 4.

At least one processing unit 35 is adjacent to the cabinet portion 4.

Reference is made to FIG. 8. In FIG. 8, the slider portion 50 is indicated by a broken line for convenience. In front view, the slider portion 50 is disposed on the first side of the transport mechanism 12. In front view, the slider portion 50 does not overlap with the rotation portion 15 of the transport mechanism 12. In front view, the slider portion 50 does not overlap with the rotation axis A15 of the transport mechanism 12.

In front view, the carrier stage 11a, the slider portion 50, and the carrier stage 11c are arranged in this order in the vertical direction Z. In front view, the carrier stage 11a is disposed downward of the slider portion 50. In front view, the carrier stage 11c is disposed upward of the slider portion 50. In front view, the slider portion 50 is disposed between the carrier stage 11a and the carrier stage 11c. In front view, the slider portion 50 does not overlap with the carrier stage 11.

Reference is made to FIG. 9. The movable elements 54a and 54b are arranged in the vertical direction Z. The movable element 54b is disposed upward of the movable element 54a.

The transport mechanisms 24 and 29 are arranged in the vertical direction Z. The transport mechanism 29 is disposed upward of the transport mechanism 24.

The transport mechanism 24 is configured to move to a height position same as a height position of the slider portion 50.

For example, the slider portion 50 includes a lower portion 50a. The movable element 54a is disposed in the lower portion 50a. The transport mechanism 24 is configured to move to a height position same as a height position of the lower portion 50a.

The processing unit 21 and the slider portion 50 are arranged in the vertical direction Z.

The plurality of processing units 20 are arranged in the vertical direction Z. At least one of the processing units 20 is disposed at a height position same as a height position of the slider portion 50.

The processing unit 20 includes a processing unit 20H. The processing unit 20H is disposed at the highest position among the plurality of processing units 20. The processing unit 20H is disposed at a height position same as a height position of the lower portion 50a. Therefore, the number of the processing units 20 is relatively large.

As described above, the transport mechanism 24 is configured to move to a height position same as a height position of the slider portion 50. Therefore, it is easy for the transport mechanism 24 to transport the substrate W to the processing unit 20H.

The transport mechanism 29 is configured to move to a height position same as a height position of the slider portion 50.

For example, the slider portion 50 includes an upper portion 50b. The upper portion 50b is located upward of the lower portion 50a. The movable element 54b is disposed in the upper portion 50b. The transport mechanism 29 is configured to move to a height position same as a height position of the upper portion 50b.

The processing unit 26 and the slider portion 50 are arranged in the vertical direction Z.

The plurality of processing units 25 are arranged in the vertical direction Z. At least one of the processing units 25 is disposed at a height position same as a height position of the slider portion 50.

The processing unit 25 includes a processing unit 25L. The processing unit 25L is disposed at the lowest position among the plurality of processing units 25. The processing unit 25L is disposed at a height position same as a height position of the upper portion 50b. Therefore, the number of the processing units 25 is relatively large.

As described above, the transport mechanism 29 is configured to move to a height position same as a height position of the slider portion 50. Therefore, it is easy for the transport mechanism 29 to transport the substrate W to the processing unit 25L.

The placing portions 23 and 28 are arranged in the vertical direction Z. The placing portion 28 is disposed upward of the placing portion 23.

The placing portion 23 is disposed downward of the slider portion 50. The placing portion 28 is disposed upward of the slider portion 50.

Although not illustrated, the processing units 22 and 27 are arranged in the vertical direction Z. The processing unit 27 is disposed upward of the processing unit 22.

Reference is made to FIG. 10. The placing portions 65 and 66 are arranged in the vertical direction Z. The placing portion 66 is disposed upward of the placing portion 65.

In FIG. 10, the slider portion 50 is indicated by a broken line for convenience. The placing portion 65 is disposed downward of the slider portion 50. The placing portion 66 is disposed upward of the slider portion 50.

In FIG. 10, the placing portions 23 and 28 are indicated by broken lines for convenience. The placing portion 65 is disposed upward of the placing portion 23. The placing portion 65 is disposed downward of the placing portion 28.

The placing portion 66 is disposed upward of the placing portion 28.

In FIG. 10, the placing portions 33 and 38 are indicated by broken lines for convenience. The placing portion 33 is disposed at a height position same as a height position of the placing portion 23. The placing portion 33 overlaps with the placing portion 23 in front view. The placing portion 38 is disposed at a height position same as a height position of the placing portion 28. The placing portion 38 overlaps with the placing portion 38 in front view.

The placing portion 65 is disposed upward of the placing portion 33. The placing portion 65 is disposed downward of the placing portion 38.

The placing portion 66 is disposed upward of the placing portion 38.

Reference is made to FIG. 11. The transport mechanisms 34 and 39 are arranged in the vertical direction Z. The transport mechanism 39 is disposed upward of the transport mechanism 34.

The placing portions 33 and 38 are arranged in the vertical direction Z. The placing portion 38 is disposed upward of the placing portion 33.

Although not illustrated, the processing units 32 and 37 are arranged in the vertical direction Z. The processing unit 37 is disposed upward of the processing unit 32.

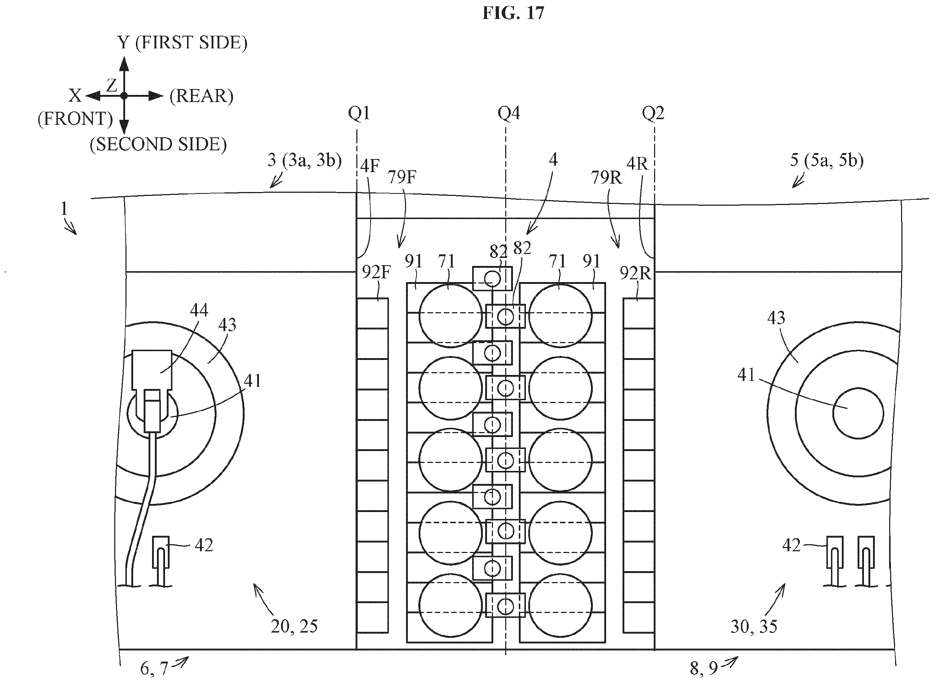

FIG. 17 is a detailed plan view of the cabinet portion 4. The processing liquid containers 71a and 71b are simply referred to as "processing liquid containers 71" when not distinguished from one another. The processing liquid containers 71 are disposed at a center of the cabinet portion 4 in the front-rear direction X.

FIG. 17 illustrates a center Q4. The center Q4 passes through a center of the cabinet portion 4 in the front-rear direction X. The center Q4 is a virtual plane perpendicular to the front-rear direction X. The processing liquid containers 71 are disposed at the center Q4 in the front-rear direction X. The processing liquid containers 71 are disposed in the vicinity of the center Q4 in the front-rear direction X. Some processing liquid containers 71 are disposed frontward of the center Q4. Other processing liquid containers 71 are disposed rearward of the center Q4.

The plurality of processing liquid containers 71 are arranged in the front-rear direction X and the width direction Y.

The trap tanks 82a and 82b are simply referred to as "trap tanks 82" when not distinguished from one another. The plurality of trap tanks 82 are arranged in the width direction Y.

The trap tanks 82 are disposed at the center Q4 in the front-rear direction X.

Some processing liquid containers 71 are disposed frontward of the trap tank 82. Other processing liquid containers 71 are disposed rearward of the trap tank 82.

The pumps 91Fa1, 91Fa2, 91Fb1, 91Fb2, 91Ra1, 91Ra2, 91Rb1, and 91Rb2 described above are simply referred to as "pumps 91" when not distinguished from one another. The pumps 91 are examples of a first pump, a third pump, and a fifth pump of the present invention.

The plurality of pumps 91 are arranged in the front-rear direction X and the width direction Y.

The pump 91 overlaps with the processing liquid container 71 in plan view.

The pump 91 overlaps with the trap tank 82 in plan view.

The pumps 92Fa1, 92Fa2, 92Fb1, and 92Fb2 are simply referred to as "pumps 92F" when not distinguished from one another. The pumps 92F are examples of a second pump and a sixth pump of the present invention.

The plurality of pumps 92F are arranged in the width direction Y. For example, the pump 92Fa1 and the pump 92Fb1 are arranged in the width direction Y. For example, the pump 92Fa2 and the pump 92Fb2 are arranged in the width direction Y.

The pump 92F is closer to the front block 3 than the center Q4 in the front-rear direction X. Specifically, a distance between the pump 92F and the front block 3 in the front-rear direction X is shorter than a distance between the center Q4 and the front block 3 in the front-rear direction X.

The pump 92F is closer to the front block 3 than the processing liquid container 71 in the front-rear direction X. Specifically, a distance between the pump 92F and the front block 3 in the front-rear direction X is shorter than a distance between the processing liquid container 71 and the front block 3 in the front-rear direction X.

The pump 92F and the processing liquid container 71 are arranged in the front-rear direction X. The pump 92F is disposed frontward of the processing liquid container 71.

The pump 92F does not overlap with the processing liquid container 71 in plan view.

The pump 92F is closer to the front block 3 than the trap tank 82 in the front-rear direction X. Specifically, a distance between the pump 92F and the front block 3 in the front-rear direction X is shorter than a distance between the trap tank 82 and the front block 3 in the front-rear direction X.

The pump 92F and the trap tank 82 are arranged in the front-rear direction X. The pump 92F is disposed frontward of the trap tank 82.

The pump 92F does not overlap with the trap tank 82 in plan view.

The pump 92F is closer to the front block 3 than the pump 91 in the front-rear direction X. Specifically, a distance between the pump 92F and the front block 3 in the front-rear direction X is shorter than a distance between the pump 91 and the front block 3 in the front-rear direction X.

The pump 92F and the pump 91 are arranged in the front-rear direction X. The pump 92F is disposed frontward of the pump 91.

The pump 92F does not overlap with the pump 91 in plan view.

The pump 92F is close to the boundary Q1.

The cabinet portion 4 includes a partition wall 4F. The partition wall 4F is disposed between the cabinet portion 4 and the front block 3. For example, the partition wall 4F is disposed on the boundary Q1. The partition wall 4F partitions between the cabinet portion 4 and the front block 3. The partition wall 4F extends in the width direction Y and the vertical direction Z.

The pump 92F is attached to the partition wall 4F.

The pumps 92Ra1, 92Ra2, 92Rb1, and 92Rb2 are simply referred to as "pumps 92R" when not distinguished from one another. The pump 92R is an example of a fourth pump of the present invention.

The plurality of pumps 92R are arranged in the width direction Y. For example, the pump 92Ra1 and the pump 92Rb1 are arranged in the width direction Y. For example, the pump 92Ra2 and the pump 92Rb2 are arranged in the width direction Y.

The pump 92R is closer to the rear block 5 than the center Q4 of the cabinet portion 4 in the front-rear direction X. Specifically, a distance between the pump 92R and the rear block 5 in the front-rear direction X is shorter than a distance between the center Q4 of the cabinet portion 4 and the rear block 5 in the front-rear direction X.

The pump 92R is closer to the rear block 5 than the processing liquid container 71 in the front-rear direction X. Specifically, a distance between the pump 92R and the rear block 5 in the front-rear direction X is shorter than a distance between the processing liquid container 71 and the rear block 5 in the front-rear direction X.

The pump 92R and the processing liquid container 71 are arranged in the front-rear direction X. The pump 92R is disposed rearward of the processing liquid container 71.

The pump 92R does not overlap with the processing liquid container 71 in plan view.

The pump 92R is closer to the rear block 5 than the trap tank 82 in the front-rear direction X. Specifically, a distance between the pump 92R and the rear block 5 in the front-rear direction X is shorter than a distance between the trap tank 82 and the rear block 5 in the front-rear direction X.

The pump 92R and the trap tank 82 are arranged in the front-rear direction X. The pump 92R is disposed rearward of the trap tank 82.

The pump 92R does not overlap with the trap tank 82 in plan view.

The pump 92R is closer to the rear block 5 than the pump 91 in the front-rear direction X. Specifically, a distance between the pump 92R and the rear block 5 in the front-rear direction X is shorter than a distance between the pump 91 and the rear block 5 in the front-rear direction X.

The pump 92R and the pump 91 are arranged in the front-rear direction X. The pump 92R is disposed rearward of the pump 91.

The pump 92R does not overlap with the pump 91 in plan view.

The pump 92R and the pump 92F are arranged in the front-rear direction X. The pump 92R is disposed rearward of the pump 92F.

The pump 92R does not overlap with the pump 92F in plan view.

The pump 92R is close to the boundary Q2.

The cabinet portion 4 includes a partition wall 4R. The partition wall 4R is disposed between the cabinet portion 4 and the rear block 5. For example, the partition wall 4R is disposed on the boundary Q2. The partition wall 4R partitions between the cabinet portion 4 and the rear block 5. The partition wall 4R extends in the width direction Y and the vertical direction Z.

The pump 92R is attached to the partition wall 4R.

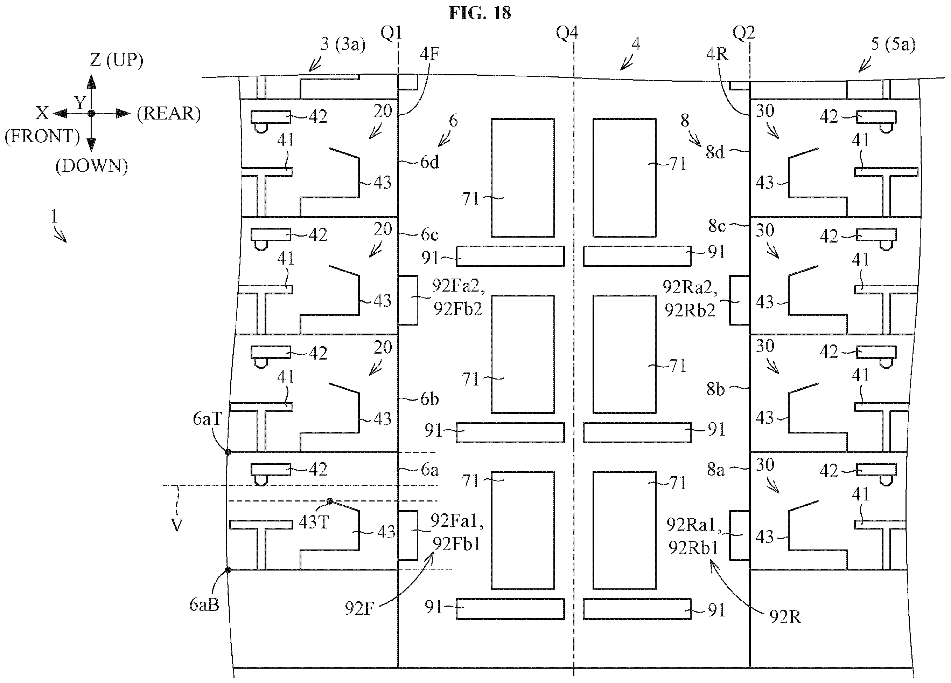

FIG. 18 is a detailed side view of the cabinet portion 4. The processing liquid container 71 is disposed at a height position same as a height position of the chamber 6. The processing liquid container 71 is disposed at a height position same as a height position of the chamber 8.

Although not illustrated, the trap tank 82 is disposed at a height position same as a height position of the processing liquid container 71. The trap tank 82 is disposed at a height position same as a height position of the chambers 6 and 8.

The plurality of processing liquid containers 71 are further arranged in the vertical direction Z.

The pump 91 is disposed at a height position same as a height position of the chamber 6. The pump 91 is disposed at a height position same as a height position of the chamber 8.

The plurality of pumps 91 are further arranged in the vertical direction Z.

The processing liquid container 71 and the pump 91 are arranged in the vertical direction Z. The pump 91 is disposed at a position lower than the processing liquid container 71. The pump 91 is disposed downward of the processing liquid container 71.

For example, the pumps 91Fa1, 91Fa2, 91Ra1, and 91Ra2 are disposed downward of the processing liquid container 71a. The pumps 91Fa1, 91Fa2, 91Ra1, and 91Ra2 communicate with the processing liquid container 71a. The pumps 91Fa1, 91Fa2, 91Ra1, and 91Ra2 are disposed at mutually the same height position.

For example, the pumps 91Fb1, 91Fb2, 91Rb1, and 91Rb2 are disposed downward of the processing liquid container 71b. The pumps 91Fb1, 91Fb2, 91Rb1, and 91Rb2 communicate with the processing liquid container 71b. The pumps 91Fb1, 91Fb2, 91Rb1, and 91Rb2 are disposed at mutually the same height position.

More specifically, the processing liquid containers 71 and the pumps 91 are alternately arranged in the vertical direction Z. For example, when the processing liquid container 71b is disposed downward of the processing liquid container 71a, the processing liquid container 71b is disposed downward of the pumps 91Fa1, 91Fa2, 91Ra1, and 91Ra2.

The plurality of pumps 92F are further arranged in the vertical direction Z.

The pump 92F is disposed at a height position same as a height position of the chamber 6.

For example, the pump 92Fa1 is disposed at a height position same as a height position of the chamber 6a. At least a part of the pump 92Fa1 is disposed at a height position same as a height position of at least a part of the chamber 6a. The pump 92Fa1 communicates with the chamber 6a.

The pump 92Fb1 is also disposed at a height position same as a height position of the chamber 6a. The pump 92Fb1 also communicates with the chamber 6a.

The pump 92Fb1 is disposed at a height position same as a height position of the pump 92Fa1.

For example, the pump 92Fa2 is disposed at a height position same as a height position of the chamber 6c. The pump 92Fa2 communicates with the chamber 6c.

The pump 92Fa2 is disposed upward of the pump 92Fa1. The pump 92Fa2 is disposed upward of the pump 92Fb1.

The pump 92Fb2 is also disposed at a height position same as a height position of the chamber 6c. The pump 92Fb2 also communicates with the chamber 6c.

The pump 92Fb2 is disposed at a height position same as a height position of the pump 92Fa2. The pump 92Fb2 is disposed upward of the pump 92Fa1. The pump 92Fb2 is disposed upward of the pump 92Fb1.

The height position of the pump 92Fa1 will be described in detail.

The chamber 6a has a lower end 6aB. At least a part of the pump 92Fa1 is disposed at a position higher than the lower end 6aB. For example, the entire pump 92Fa1 is disposed at a position higher than the lower end 6aB.

The chamber 6a has an upper end 6aT. At least a part of the pump 92Fa1 is disposed at a position lower than the upper end 6aT. For example, the entire pump 92Fa1 is disposed at a position lower than the upper end 6aT.

The pump 92Fa1 is disposed at a position lower than the chamber 6b. The entire pump 92Fa1 is disposed at a position lower than the entire chamber 6b.

At least a part of the pump 92Fa1 is disposed at a position lower than the nozzle 42 of the chamber 6a. For example, the entire pump 92Fa1 is disposed at a position lower than the nozzle 42 of the chamber 6a.

Although not illustrated, the nozzle 42 has an dispensing port for dispensing the processing liquid. At least a part of the pump 92Fa1 is disposed at a position lower than the dispensing port of the nozzle 42 of the chamber 6a. For example, the entire pump 92Fa1 is disposed at a position lower than the dispensing port of the nozzle 42 of the chamber 6a.

FIG. 18 illustrates a height position V. The height position V indicates a height position of the dispensing port of the nozzle 42 of the chamber 6a. At least a part of the pump 92Fa1 is lower than the height position V.

The pump 92Fa1 is disposed at a height position same as a height position of the cup 43 of the chamber 6a. At least a part of the pump 92Fa1 is disposed at a height position same as a height position of at least a part of the cup 43 of the chamber 6a.

The cup 43 has an upper end 43T. At least a part of the pump 92Fa1 is disposed at a position lower than the upper end 43T. For example, the entire pump 92Fa1 is disposed at a position lower than the upper end 43T.

A positional relationship in the vertical direction Z between the pump 92Fb1 and the chambers 6a and 6b is identical to a positional relationship in the vertical direction Z between the pump 92Fa1 and the chambers 6a and 6b.

A positional relationship in the vertical direction Z between the pumps 92Fa2 and 92Fb2 and the chambers 6c and 6d is also the same as a positional relationship in the vertical direction Z between the pump 92Fa1 and the chambers 6a and 6b.

The plurality of pumps 92R are further arranged in the vertical direction Z.

The pump 92R is disposed at a height position same as a height position of the chamber 8.

For example, the pump 92Ra1 is disposed at a height position same as a height position of the chamber 8a. At least a part of the pump 92Ra1 is disposed at a height position same as a height position of at least a part of the chamber 8a. The pump 92Ra1 communicates with the chamber 8a.

The pump 92Rb1 is also disposed at a height position same as a height position of the chamber 8a. The pump 92Rb1 also communicates with the chamber 8a.

The pump 92Rb1 is disposed at a height position same as a height position of the pump 92Ra1.

For example, the pump 92Ra2 is disposed at a height position same as a height position of the chamber 8c. The pump 92Ra2 communicates with the chamber 8c.

The pump 92Ra2 is disposed upward of the pump 92Ra1. The pump 92Ra2 is disposed upward of the pump 92Rb1.

The pump 92Rb2 is also disposed at a height position same as a height position of the chamber 8c. The pump 92Rb2 also communicates with the chamber 8c.

The pump 92Rb2 is disposed at a height position same as a height position of the pump 92Ra2. The pump 92Rb2 is disposed upward of the pump 92Ra1. The pump 92Rb2 is disposed upward of the pump 92Rb1.

A positional relationship in the vertical direction Z between the pumps 92Ra1 and 92Rb1 and the chambers 8a and 8b is identical to a positional relationship in the vertical direction Z between the pump 92Fa1 and the chambers 6a and 6b.

A positional relationship in the vertical direction Z between the pumps 92Ra2 and 92Rb2 and the chambers 8c and 8d is also the same as a positional relationship in the vertical direction Z between the pump 92Fa1 and the chambers 6a and 6b.

The pump 92R is disposed at a height position same as a height position of the pump 92F. For example, the pump 92Ra1 is disposed at a height position same as a height position of the pump 92Fa1. The pump 92Rb1 is disposed at a height position same as a height position of the pump 92Fb1. The pump 92Ra2 is disposed at a height position same as a height position of the pump 92Fa2. The pump 92Rb2 is disposed at a height position same as a height position of the pump 92Fb2.

For example, the pumps 92Fa1, 92Fb1, 92Ra1, and 92Rb1 are disposed at the same height position. The pumps 92Fa2, 92Fb2, 92Ra2, and 92Rb2 are disposed at the same height position.

Although not illustrated, for example, the liquid feeder 79Ra1 is disposed at a height position same as a height position of the liquid feeder 79Fa1. The liquid feeder 79Rb1 is disposed at a height position same as a height position of the liquid feeder 79Fb1. The liquid feeder 79Ra2 is disposed at a height position same as a height position of the liquid feeder 79Fa2. The liquid feeder 79Rb2 is disposed at a height position same as a height position of the liquid feeder 79Fb2.

For example, the liquid feeders 79Fa1, 79Fb1, 79Ra1, and 79Rb1 are disposed at the same height position. The liquid feeders 79Fa2, 79Fb2, 79Ra2, and 79Rb2 are disposed at the same height position.

Although not illustrated, the pipe 72Ra1 has a length equal to a length of the pipe 72Fa1. The pipe 72Ra2 has a length equal to a length of the pipe 72Fa2. The pipe 72Rb1 has a length equal to a length of the pipe 72Fb1. The pipe 72Rb2 has a length equal to a length of the pipe 72Fb2.

For example, the pipes 72Fa1, 72Fb1, 72Ra1, and 72Rb1 have the same length. The pipes 72Fa2, 72Fb2, 72Ra2, and 72Rb2 have the same length.

### <7. Operation example>

An operation example of the substrate processing apparatus 1 will be described.

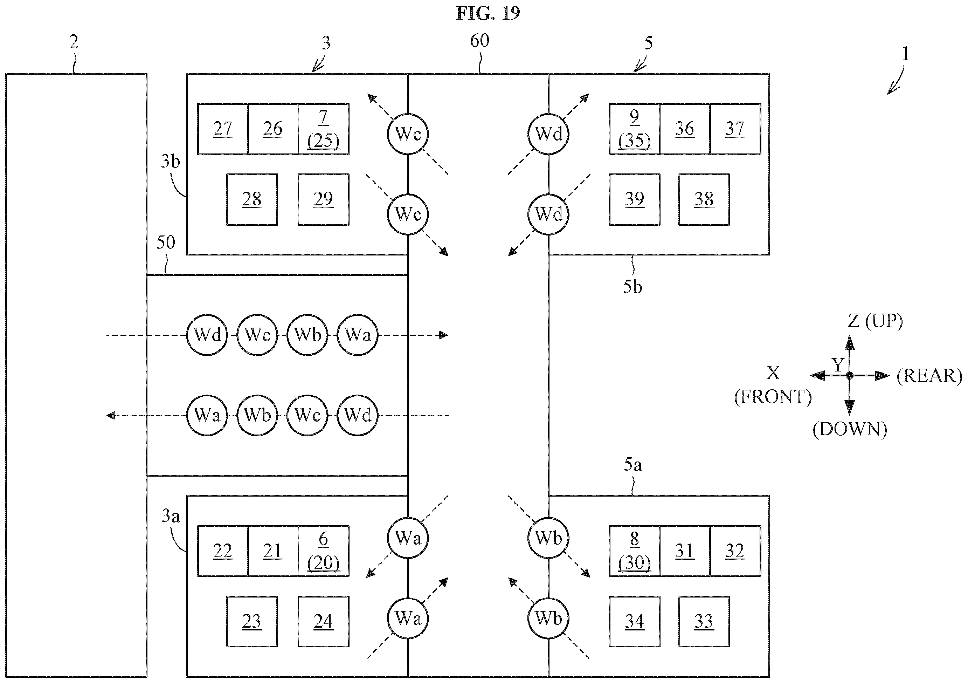

FIG. 19 is a side view of the substrate processing apparatus 1 schematically illustrating an operation of the substrate processing apparatus 1. For convenience, a plurality of substrates W are referred to as substrates Wa, Wb, Wc, and Wd in order to distinguish from one another.

The slider portion 50 transports the substrates Wa, Wb, Wc, and Wd from the indexer portion 2 to the bridge portion 60.

The bridge portion 60 performs take-in and distribution. As a result, the bridge portion 60 transports the substrates Wa, Wb, Wc, and Wd from the slider portion 50 to the front block 3 and the rear block 5. Specifically, the bridge portion 60 transports the substrate Wa from the slider portion 50 to the first front portion 3a. The bridge portion 60 transports the substrate Wb from the slider portion 50 to the first rear portion 5a. The bridge portion 60 transports the substrate Wc from the slider portion 50 to the second front portion 3b. The bridge portion 60 transports the substrate Wd from the slider portion 50 to the second rear portion 5b.

The first front portion 3a processes the substrate Wa. The first rear portion 5a processes the substrate Wb. The second front portion 3b processes the substrate Wc. The second rear portion 5b processes the substrate Wd.

The bridge portion 60 performs collection and discharge. As a result, the bridge portion 60 transports the substrates Wa, Wb, Wc, and Wd from the front block 3 and the rear block 5 to the slider portion 50. Specifically, the bridge portion 60 transports the substrate Wa from the first front portion 3a to the slider portion 50. The bridge portion 60 transports the substrate Wb from the first rear portion 5a to the slider portion 50. The bridge portion 60 transports the substrate Wc from the second front portion 3b to the slider portion 50. The bridge portion 60 transports the substrate Wd from the second rear portion 5b to the slider portion 50.

The slider portion 50 transports the substrates Wa, Wb, Wc, and Wd from the bridge portion 60 to the indexer portion 2.

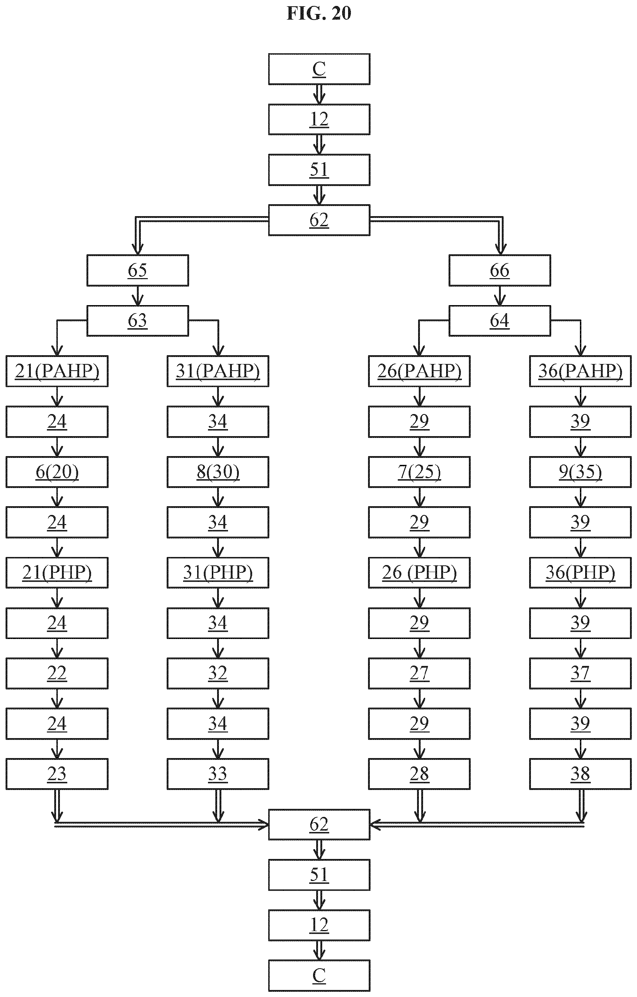

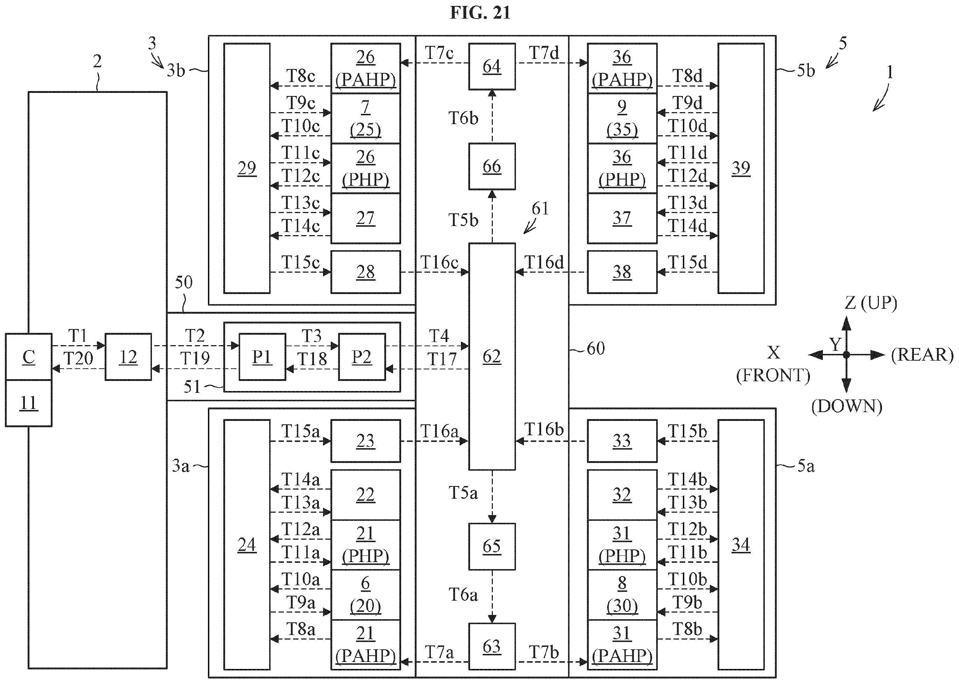

FIG. 20 is a view schematically illustrating a transport path of the substrate W. In FIG. 20, a path along which the plurality of substrates W are transported at a time is indicated by a double line. However, one substrate W may be transported at a time along the path indicated by the double line. FIG. 21 is a side view schematically illustrating an operation example of the substrate processing apparatus 1. FIG. 21 illustrates transport operations T1 to T20.

### Transport operation T1

The transport mechanism 12 takes a plurality of substrates W in the carrier C on the carrier stage 11 at a time.

### Transport operation T2

The transport mechanism 12 transports the plurality of substrates W from the indexer portion 2 to the slider portion 50 at a time. The transport mechanism 12 places the plurality of substrates W on the transport mechanism 51 at a time.

By the transport operations T1 and T2, the transport mechanism 12 transports the plurality of substrates W from the carrier C to the transport mechanism 51 at a time.

### Transport operation T3

The transport mechanism 51 transports the plurality of substrates W from the first position P1 to the second position P2 at a time. As a result, the transport mechanism 51 transports the plurality of substrates W from the indexer portion 2 to the bridge portion 60 at a time. In other words, the transport mechanism 51 transports the plurality of substrates W from the transport mechanism 12 to the transport mechanism 62 at a time.

### Transport operation T4

The transport operation T4 corresponds to the above-described "take-in".

The transport mechanism 61 takes a plurality of substrates W on the transport mechanism 51 at a time. The transport mechanism 61 transports the plurality of substrates W from the slider portion 50 to the bridge portion 60 at a time.

For example, the transport mechanism 62 takes a plurality of substrates W on the transport mechanism 51 at a time. The transport mechanism 62 transports the plurality of substrates W from the slider portion 50 to the bridge portion 60 at a time.

### Transport operations T5a and T5b

The transport mechanism 62 places the plurality of substrates W on the placing portion 65 at a time. The transport mechanism 62 places the plurality of substrates W on the placing portion 66 at a time.

By the transport operations T4 and T5a, the transport mechanism 62 transports the plurality of substrates W from the transport mechanism 51 to the placing portion 65 at a time. By the transport operations T4 and T5b, the transport mechanism 62 transports the plurality of substrates W from the transport mechanism 51 to the placing portion 66 at a time.

### Transport operation T6a

The transport mechanism 63 takes one substrate W on the placing portion 65 at a time.

### Transport operation T6b

The transport mechanism 64 takes one substrate W on the placing portion 66 at a time.

The transport mechanism 62 transports the substrate W from the transport mechanism 51 to the transport mechanism 63 by the transport operations T4, T5a, and T6a. The transport mechanism 62 transports the substrate W from the transport mechanism 51 to the transport mechanism 64 by the transport operations T4, T5b, and T6b.

### Transport operations T7a and T7b

The transport operations T7a and T7b correspond to the above-described "distribution".

The transport mechanism 61 transports a substrate W from the bridge portion 60 to the first front portion 3a. A part of the transport mechanism 61 enters the first front portion 3a. The support portion of the transport mechanism 61 enters the first front portion 3a. The transport mechanism 61 places the substrate W in one of the processing units 21. Specifically, the transport mechanism 61 places the substrate W in the adhesion reinforcing processing unit PAHP in the processing units 21. Similarly, the transport mechanism 61 transports the substrate W from the bridge portion 60 to the first rear portion 5a. A part of the transport mechanism 61 enters the first rear portion 5a. The support portion of the transport mechanism 61 enters the first rear portion 5a. The transport mechanism 61 places the substrate W in one of the processing units 31. Specifically, the transport mechanism 61 places the substrate W in the adhesion reinforcing processing unit PAHP in the processing units 31.

For example, the transport mechanism 63 transports the substrate W from the bridge portion 60 to the first front portion 3a. A part of the transport mechanism 63 enters the first front portion 3a. The support portion 47d of the transport mechanism 63 enters the first front portion 3a. The transport mechanism 63 places the substrate W in one of the processing units 21. Specifically, the transport mechanism 63 places the substrate W in the adhesion reinforcing processing unit PAHP in the processing units 21. Similarly, the transport mechanism 63 transports the substrate W from the bridge portion 60 to the first rear portion 5a. A part of the transport mechanism 63 enters the first rear portion 5a. The support portion 47d of the transport mechanism 63 enters the first rear portion 5a. The transport mechanism 63 places the substrate W in one of the processing units 31. Specifically, the transport mechanism 63 places the substrate W in the adhesion reinforcing processing unit PAHP in the processing units 31.

### Transport operations T7c and T7d

The transport operations T7c and T7d correspond to the above-described "distribution".

The transport mechanism 61 transports the substrate W from the bridge portion 60 to the second front portion 3b. A part of the transport mechanism 61 enters the second front portion 3b. The support portion of the transport mechanism 61 enters the second front portion 3b. The transport mechanism 61 places the substrate W in one of the processing units 26. Specifically, the transport mechanism 61 places the substrate W in the adhesion reinforcing processing unit PAHP in the processing units 26. Similarly, the transport mechanism 61 transports the substrate W from the bridge portion 60 to the second rear portion 5b. A part of the transport mechanism 61 enters the second rear portion 5b. The support portion of the transport mechanism 61 enters the second rear portion 5b. The transport mechanism 61 places the substrate W in one of the processing units 36. Specifically, the transport mechanism 61 places the substrate W in the adhesion reinforcing processing unit PAHP in the processing units 36.

For example, the transport mechanism 64 transports the substrate W from the bridge portion 60 to the second front portion 3b. A part of the transport mechanism 64 enters the second front portion 3b. The support portion 47d of the transport mechanism 64 enters the second front portion 3b. The transport mechanism 64 places the substrate W in one of the processing units 26. Specifically, the transport mechanism 64 places the substrate W in the adhesion reinforcing processing unit PAHP in the processing units 26. Similarly, the transport mechanism 64 transports the substrate W from the bridge portion 60 to the second rear portion 5b. A part of the transport mechanism 64 enters the second rear portion 5b. The support portion 47d of the transport mechanism 64 enters the second rear portion 5b. The transport mechanism 64 places the substrate W in one of the processing units 36. Specifically, the transport mechanism 64 places the substrate W in the adhesion reinforcing processing unit PAHP in the processing units 36.

The transport mechanism 63 transports the substrate W from the transport mechanism 62 to the processing unit 21 by the transport operations T5a, T6a, and T7a. The transport mechanism 63 transports the substrate W from the transport mechanism 62 to the processing unit 31 by the transport operations T5a, T6a, and T7b.

The transport mechanism 64 transports the substrate W from the transport mechanism 62 to the processing unit 26 by the transport operations T5b, T6b, and T7c. The transport mechanism 64 transports the substrate W from the transport mechanism 62 to the processing unit 36 by the transport operations T5b, T6b, and T7d.

An operation of the first front portion 3a will be described. The adhesion reinforcing processing unit PAHP performs adhesion reinforcing processing on the substrate W. The transport mechanism 24 takes the substrate W in the adhesion reinforcing processing unit PAHP (transport operation T8a). The transport mechanism 24 places the substrate W in the chamber 6 (transport operation T9a). Specifically, the transport mechanism 24 places the substrate W in the processing unit 20.

The chamber 6 performs liquid processing on the substrate W. The processing unit 20 performs liquid processing on the substrate W. For example, the liquid feeder 79Fa feeds the processing liquid Ra from the processing liquid container 71a to the chamber 6a. The chamber 6a supplies the processing liquid Ra to the substrate W.

Thereafter, the transport mechanism 24 takes the substrate W in the chamber 6 (transport operation T10a). The transport mechanism 24 takes the substrate W in the processing unit 20. The transport mechanism 24 places the substrate W in the heating and cooling unit PHP (transport operation T11a). The heating and cooling unit PHP heats the substrate W and then cools the substrate W. The transport mechanism 24 takes the substrate W in the heating and cooling unit PHP (transport operation T12a). The transport mechanism 24 places the substrate W in the processing unit 22 (transport operation T13a). The processing unit 22 cools the substrate W. The transport mechanism 24 takes the substrate W in the processing unit 22 (transport operation T14a). The transport mechanism 24 places the substrate W on the placing portion 23 (transport operation T15a).

Every time the first front portion 3a repeats the transport operation T15a, the number of substrates W placed on the placing portion 23 increases by one.

An operation of the first rear portion 5a is identical to the operation of the first front portion 3a. Each of operations of the second front portion 3b and the second rear portion 5b is also identical to the operation of the first front portion 3a.

### Transport operations T16a, T16b, T16c, and T16d

The transport operations T16a, T16b, T16c, and T16d correspond to the above-described "collection".

A part of the transport mechanism 61 enters the first front portion 3a. The support portion of the transport mechanism 61 enters the first front portion 3a. The transport mechanism 61 takes a plurality of substrates W on the placing portion 23 at a time. The transport mechanism 61 transports the plurality of substrates W from the first front portion 3a to the bridge portion 60 at a time. Similarly, a part of the transport mechanism 61 enters the first rear portion 5a. The support portion of the transport mechanism 61 enters the first rear portion 5a. The transport mechanism 61 takes a plurality of substrates W on the placing portion 33 at a time. The transport mechanism 61 transports the plurality of substrates W from the first rear portion 5a to the bridge portion 60 at a time. A part of the transport mechanism 61 enters the second front portion 3b. The support portion of the transport mechanism 61 enters the second front portion 3b. The transport mechanism 61 takes a plurality of substrates W on the placing portion 28 at a time. The transport mechanism 61 transports the plurality of substrates W from the second front portion 3b to the bridge portion 60 at a time. A part of the transport mechanism 61 enters the second rear portion 5b. The support portion of the transport mechanism 61 enters the second rear portion 5b. The transport mechanism 61 takes a plurality of substrates W on the placing portion 38 at a time. The transport mechanism 61 transports the plurality of substrates W from the second rear portion 5b to the bridge portion 60 at a time.

For example, a part of the transport mechanism 62 enters the first front portion 3a. The support portion 16 of the transport mechanism 62 enters the first front portion 3a. The transport mechanism 62 takes a plurality of substrates W on the placing portion 23 at a time. The transport mechanism 62 transports the plurality of substrates W from the first front portion 3a to the bridge portion 60 at a time. Similarly, a part of the transport mechanism 62 enters the first rear portion 5a. The support portion 16 of the transport mechanism 62 enters the first rear portion 5a. The transport mechanism 62 takes a plurality of substrates W on the placing portion 33 at a time. The transport mechanism 62 transports the plurality of substrates W from the first rear portion 5a to the bridge portion 60 at a time. A part of the transport mechanism 62 enters the second front portion 3b. The support portion 16 of the transport mechanism 62 enters the second front portion 3b. The transport mechanism 62 takes a plurality of substrates W on the placing portion 28 at a time. The transport mechanism 62 transports the plurality of substrates W from the second front portion 3b to the bridge portion 60 at a time. A part of the transport mechanism 62 enters the second rear portion 5b. The support portion 16 of the transport mechanism 62 enters the second rear portion 5b. The transport mechanism 62 takes a plurality of substrates W on the placing portion 38 at a time. The transport mechanism 62 transports the plurality of substrates W from the second rear portion 5b to the bridge portion 60 at a time.

### Transport operation T17

The transport operation T17 corresponds to the above-described "discharge".

The transport mechanism 61 transports the plurality of substrates W from the bridge portion 60 to the slider portion 50 at a time. A part of the transport mechanism 61 enters the slider portion 50. The support portion of the transport mechanism 61 enters the slider portion 50. The transport mechanism 61 places the plurality of substrates W on the transport mechanism 51 at a time (transport operation T17).

For example, the transport mechanism 62 transports a plurality of substrates W from the bridge portion 60 to the slider portion 50 at a time. A part of the transport mechanism 62 enters the slider portion 50. The support portion 16 of the transport mechanism 62 enters the slider portion 50. The transport mechanism 62 places the plurality of substrates W on the transport mechanism 51 at a time (transport operation T17).

By the transport operations T16a and T17, the transport mechanism 62 transports the plurality of substrates W from the placing portion 23 to the transport mechanism 51 at a time. By the transport operations T16b and T17, the transport mechanism 62 transports the plurality of substrates W from the placing portion 33 to the transport mechanism 51 at a time. By the transport operations T16c and T17, the transport mechanism 62 transports the plurality of substrates W from the placing portion 28 to the transport mechanism 51 at a time. By the transport operations T16d and T17, the transport mechanism 62 transports the plurality of substrates W from the placing portion 38 to the transport mechanism 51 at a time.

### Transport operation T18

The transport mechanism 51 transports the plurality of substrates W from the second position P2 to the first position P1 at a time. As a result, the transport mechanism 51 transports the plurality of substrates W from the bridge portion 60 to the indexer portion 2 at a time. In other words, the transport mechanism 51 transports the plurality of substrates W from the transport mechanism 62 to the transport mechanism 12 at a time.

### Transport operation T19

The transport mechanism 12 takes the plurality of substrates W on the transport mechanism 51 at a time. The transport mechanism 12 transports the plurality of substrates W from the slider portion 50 to the indexer portion 2 at a time.

### Transport operation T20

The transport mechanism 12 places the plurality of substrates W in the carrier C on the carrier stage 11 at a time.

By the transport operations T19 and T20, the transport mechanism 12 transports the plurality of substrates W from the transport mechanism 51 to the carrier C at a time.

The transport operations T1 to T20 are referred to as transport operations T when not distinguished from one another. The number of transport operations T of the substrate processing apparatus 1 is, for example, 20. The number of transport operations T of the transport mechanism 12 is four. The number of transport operations T of the transport mechanism 51 is two. The number of transport operations T of the transport mechanism 61 is 14. The number of transport operations T of the transport mechanism 62 is eight. The number of transport operations T of the transport mechanism 63 is three. The number of transport operations T of the transport mechanism 64 is three. The number of transport operations T of the transport mechanism 24 is eight. The number of transport operations T of the transport mechanism 34 is eight. The number of transport operations T of the transport mechanism 29 is eight. The number of transport operations T of the transport mechanism 39 is eight.

### <8. Effects of embodiment>

The substrate processing apparatus 1 includes the front block 3, the cabinet portion 4, and the rear block 5. The front block 3 includes a chamber 6. The rear block 5 includes a chamber 8. The cabinet portion 4 includes the processing liquid container 71a, the pipe 72Fa, and the liquid feeder 79Fa. The processing liquid container 71a stores a processing liquid Ra. The pipe 72Fa connects the processing liquid container 71a and the chamber 6. The liquid feeder 79Fa is provided on the pipe 72Fa.

Here, the front block 3, the cabinet portion 4, and the rear block 5 are arranged in this order in the front-rear direction X. Therefore, the cabinet portion 4 is close to the front block 3. Thus, it is easy to shorten the pipe 72Fa. Therefore, the liquid feeder 79Fa appropriately supplies the processing liquid Ra to the chamber 6.

In summary, according to the substrate processing apparatus 1, the processing liquid Ra is appropriately supplied.

The cabinet portion 4 includes the pipe 72Ra and the liquid feeder 79Ra. The pipe 72Ra connects the processing liquid container 71a and the chamber 8. The liquid feeder 79Ra is provided on the pipe 72Ra. As described above, the front block 3, the cabinet portion 4, and the rear block 5 are arranged in this order in the front-rear direction X. Accordingly, the cabinet portion 4 is close to the rear block 5. Thus, it is easy to shorten the pipe 72Ra. Therefore, the liquid feeder 79Ra appropriately supplies the processing liquid Ra to the chamber 8.

The cabinet portion 4 is adjacent to the chamber 6. Thus, it is easier to shorten the pipe 72Fa. Therefore, the liquid feeder 79Fa more appropriately supplies the processing liquid Ra to the chamber 6.

The cabinet portion 4 is adjacent to the chamber 8. Thus, it is easier to shorten the pipe 72Ra. Therefore, the liquid feeder 79Ra more appropriately supplies the processing liquid Ra to the chamber 8.

The pipe 72Ra has a length equal to a length of the pipe 72Fa. For example, the pipe 72Ra1 has a length equal to a length of the pipe 72Fa1. The pipe 72Ra2 has a length equal to a length of the pipe 72Fa2. Therefore, quality of processing on the substrates W in the chamber 8 can be easily made equal to quality of processing on the substrates W in the chamber 6.

The pipe 72Fa has the downstream portion 75Fa from the liquid feeder 79Fa to the chamber 6. The pipe 72Ra has the downstream portion 75Ra from the liquid feeder 79Ra to the chamber 8. The downstream portion 75Ra has a length equal to a length of the downstream portion 75Fa. Therefore, quality of processing on the substrates W in the chamber 8 can be easily made equal to quality of processing on the substrates W in the chamber 6.

The chamber 8 is disposed at a height position same as a height position of the chamber 6. For example, the chamber 8a is disposed at a height position same as a height position of the chamber 6a. Therefore, it is easy for the pipe 72Ra to have a length equal to a length of the pipe 72Fa.

The liquid feeder 79Ra is disposed at a height position same as a height position of the liquid feeder 79Fa. For example, the liquid feeder 79Ra1 is disposed at a height position same as a height position of the liquid feeder 79Fa1. The liquid feeder 79Ra2 is disposed at a height position same as a height position of the liquid feeder 79Fa2. Therefore, it is easy for the pipe 72Ra to have a length equal to a length of the pipe 72Fa.

The liquid feeder 79Fa1 includes a pump 91Fa1. The pump 91Fa1 is provided on the pipe 72Fa1. Therefore, it is easy for the liquid feeder 79Fa1 to supply the processing liquid Ra from the processing liquid container 71a to the chamber 6a.

Similarly, the liquid feeder 79Fa2 includes the pump 91Fa2. The pump 91Fa2 is provided on the pipe 72Fa2. Therefore, it is easy for the liquid feeder 79Fa2 to supply the processing liquid Ra from the processing liquid container 71a to the chamber 6c.

The liquid feeder 79Ra1 includes a pump 91Ra1. The pump 91Ra1 is provided on the pipe 72Ra1. Therefore, it is easy for the liquid feeder 79Ra1 to supply the processing liquid Ra from the processing liquid container 71a to the chamber 8a.

Similarly, the liquid feeder 79Ra2 includes the pump 91Ra2. The pump 91Ra2 is provided on the pipe 72Ra2. Therefore, it is easy for the liquid feeder 79Ra2 to supply the processing liquid Ra from the processing liquid container 71a to the chamber 8c.

The pump 91Ra1 is disposed at a height position same as a height position of the pump 91Fa1. Therefore, it is easy to arrange the liquid feeder 79Ra1 at a height position same as a height position of the liquid feeder 79Fa1.

Similarly, the pump 91Ra2 is disposed at a height position same as a height position of the pump 91Fa2. Therefore, it is easy to arrange the liquid feeder 79Ra2 at a height position same as a height position of the liquid feeder 79Fa2.

The liquid feeder 79Fa1 includes the pump 92Fa1. The pump 92Fa1 is provided on the pipe 72Fa1. The pump 92Fa1 is disposed downstream of the pump 91Fa1. Therefore, it is easy for the liquid feeder 79Fa1 to supply the processing liquid Ra from the processing liquid container 71a to the chamber 6a.

Similarly, the liquid feeder 79Fa2 includes the pump 92Fa2. The pump 92Fa2 is provided on the pipe 72Fa2. The pump 92Fa2 is disposed downstream of the pump 91Fa2. Therefore, it is easy for the liquid feeder 79Fa2 to supply the processing liquid Ra from the processing liquid container 71a to the chamber 6c.

The liquid feeder 79Ra1 includes the pump 92Ra1. The pump 92Ra1 is provided on the pipe 72Ra1. The pump 92Ra1 is disposed downstream of the pump 91Ra1. Therefore, it is easy for the liquid feeder 79Ra1 to supply the processing liquid Ra from the processing liquid container 71a to the chamber 8a.

Similarly, the liquid feeder 79Ra2 includes the pump 92Ra2. The pump 92Ra2 is provided on the pipe 72Ra2. The pump 92Ra2 is disposed downstream of the pump 91Ra2. Therefore, it is easy for the liquid feeder 79Ra2 to supply the processing liquid Ra from the processing liquid container 71a to the chamber 8c.

The pump 92Ra1 is disposed at a height position same as a height position of the pump 92Fa1. Therefore, it is easy to arrange the liquid feeder 79Ra1 at a height position same as a height position of the liquid feeder 79Fa1.

Similarly, the pump 92Ra2 is disposed at a height position same as a height position of the pump 92Fa2. Therefore, it is easy to arrange the liquid feeder 79Ra2 at a height position same as a height position of the liquid feeder 79Fa2.

The pump 92F is closer to the front block 3 than the center Q4 of the cabinet portion 4 in the front-rear direction X. Therefore, a distance between the pump 92F and the chamber 6 in the front-rear direction X is relatively short. Thus, it is easy to shorten a length of a portion of the pipe 72Fa between the pump 92F and the chamber 6. Therefore, the liquid feeder 79Fa appropriately supplies the processing liquid Ra to the chamber 6.

For example, the pump 92Fa1 is closer to the front block 3 than the center Q4 of the cabinet portion 4 in the front-rear direction X. Therefore, a distance between the pump 92Fa1 and the chamber 6a in the front-rear direction X is relatively short. Thus, it is easy to shorten a length of a portion of the pipe 72Fa1 between the pump 92Fa1 and the chamber 6a. Therefore, the liquid feeder 79Fa1 appropriately supplies the processing liquid Ra to the chamber 6a.

For example, the pump 92Fa2 is closer to the front block 3 than the center Q4 of the cabinet portion 4 in the front-rear direction X. Therefore, a distance between the pump 92Fa2 and the chamber 6c in the front-rear direction X is relatively short. Thus, it is easy to shorten a length of a portion of the pipe 72Fa2 between the pump 92Fa2 and the chamber 6c. Therefore, the liquid feeder 79Fa2 appropriately supplies the processing liquid Ra to the chamber 6c.

Similarly, it is easy to shorten a length of a portion of the pipe 72Fb1 between the pump 92Fb1 and the chamber 6a. Therefore, the liquid feeder 79Fb1 appropriately supplies the processing liquid Rb to the chamber 6a. It is easy to shorten a length of a portion of the pipe 72Fb2 between the pump 92Fb2 and the chamber 6c. Therefore, the liquid feeder 79Fb2 appropriately supplies the processing liquid Rb to the chamber 6c.

The pump 92R is closer to the rear block 5 than the center Q4 of the cabinet portion 4 in the front-rear direction X. Therefore, a distance between the pump 92R and the chamber 8 in the front-rear direction X is relatively short. Thus, it is easy to shorten a length of a portion of the pipe 72Ra between the pump 92R and the chamber 8. Therefore, the liquid feeder 79Ra appropriately supplies the processing liquid Ra to the chamber 8.

For example, the pump 92Ra1 is closer to the rear block 5 than the center Q4 of the cabinet portion 4 in the front-rear direction X. Therefore, a distance between the pump 92Ra1 and the chamber 8a in the front-rear direction X is relatively short. Thus, it is easy to shorten a length of a portion of the pipe 72Ra1 between the pump 92Ra1 and the chamber 8a. Therefore, the liquid feeder 79Ra1 appropriately supplies the processing liquid Ra to the chamber 8a.

For example, the pump 92Ra2 is closer to the rear block 5 than the center Q4 of the cabinet portion 4 in the front-rear direction X. Therefore, a distance between the pump 92Ra2 and the chamber 8c in the front-rear direction X is relatively short. Thus, it is easy to shorten a length of a portion of the pipe 72Ra2 between the pump 92Ra2 and the chamber 8c. Therefore, the liquid feeder 79Ra2 appropriately supplies the processing liquid Ra to the chamber 8c.

Similarly, it is easy to shorten a length of a portion of the pipe 72Rb1 between the pump 92Rb1 and the chamber 8a. Therefore, the liquid feeder 79Rb1 appropriately supplies the processing liquid Rb to the chamber 8a. It is easy to shorten a length of a portion of the pipe 72Rb2 between the pump 92Rb2 and the chamber 8c. Therefore, the liquid feeder 79Rb2 appropriately supplies the processing liquid Rb to the chamber 8c.

The pipe 72Fa extends from the cabinet portion 4 to the front block 3. The pipe 72Fa includes the inner portion 76Fa, the outer portion 77Fa, and the joint 78Fa. The inner portion 76Fa is disposed in the cabinet portion 4. The outer portion 77Fa is disposed in the front block 3. The joint 78Fa connects the inner portion 76Fa and the outer portion 77Fa. Therefore, it is easy to separate the pipe 72Fa at the boundary Q1 between the cabinet portion 4 and the front block 3.

The pipe 72Ra extends from the cabinet portion 4 to the rear block 5. The pipe 72Ra includes the inner portion 76Ra, the outer portion 77Ra, and the joint 78Ra. The inner portion 76Ra is disposed in the cabinet portion 4. The outer portion 77Ra is disposed in the rear block 5. The joint 78Ra connects the inner portion 76Ra and the outer portion 77Ra. Therefore, it is easy to separate the pipe 72Ra at the boundary Q2 between the cabinet portion 4 and the rear block 5.

The pipe 72Fa does not reach the rear block 5. Therefore, it is easy to shorten the pipe 72Fa.

As described above, the pipe 72Fa does not reach the rear block 5. Therefore, the number of the joints 78Fa of the pipe 72Fa is small. When the joint 78Fa is attached and detached, foreign matter or dust may enter the pipe 72Fa. As described above, the number of the joints 78Fa of the pipe 72Fa is small. Therefore, it is easy to keep the pipe 72Fa in good condition. It is easy to keep the pipe 72Fa clean.

The pipe 72Ra does not reach the front block 3. Therefore, it is easy to shorten the pipe 72Ra.

As described above, the pipe 72Ra does not reach the front block 3. Therefore, the number of the joints 78Ra of the pipe 72Ra is small. Therefore, it is easy to keep the pipe 72Ra in good condition. It is easy to keep the pipe 72Ra clean.

The cabinet portion 4 is adjacent to the chamber 6. Thus, it is easier to shorten the pipe 72Fa. Therefore, the liquid feeder 79Fa more appropriately supplies the processing liquid Ra to the chamber 6.

As described above, the liquid feeder 79Fa1 includes the pump 91Fa1. The pump 91Fa1 is provided on the pipe 72Fa1. Therefore, it is easy for the liquid feeder 79Fa to supply the processing liquid Ra from the processing liquid container 71a to the chamber 6a.

As described above, the liquid feeder 79Fa2 includes the pump 91Fa2. The pump 91Fa2 is provided on the pipe 72Fa2. Therefore, it is easy for the liquid feeder 79Fa2 to supply the processing liquid Ra from the processing liquid container 71a to the chamber 6c.

The pump 91Fa1 is disposed at a position lower than the processing liquid container 71a. Therefore, gravity promotes a flow of the processing liquid Ra from the processing liquid container 71a to the pump 91Fa1. Thus, it is easy for the processing liquid Ra to flow from the processing liquid container 71a to the pump 91Fa1. For example, it is easy for the pump 91Fa1 to suction the processing liquid Ra from the processing liquid container 71a. Therefore, the pressure of the processing liquid Ra does not significantly decrease between the processing liquid container 71a and the pump 91Fa1. The processing liquid Ra does not generate bubbles between the processing liquid container 71a and the pump 91Fa1. As a result, the liquid feeder 79Fa1 appropriately supplies the processing liquid Ra to the chamber 6a.

Similarly, the pump 91Fa2 is disposed at a position lower than the processing liquid container 71a. Thus, the liquid feeder 79Fa2 appropriately supplies the processing liquid Ra to the chamber 6c.

As described above, the liquid feeder 79Ra1 includes the pump 91Ra1. The pump 91Ra1 is provided on the pipe 72Ra1. Therefore, it is easy for the liquid feeder 79Ra1 to supply the processing liquid Ra from the processing liquid container 71a to the chamber 8a.

As described above, the liquid feeder 79Ra2 includes the pump 91Ra2. The pump 91Ra2 is provided on the pipe 72Ra2. Therefore, it is easy for the liquid feeder 79Ra2 to supply the processing liquid Ra from the processing liquid container 71a to the chamber 8c.

Each of the pumps 91Ra1 and 91Ra2 is disposed at a position lower than the processing liquid container 71a. Thus, each of the liquid feeders 79Ra1 and 79Ra2 appropriately supplies the processing liquid Ra to the chamber 8.

The pump 91 overlaps with the processing liquid container 71 in plan view. Accordingly, it is easy to reduce a size of the cabinet portion 4 in plan view. In other words, it is easy to reduce a footprint of the cabinet portion 4.

As described above, the liquid feeder 79Fa1 includes the pump 92Fa1. The pump 92Fa1 is provided on the pipe 72Fa1. The pump 92Fa1 is disposed downstream of the pump 91F1. Therefore, it is easy for the liquid feeder 79Fa1 to supply the processing liquid Ra from the processing liquid container 71a to the chamber 6a.

As described above, the pump 92Fa1 is closer to the front block 3 than the center Q4 of the cabinet portion 4 in the front-rear direction X. Therefore, a distance between the pump 92Fa1 and the chamber 6a in the front-rear direction X is relatively short. Thus, it is easy to shorten a length of a portion of the pipe 72Fa1 between the pump 92Fa1 and the chamber 6a. Therefore, the liquid feeder 79Fa1 appropriately supplies the processing liquid Ra to the chamber 6a.

At least a part of the pump 92Fa1 is disposed at a height position same as a height position of at least a part of the chamber 6a. Therefore, a distance between the pump 92Fa1 and the chamber 6a in the vertical direction Z is relatively short. Thus, it is easier to shorten a length of a portion of the pipe 72Fa1 between the pump 92Fa1 and the chamber 6a. Therefore, the liquid feeder 79Fa1 appropriately supplies the processing liquid Ra to the chamber 6a.

The chamber 6 includes the processing unit 20a. The processing unit 20a includes the holding portion 41 and the nozzle 42. The holding portion 41 holds the substrate W. The nozzle 42 dispenses the processing liquid to the substrate W held by the holding portion 41. The pipe 72Fa connects the processing liquid container 71a and the nozzle 42. Therefore, it is easy for the liquid feeder 79Fa to supply the processing liquid Ra from the processing liquid container 71a to the nozzle 42.

At least a part of the pump 92Fa1 is disposed at a position lower than the nozzle 42 of the chamber 6a. Therefore, the liquid feeder 79Fa1 appropriately supplies the processing liquid Ra to the nozzle 42 of the chamber 6a.

The chamber 6 includes the processing unit 20b. Therefore, the chamber 6 efficiently processes the substrate W.

The processing unit 20b shares the nozzle 42 of the processing unit 20a. Therefore, quality of processing on the substrates W in the processing unit 20b can be easily made equal to quality of processing on the substrates W in the processing unit 20a.

The processing unit 20a includes the cup 43. The cup 43 is disposed outward of the holding portion 41. The cup 43 has an upper end 43T. At least a part of the pump 92Fa1 is disposed at a position lower than the upper end 43T of the cup 43 of the chamber 6a. Therefore, the liquid feeder 79Fa1 appropriately supplies the processing liquid Ra to the nozzle 42 of the chamber 6a.

The cabinet portion 4 includes the processing liquid container 71b, the pipe 72Fb1, and the liquid feeder 79Fb1. The processing liquid container 71b stores a processing liquid Rb. The pipe 72Fb1 connects the processing liquid container 71b and the chamber 6a. The liquid feeder 79Fb1 is provided on the pipe 72Fb1. The liquid feeder 79Fb1 includes the pump 91Fb1 and the pump 92Fb1. The pump 91Fb1 is provided on the pipe 72Fb1. The pump 92Fb1 is provided on the pipe 72Fb1. The pump 92Fb1 is disposed downstream of the pump 91Fb1. Therefore, it is easy for the liquid feeder 79Fb1 to supply the processing liquid Rb from the processing liquid container 71b to the chamber 6a.

The pump 92Fa1 and the pump 92Fb1 are disposed at the same height position. Therefore, it is easy to improve quality of processing on the substrate W in the chamber 6a. For example, quality of processing on the substrate W using the processing liquid Rb in the chamber 6a can be easily made equal to quality of processing on the substrate W using the processing liquid Ra in the chamber 6a.

The pump 92Fa1 and the pump 92Fb1 are arranged in the width direction Y. A width direction Y is horizontal. Therefore, it is easy to dispose the pump 92Fb1 at a height position same as a height position of the pump 92Fa1.

The width direction Y is orthogonal to the front-rear direction X. Therefore, the pump 92Fa1 and the pump 92Fb1 are not arranged in the front-rear direction X. Accordingly, it is easy to shorten a length of the cabinet portion 4 in the front-rear direction X.

The substrate processing apparatus 1 includes the indexer portion 2. The indexer portion 2 includes the carrier stage 11 and the transport mechanism 12. The carrier stage 11 and the transport mechanism 12 are arranged in the width direction Y. A width direction Y is horizontal. The width direction Y is orthogonal to the front-rear direction X. Therefore, it is easy to shorten the length U of the indexer portion 2 in the front-rear direction X. Thus, even when the substrate processing apparatus 1 includes the cabinet portion 4, a length of the substrate processing apparatus 1 in the front-rear direction X does not significantly increase.

The indexer portion 2, the front block 3, the cabinet portion 4, and the rear block 5 are arranged in this order in a front-rear direction X. Even when the indexer portion 2, the front block 3, the cabinet portion 4, and the rear block 5 are arranged in this order in the front-rear direction X, the liquid feeder 79Fa appropriately supplies the processing liquid Ra to the chamber 6.

The pipe 72Fa does not reach the indexer portion 2. Therefore, it is easy to shorten the pipe 72Fa.

As described above, the pipe 72Fa does not reach the indexer portion 2. Therefore, the number of the joints 78Fa of the pipe 72Fa is small. Therefore, it is easy to keep the pipe 72Fa in good condition. It is easy to keep the pipe 72Fa clean.

The substrate processing apparatus 1 includes the bridge portion 60. The bridge portion 60 transports the substrate W to the front block 3 and the rear block 5. Therefore, it is easy for the front block 3 to process the substrate W. It is easy for the rear block 5 to process the substrate W.

The front block 3, the bridge portion 60, and the rear block 5 are arranged in this order in the front-rear direction X. Therefore, it is easy for the bridge portion 60 to transport the substrate W to the front block 3 and the rear block 5.

The cabinet portion 4 and the bridge portion 60 are arranged in the width direction Y. Therefore, it is easy to arrange the front block 3, the bridge portion 60, and the rear block 5 in this order in the front-rear direction X.

The substrate processing apparatus 1 includes the slider portion 50. The slider portion 50 transports the substrate W between the indexer portion 2 and the bridge portion 60. Therefore, the substrate W is efficiently transported between the indexer portion 2 and the bridge portion 60.

The slider portion 50 overlaps with the front block 3 in plan view. Therefore, even when the substrate processing apparatus 1 includes the slider portion 50, the substrate processing apparatus 1 does not become significantly large in plan view. In other words, even when the substrate processing apparatus 1 includes the slider portion 50, a footprint of the substrate processing apparatus 1 does not become significantly large.

### <9. Modified embodiment>

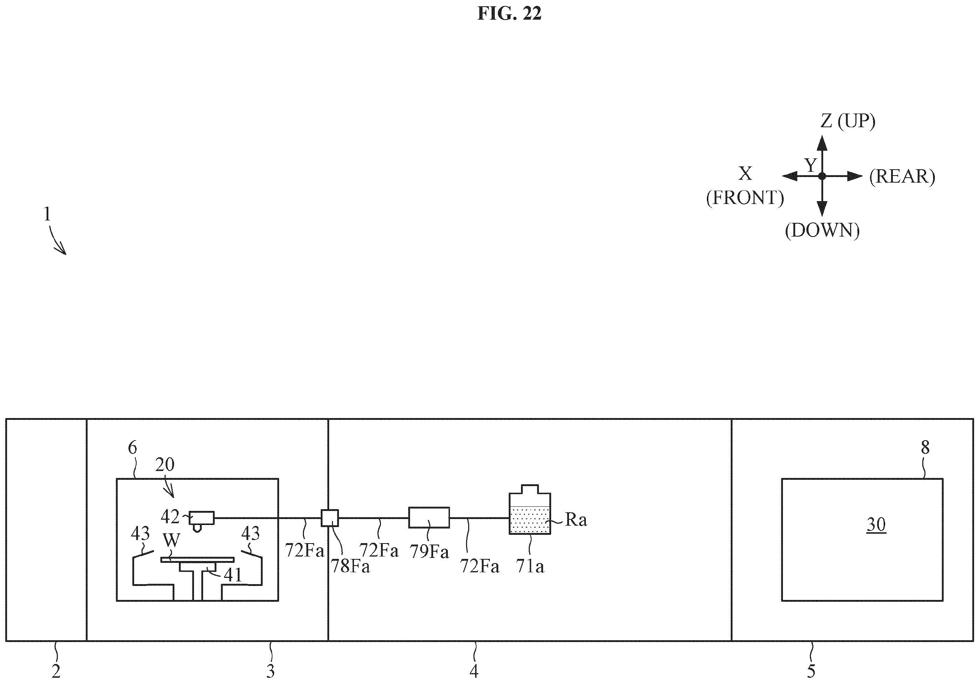

The present invention is not limited to the embodiment, and can be modified as follows.
(1) The cabinet portion 4 may supply the processing liquid Ra to only one of the front block 3 or the rear block 5. The cabinet portion 4 may supply the processing liquid Ra to only one of the chamber 6 or the chamber 8. Two modified embodiments will be described.
(1-1) FIG. 22 is a schematic side view of a substrate processing apparatus 1 according to a modified embodiment. The same components as those of the embodiment are denoted by the same reference numerals, and a detailed description thereof will be omitted.

The cabinet portion 4 supplies the processing liquid Ra to the front block 3. The cabinet portion 4 supplies the processing liquid Ra to the chamber 6.

The cabinet portion 4 does not supply the processing liquid Ra to the rear block 5. The cabinet portion 4 does not supply the processing liquid Ra to the chamber 8.

The cabinet portion 4 includes the processing liquid container 71a, the pipe 72Fa, and the liquid feeder 79Fa. The cabinet portion 4 does not include the pipe 72Ra. The cabinet portion 4 does not include the liquid feeder 79Ra.

In the modified embodiment of (1-1) described above, the chamber 8 may perform liquid processing on the substrate W. For example, the chamber 8 may use a processing liquid of equipment outside the substrate processing apparatus 1. The equipment outside the substrate processing apparatus 1 is, for example, utility equipment. The processing liquid of the equipment outside the substrate processing apparatus 1 is, for example, a developer. Alternatively, the chamber 8 may perform non-liquid processing on the substrate W.

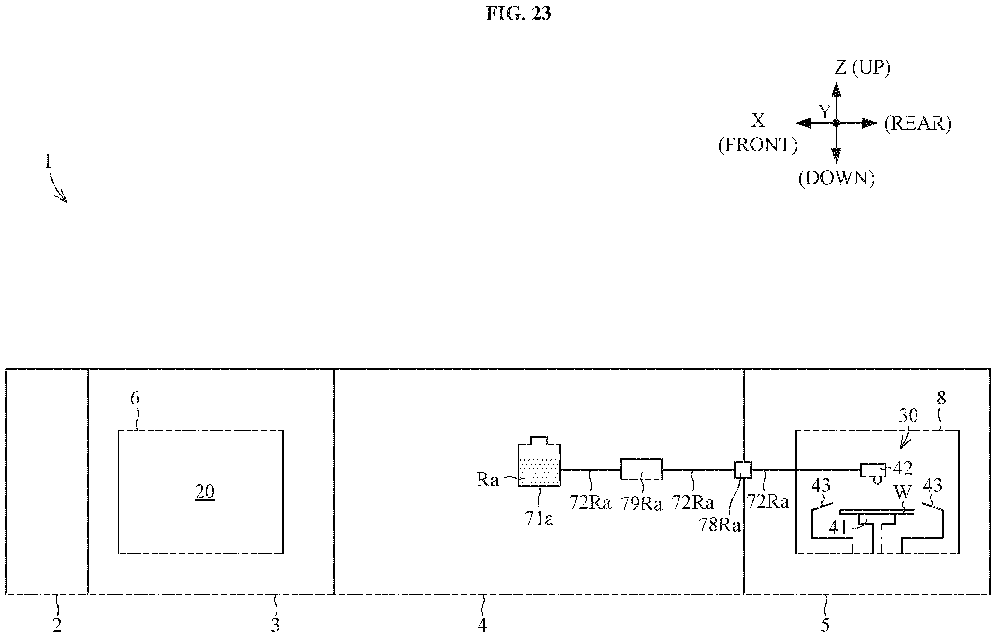

(1-2) FIG. 23 is a schematic side view of a substrate processing apparatus 1 according to a modified embodiment. The same components as those of the embodiment are denoted by the same reference numerals, and a detailed description thereof will be omitted.

The cabinet portion 4 supplies the processing liquid Ra to the rear block 5. The cabinet portion 4 supplies the processing liquid Ra to the chamber 8.

The cabinet portion 4 does not supply the processing liquid Ra to the front block 3. The cabinet portion 4 does not supply the processing liquid Ra to the chamber 6.

The cabinet portion 4 includes the processing liquid container 71a, the pipe 72Ra, and the liquid feeder 79Ra. The cabinet portion 4 does not include the pipe 72Fa. The cabinet portion 4 does not include the liquid feeder 79Fa.

In the modified embodiment of (1-2) described above, the chamber 6 may perform liquid processing on the substrate W. For example, the chamber 6 may use a processing liquid of equipment outside the substrate processing apparatus 1. Alternatively, the chamber 6 may perform non-liquid processing on the substrate W.

In the modified embodiment of (1-2) described above, the front block 3 is an example of the second block of the present invention. The rear block 5 is an example of the first block of the present invention.

(2) The indexer portion 2 may be adjacent to the rear block 5. The front block 3, the cabinet portion 4, the rear block 5, and the indexer portion 2 may be arranged in this order in the front-rear direction X.

Even when the front block 3, the cabinet portion 4, the rear block 5, and the indexer portion 2 are arranged in this order in the front-rear direction X, the liquid feeder 79Fa appropriately supplies the processing liquid Ra to the chamber 6.

In the modified embodiment of (2) described above, the slider portion 50 preferably overlaps with the rear block 5 in plan view. The slider portion 50 preferably does not overlap with the front block 3 in plan view. Therefore, even when the substrate processing apparatus 1 includes the slider portion 50, the substrate processing apparatus 1 does not become significantly large in plan view. In other words, even when the substrate processing apparatus 1 includes the slider portion 50, a footprint of the substrate processing apparatus 1 does not become significantly large.
(3) The processing unit 20b may not share the nozzle 42 of the processing unit 20a. The processing unit 20b may include a nozzle separate from the nozzle 42 of the processing unit 20a. Similarly to the processing unit 20b, the processing unit 30b may be changed.
(4) Processing performed on the substrate W by the chamber 8 may be identical to processing performed on the substrate W by the chamber 6. Processing performed on the substrate W by the chamber 8 may be different from processing performed on the substrate W by the chamber 6.
(5) Processing performed on the substrate W by the chamber 7 may be identical to processing performed on the substrate W by the chamber 6. Processing performed on the substrate W by the chamber 7 may be different from processing performed on the substrate W by the chamber 6.

Processing performed on the substrate W by the chamber 7 may be identical to processing performed on the substrate W by the chamber 8. Processing performed on the substrate W by the chamber 7 may be different from processing performed on the substrate W by the chamber 8.

Processing performed on the substrate W by the chamber 9 may be identical to processing performed on the substrate W by the chamber 6. Processing performed on the substrate W by the chamber 9 may be different from processing performed on the substrate W by the chamber 6.

Processing performed on the substrate W by the chamber 9 may be identical to processing performed on the substrate W by the chamber 7. Processing performed on the substrate W by the chamber 9 may be different from processing performed on the substrate W by the chamber 7.

Processing performed on the substrate W by the chamber 9 may be identical to processing performed on the substrate W by the chamber 8. Processing performed on the substrate W by the chamber 9 may be different from processing performed on the substrate W by the chamber 8.

(6) The number of the chambers 6 may be one. For example, the chambers 6b, 6c, and 6d may be omitted.

Similarly to the chamber 6, the chamber 8 may be changed.

(7) The number of the processing units 20 included in one chamber 6 may be one. For example, the number of the processing units 20 included in the chamber 6a may be one. For example, one of the processing unit 20a or the processing unit 20b may be omitted. Alternatively, the number of the processing units 20 included in one chamber 6 may be three or more. The number of the processing units 20 included in the chamber 6a may be three or more.

Similarly to the chamber 6, the chamber 8 may be changed. Similarly to the processing unit 20, the processing unit 30 may be changed.

(8) The number of pumps included in one liquid feeder 79Fa may be one. For example, the number of pumps included in the liquid feeder 79Fa1 may be one. For example, one of the pump 91Fa1 or the pump 92Fa1 may be omitted. For example, the number of pumps included in the liquid feeder 79Fa2 may be one. For example, one of the pump 91Fa2 or the pump 92Fa2 may be omitted.

Alternatively, the number of pumps included in one liquid feeder 79Fa may be three or more. For example, the number of pumps included in the liquid feeder 79Fa1 may be three or more. For example, the number of pumps included in the liquid feeder 79Fa2 may be three or more.

Two modified embodiments will be described.

(8-1) Although not illustrated, the liquid feeder 79Fa1 includes a pump 111Fa1 in addition to the pumps 91Fa1 and 92Fa1. For convenience, reference is made to FIG. 14. The pumps 91Fa1, 92Fa1, and 111Fa1 are provided on the pipe 72Fa1. The pipe 72Fa1 connects the pumps 91Fa1, 92Fa1, and 111Fa1 in series. When the liquid feeder 79Fa1 supplies the processing liquid Ra to the chamber 6a, the pumps 91Fa1, 92Fa1, and 111Fa1 operate. The pumps 91Fa1, 92Fa1, and 111Fa1 operate also when the liquid feeder 79Fa1 supplies the processing liquid Ra to the chamber 6b.

(8-2) Although not illustrated, the liquid feeder 79Fa1 includes a pump 113Fa1 in addition to the pumps 91Fa1 and 92Fa1. For convenience, reference is made to FIG. 14. The pumps 91Fa1 and 92Fa1 are provided on the pipe 72Fa1. The pump 91Fa1 is disposed upstream of the branch portion 85Fa1. The pump 92Fa1 is disposed downstream of the branch portion 85Fa1. The pump 113Fa1 is provided on the branch pipe 86Fa1. The pumps 92Fa1 and 113Fa1 are connected in parallel. When the liquid feeder 79Fa1 supplies the processing liquid Ra to the chamber 6a, the pumps 91Fa1 and 92Fa1 operate, and the pump 113Fa1 does not operate. When the liquid feeder 79Fa1 supplies the processing liquid Ra to the chamber 6b, the pumps 91Fa1 and 113Fa1 operate, and the pump 92Fa1 does not operate.

Similarly to the liquid feeder 79Fa1, the liquid feeder 79Fa2 may be changed. Similarly to the liquid feeder 79Fa1, the liquid feeder 79Ra1 may be changed. Similarly to the liquid feeder 79Fa1, the liquid feeder 79Ra2 may be changed.

Similarly to the liquid feeder 79Fa, the liquid feeder 79Ra may be changed.

(9) The number of the chambers 6 to which the liquid feeder 79Fa supplies the processing liquid Ra may be one. For example, the number of the chambers 6 to which the liquid feeder 79Fa1 supplies the processing liquid Ra may be one. The number of the chambers 6 to which the liquid feeder 79Fa2 supplies the processing liquid Ra may be one.

The liquid feeder 79Fa may supply the processing liquid Ra to the chamber 6a alone. The liquid feeder 79Fa may not supply the processing liquid Ra to the chambers 6b, 6c, and 6d. For example, the liquid feeder 79Fa1 may supply the processing liquid Ra to the chamber 6a alone. The liquid feeder 79Fa2 may supply the processing liquid Ra to the chamber 6a alone.

Alternatively, the number of the chambers 6 to which the processing liquid Ra is supplied by the liquid feeder 79Fa may be three or more. For example, the number of the chambers 6 to which the liquid feeder 79Fa1 supplies the processing liquid Ra may be three or more. The number of the chambers 6 to which the liquid feeder 79Fa2 supplies the processing liquid Ra may be three or more.

Similarly to the liquid feeder 79Fa, the liquid feeder 79Ra may be changed.
(10) The slider portion 50 may be omitted. For example, the indexer portion 2 and the front block 3 may deliver the substrate W. For example, the indexer portion 2 and the front block 3 may directly deliver the substrate W. Although not illustrated, the substrate processing apparatus 1 may include a placing portion disposed at the boundary Q3 between the indexer portion 2 and the front block 3. For example, the indexer portion 2 and the front block 3 may deliver the substrate W via the placing portion on the boundary Q3.
(11) The bridge portion 60 may be omitted. For example, the front block 3 and the rear block 5 may deliver the substrate W. For example, the front block 3 and the rear block 5 may directly deliver the substrate W. Although not illustrated, the substrate processing apparatus 1 may include a placing portion disposed between the front block 3 and the rear block 5. For example, the front block 3 and the rear block 5 may deliver the substrate W via the placing portion between the front block 3 and the rear block 5.
(12) The second front portion 3b may be omitted.
(13) The second rear portion 5b may be omitted.
(14) In the embodiment and each modified embodiment described in (1) to (13) described above, each configuration may be appropriately changed by further replacing or combining each configuration with a configuration of another modified embodiment.

The present invention may be embodied in other specific forms without departing from the spirit or essential attributes thereof and, accordingly, reference should be made to the appended claims, rather than to the foregoing specification, as indicating the scope of the invention.

### Reference Signs List

1: Substrate processing apparatus
2: Indexer portion
3: Front block (first block and second block)
4: Cabinet portion
5: Rear block (first block and second block)
6, 6a, 6b, 6c, 6d: Chamber (first chamber)
6aT: Upper end of chamber
6aB: Lower end of chamber
8, 8a, 8b, 8c, 8d: Chamber (second chamber)
11: Carrier stage
12: Transport mechanism
20: Processing unit (first processing unit, second processing unit)
20a: Processing unit (first processing unit)
20b: Processing unit (second processing unit)
30: Processing unit
41: Holding portion
42: Nozzle
43: Cup
43T: Upper end of cup
71a: Processing liquid container (first processing liquid container)
71b: Processing liquid container (second processing liquid container)
72Fa: Pipe (first pipe)
72Ra: Pipe (second pipe)
72Fb: Pipe (third pipe)
73Fa: Upstream portion (upstream portion of first pipe)
73Ra: Upstream portion (upstream portion of second pipe)
75Fa: Downstream portion (downstream portion of first pipe)
75Ra: Downstream portion (downstream portion of second pipe)
76Fa: Inner portion (first inner portion)
76Ra: Inner portion (second inner portion)
77Fa: Outer portion (first outer portion)
77Ra: Outer portion (second outer portion)
78Fa: Joint (first joint)
78Rb: Joint (second joint)
79Fa: Liquid feeder (first liquid feeder)
79Ra: Liquid feeder (second liquid feeder)
79Fb: Liquid feeder (third liquid feeder)
91Fa1, 91Fa2: Pump (first pump)
92Fa1, 92Fa2: Pump (second pump)
91Ra1, 91Ra2: Pump (third pump)
92Ra1, 92Ra2: Pump (fourth pump)
91Fb1, 91Fb2: Pump (fifth pump)
92Fb1, 92Fb2: Pump (sixth pump)
Q1: Boundary between cabinet portion and front block
Q2: Boundary between cabinet portion and rear block
Q3: Boundary between indexer portion and front block
Q4: Center of cabinet portion in front-rear direction
Ra, Rb: Processing liquid
U: Length of indexer portion in front-rear direction
V: Height position of dispensing opening of nozzle
W: Substrate
X: Front-rear direction (first direction)
Y: Width direction (second direction)
Z: Vertical direction

## Claims

1. A substrate processing apparatus comprising:
a first block;
a cabinet portion; and
a second block, wherein
the first block, the cabinet portion, and the second block are arranged in this order in a first direction,
the first direction is horizontal,
the first block includes a first chamber,
the second block includes a second chamber, and
the cabinet portion includes:
a first processing liquid container configured to store a processing liquid;
a first pipe connecting the first processing liquid container and the first chamber; and
a first liquid feeder provided on the first pipe.

2. The substrate processing apparatus according to claim 1, wherein
the cabinet portion includes:
a second pipe connecting the first processing liquid container and the second chamber; and
a second liquid feeder provided on the second pipe.

3. The substrate processing apparatus according to claim 2, wherein
the cabinet portion is adjacent to the first chamber, and
the cabinet portion is adjacent to the second chamber.

4. The substrate processing apparatus according to claim 2, wherein
the second pipe has a length equal to a length of the first pipe.

5. The substrate processing apparatus according to claim 2, wherein
the first pipe has a downstream portion from the first liquid feeder to the first chamber,
the second pipe has a downstream portion from the second liquid feeder to the second chamber, and
the downstream portion of the second pipe has a length equal to a length of the downstream portion of the first pipe.

6. The substrate processing apparatus according to claim 2, wherein
the second chamber is disposed at a height position same as a height position of the first chamber.

7. The substrate processing apparatus according to claim 2, wherein
the second liquid feeder is disposed at a height position same as a height position of the first liquid feeder.

8. The substrate processing apparatus according to claim 2, wherein
the first liquid feeder includes a first pump provided on the first pipe,
the second liquid feeder includes a third pump provided on the second pipe, and
the third pump is disposed at a height position same as a height position of the first pump.

9. The substrate processing apparatus according to claim 8, wherein
the first liquid feeder includes a second pump provided on the first pipe,
the second pump is disposed downstream of the first pump,
the second liquid feeder includes a fourth pump provided on the second pipe,
the fourth pump is disposed downstream of the third pump, and
the fourth pump is disposed at a height position same as a height position of the second pump.

10. The substrate processing apparatus according to claim 9, wherein
the second pump is closer to the first block than a center of the cabinet portion in the first direction, and
the fourth pump is closer to the second block than a center of the cabinet portion in the first direction.

11. The substrate processing apparatus according to claim 2, wherein
the first pipe extends from the cabinet portion to the first block,
the first pipe includes:
a first inner portion disposed in the cabinet portion;
a first outer portion disposed in the first block; and
a first joint connecting the first inner portion and the first outer portion, the second pipe extends from the cabinet portion to the second block, and the second pipe includes:
a second inner portion disposed in the cabinet portion;
a second outer portion disposed in the second block; and
a second joint connecting the second inner portion and the second outer portion.

12. The substrate processing apparatus according to claim 2, wherein
the first pipe does not reach the second block, and
the second pipe does not reach the first block.

13. The substrate processing apparatus according to claim 1, wherein
the cabinet portion is adjacent to the first chamber.

14. The substrate processing apparatus according to claim 1, wherein
the first liquid feeder includes a first pump provided on the first pipe.

15. The substrate processing apparatus according to claim 14, wherein
the first pump is disposed at a position lower than the first processing liquid container.

16. The substrate processing apparatus according to claim 14, wherein
the first pump overlaps with the first processing liquid container in plan view.

17. The substrate processing apparatus according to claim 14, wherein
the first liquid feeder includes a second pump provided on the first pipe, and
the second pump is disposed downstream of the first pump.

18. The substrate processing apparatus according to claim 17, wherein
the second pump is closer to the first block than a center of the cabinet portion in the first direction.

19. The substrate processing apparatus according to claim 17, wherein
at least a part of the second pump is disposed at a height position same as a height position of at least a part of the first chamber.

20. The substrate processing apparatus according to claim 17, wherein
the first chamber includes a first processing unit,
the first processing unit includes:
a holding portion configured to hold a substrate; and
a nozzle configured to dispense a processing liquid to a substrate held by the holding portion, and
the first pipe connects the first processing liquid container and the nozzle.

21. The substrate processing apparatus according to claim 20, wherein
at least a part of the second pump is disposed at a position lower than the nozzle.

22. The substrate processing apparatus according to claim 20, wherein
the first chamber includes a second processing unit, and
the second processing unit shares the nozzle of the first processing unit.

23. The substrate processing apparatus according to claim 20, wherein
the first processing unit includes a cup disposed outward of the holding portion,
the cup has an upper end, and
at least a part of the second pump is disposed at a position lower than the upper end of the cup.

24. The substrate processing apparatus according to claim 17, wherein
the cabinet portion includes:
a second processing liquid container configured to store a processing liquid;
a third pipe connecting the second processing liquid container and the first chamber; and
a third liquid feeder provided on the third pipe,
the third liquid feeder includes:
a fifth pump provided on the third pipe; and
a sixth pump provided on the third pipe,
the sixth pump is disposed downstream of the fifth pump, and
the sixth pump is disposed at a height position same as a height position of the second pump.

25. The substrate processing apparatus according to claim 24, wherein
the second pump and the sixth pump are arranged in a second direction, and
the second direction is horizontal and is orthogonal to the first direction.

26. The substrate processing apparatus according to claim 1, comprising:
an indexer portion, wherein
the indexer portion includes:
a carrier stage; and
a transport mechanism,
the carrier stage and the transport mechanism are arranged in a second direction, and
the second direction is horizontal and is orthogonal to the first direction.

27. The substrate processing apparatus according to claim 26, wherein
the indexer portion, the first block, the cabinet portion, and the second block are arranged in this order in the first direction.

28. The substrate processing apparatus according to claim 26, wherein
the first block, the cabinet portion, the second block, and the indexer portion are arranged in this order in the first direction.

29. The substrate processing apparatus according to claim 26, wherein
the first pipe does not reach the indexer portion.

30. The substrate processing apparatus according to claim 26, comprising:
a bridge portion, wherein
the bridge portion transports a substrate to the first block and the second block,
the first block, the bridge portion, and the second block are arranged in this order in the first direction, and
the cabinet portion and the bridge portion are arranged in the second direction.

31. The substrate processing apparatus according to claim 30, comprising:
a slider portion, wherein
the slider portion transports a substrate between the indexer portion and the bridge portion, and
the slider portion overlaps with one of the first block or the second block in plan view.
